# EUROPEAN PATENT SPECIFICATION

(11) **EP 4 446 848 B1**
(45) Date of publication and mention of the grant of the patent: **04.03.2026**
(21) Application number: 24705587.4
(22) Date of filing: 29.01.2024
(51) Int. Cl.: G06F 1/16, H04M 1/02

(54) **ELECTRONIC DEVICE COMPRISING HINGE DEVICE**
ELEKTRONISCHE VORRICHTUNG MIT SCHARNIERVORRICHTUNG
DISPOSITIF ÉLECTRONIQUE COMPRENANT UN DISPOSITIF CHARNIÈRE

(30) Priority: 24.02.2023 KR 20230025081; 07.04.2023 KR 20230046024
(43) Date of publication of application: 16.10.2024
(60) Divisional application: 25214635.2
(73) Proprietor: Samsung Electronics Co., Ltd., Suwon-si, Gyeonggi-do 16677 (KR)
(72) Inventor: CHO, Sunggun, Suwon-si, Gyeonggi-do 16677 (KR); KIM, Jongkeun, Suwon-si, Gyeonggi-do 16677 (KR); BAIK, Jinwook, Suwon-si, Gyeonggi-do 16677 (KR); SEO, Wonyoung, Suwon-si, Gyeonggi-do 16677 (KR); CHOI, Sooyeon, Suwon-si, Gyeonggi-do 16677 (KR); YOO, Minwoo, Suwon-si, Gyeonggi-do 16677 (KR)
(74) Representative: Gulde & Partner
(86) International application number: PCT/KR2024/001319
(87) International publication number: WO 2024/177300

(56) References cited:
- EP-A2- 4 290 835
- WO-A1-2021/162466
- WO-A2-2022/173237
- CN-A- 114 205 430
- KR-A- 20210 101 717
- KR-A- 20220 102 050
- KR-A- 20220 107 974
- KR-A- 20220 151 298
- US-A1- 2019 212 786
- US-A1- 2022 346 256
- US-B1- 10 659 576

## Description

### [Technical Field]

The embodiments of the present disclosure relate to an electronic device including a hinge device.

### [Background Art]

Electronic devices are gradually becoming slimmer to meet consumers' purchasing desires as the functional gap has narrowed significantly in each manufacturer, and improvements are being made to increase the rigidity of electronic devices, strengthen their design aspects, and differentiate their functional elements. These electronic devices are moving away from the uniform rectangular shape and are gradually being transformed into various shapes. For example, electronic devices may have a deformable structure that is convenient to carry and allows for the use of a large-screen display when used. As a type of electronic device, foldable type electronic devices are continuously being released, and operational reliability for frequent folding operations may be required. Foldable electronic devices are disclosed in WO 2021/162466 A1, WO 2022/173237 A2.

### [Disclosure of Invention]

### [Technical Problem]

The electronic device may include a foldable electronic device comprising a first housing and a second housing that is foldably connected to the first housing via a hinge device (e.g., a hinge structure, a hinge module, or a hinge assembly). The first housing and the second housing may ensure operational reliability for folding and/or unfolding by being structurally coupled to the hinge device. This foldable electronic device may be operated in an in-folding and/or out-folding method by rotating the first housing within a range of 0 ~ 360 degrees with respect to the second housing through a hinge device. The foldable electronic may include a flexible display disposed across the first housing and the second housing when unfolded 180 degrees.

The foldable electronic device may include a first wing plate and a second wing plate disposed in the first housing and the second housing respectively. The wing plates can support the flexible display by being disposed adjacent to each other when the foldable electronic device is in an unfolded state.

However, when the wing plates are disposed in close proximity, the rotation radius of the wing plates must be considered when switching from the folded state to the unfolded state, and it may be difficult to secure the efficient placement space of the surrounding structures because of such a rotation radius.

To secure the placement space of surrounding structures because of the rotation radius, the wing plates may be spaced at a predetermined interval, and one center bar may be disposed movable in a perpendicular direction from the hinge housing. The center bar may be moved to form the same plane as the wing plates while being supported by the surrounding operating structures (e.g., a pair of hinge arms) in the unfolded state and may be disposed to descend in the folded state.

However, since it is difficult for one center bar to be simultaneously supported by the operating structure, it may be operated while tilting to one side because of the synchronization deviation caused by sequential support, or it may cause malfunction because of j oint or jamming by the surrounding support structure supporting the center bar.

Various embodiments of the present disclosure may provide an electronic device including a hinge device that can help to secure space for efficient placement of surrounding structures by reducing the rotation radius of the wing plates.

According to various embodiments, an electronic device including a hinge device that can help to reinforce rigidity by providing a high-strength rotational structure to the reduced rotational trajectory of the wing plates may be provided.

According to various embodiments, an electronic device including a hinge device that can help to slim down by reducing the rotation radius of the wing plates may be provided.

However, the problems to be solved in the present disclosure are not limited to the aforementioned problems and may be expanded in various ways within the scope of the ideas and areas of the present disclosure.

### [Solution to Problem]

According to various embodiments, an electronic device may include a first housing; a second housing; at least one hinge device, and at least one hinge device that connects the first housing and the second housing to be foldable from a first state to a second state, that includes a rotator bracket, a first rotator rotatably coupled to the rotator bracket with respect to a first rotation axis, a second rotator rotatably coupled to the rotator bracket with respect to a second rotation axis, a first link rotatably coupled to the first rotator with respect to a third rotation axis, a second link rotatably coupled to the second rotator with respect to a fourth rotation axis, a first hinge arm rotatably disposed on the rotator bracket with respect to a fifth rotation axis, and a second hinge arm rotatably disposed on the rotator bracket with respect to a sixth rotation axis; a first wing plate fixed to the first rotator; a second wing plate fixed to the second rotator; a first center bar rotatably disposed with respect to the first wing plate; a second center bar rotatably disposed with respect to the second wing plate; and a flexible display disposed to be supported by the first and second housings, the first and second wing plates, and the first and second center bars in the first state, wherein the first center bar and the second center bar may be operated to correspond to the first wing plate and the second wing plate, respectively, up to a third state between the first state and the second state, and may be operated respectively to have a different rotation angle from the first wing plate and the second wing plate from the third state to the second state.

According to various embodiments, an electronic device may include a first housing; a second housing; at least one hinge device, and at least one hinge device that connects the first housing and the second housing to be foldable from a first state to a second state, that includes a rotator bracket, a first rotator rotatably coupled to the rotator bracket with respect to a first rotation axis, a second rotator rotatably coupled to the rotator bracket with respect to a second rotation axis, a first wing plate rotatably coupled to the first rotator with respect to a third rotation axis, a second wing plate rotatably coupled to the second rotator with respect to a fourth rotation axis, a first hinge arm rotatably disposed on the rotator bracket with respect to a fifth rotation axis, and a second hinge arm rotatably disposed on the rotator bracket with respect to a sixth rotation axis; a first center bar rotatably disposed with respect to the first wing plate; a second center bar rotatably disposed with respect to the second wing plate; and a flexible display disposed to be supported by the first and second housings, the first and second wing plates, and the first and second center bars in the first state, wherein the first center bar and the second center bar may be disposed to have a different rotation angle from the first wing plate and the second wing plate respectively from the third state, which is between the first state and the second state, to the second state.

### [Advantageous Effects of Invention]

An electronic device according to the exemplary embodiments of the present disclosure may secure an efficient placement space for surrounding structures because of the reduction of the rotation radius of the wing plates in comparison with the rotation radius of conventional first and second wing plates supporting the flexible display without center bars, and help to slim down the electronic device, by including at least one hinge device having a pair of center bars provided between the wing plates and disposed to support the flexible display at different angles from the wing plates during operation. In addition, the reduced rotation radius of the wing plates because of the placement of the center bar may help to provide space for rigidity reinforcement of the surrounding rotating structure without increasing the volume of the electronic device.

In addition, various effects that can be directly or indirectly identified through the present document may be provided.

The effects obtainable in the present disclosure are not limited to the aforementioned effects, and other effects not mentioned may be easily understood from the following description by a person having ordinary knowledge in the art to which the disclosure pertains.

### [Brief Description of Drawings]

With regard to the description of the drawing, the same or similar reference numerals may be used for the same or similar components.
FIG. 1a is a front perspective view of an electronic device illustrating a flat status or unfolded state according to various embodiments of the present disclosure.
FIG. 1b is a plan view illustrating the front surface of an electronic device in an unfolded state according to various embodiments of the present disclosure.
FIG. 1c is a plan view illustrating the rear surface of an electronic device in an unfolded state according to various embodiments of the present disclosure.
FIG. 2a is a perspective view of an electronic device illustrating a folded state according to various embodiments of the present disclosure.
FIG. 2b is a perspective view of an electronic device illustrating an intermediate state according to various embodiments of the present disclosure.
FIG. 3a is a configuration diagram of an electronic device including a hinge assembly according to various embodiments of the present disclosure.

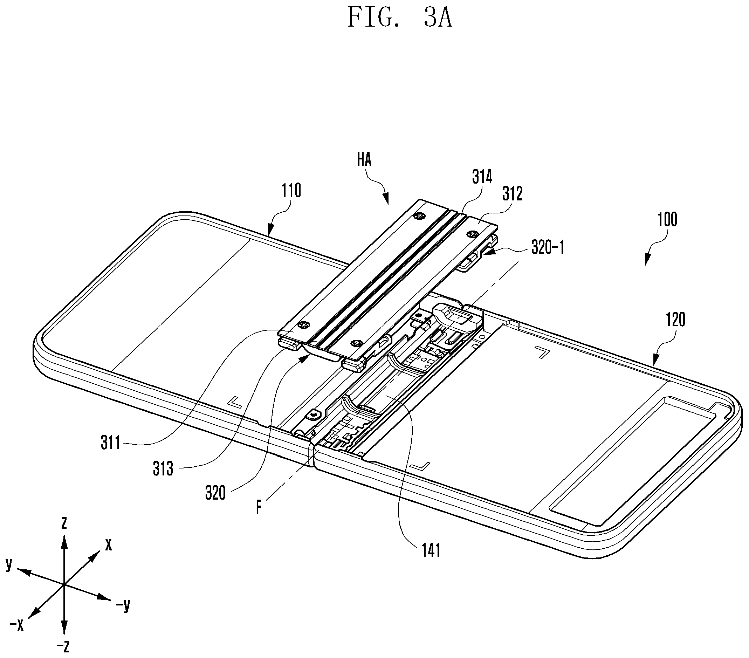

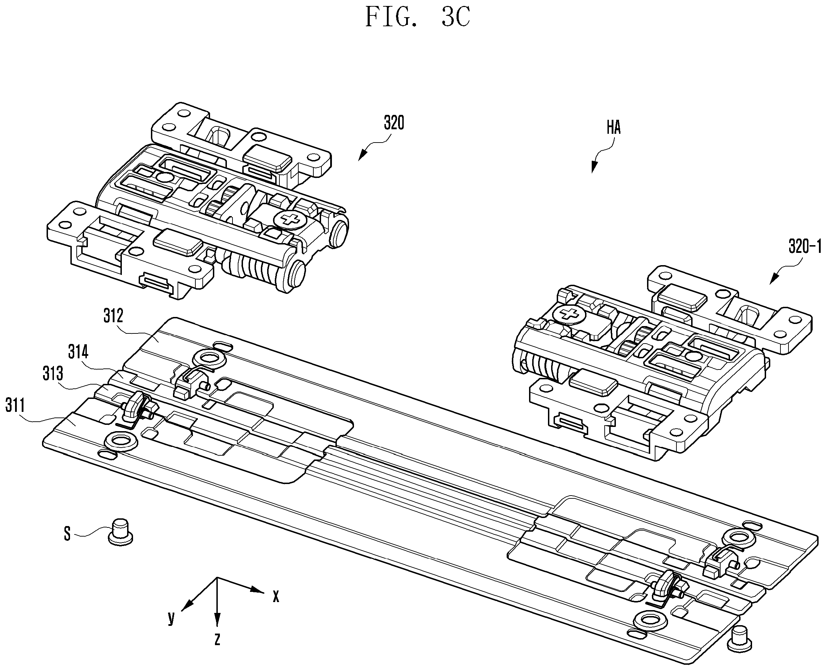

FIGS. 3a and 3c are exploded perspective views of a hinge assembly viewed from the front surface and rear surface according to various embodiments of the present disclosure.

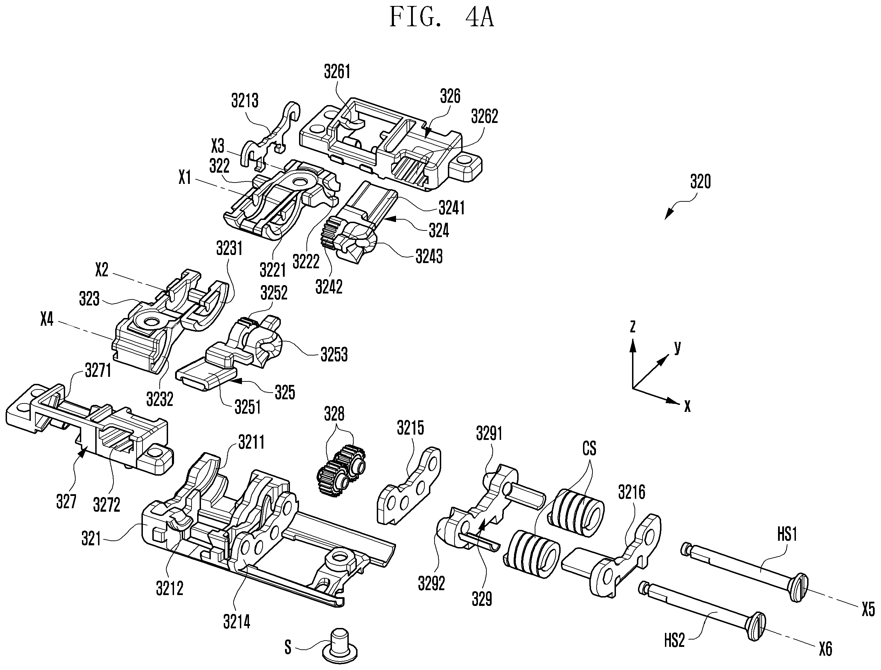

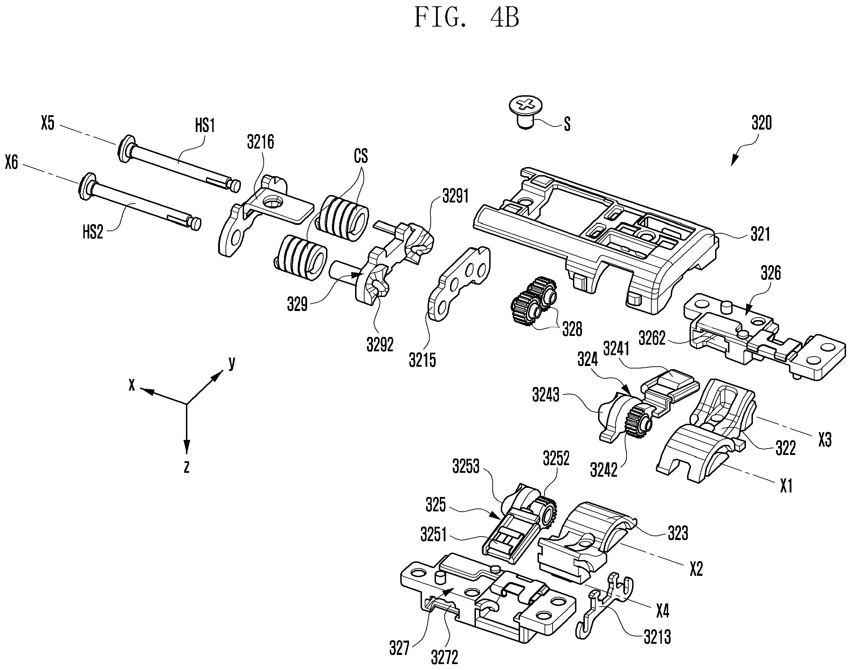

FIGS. 4a and 4b are exploded perspective views of a hinge device viewed from the front surface and rear surface according to various embodiments of the present disclosure.

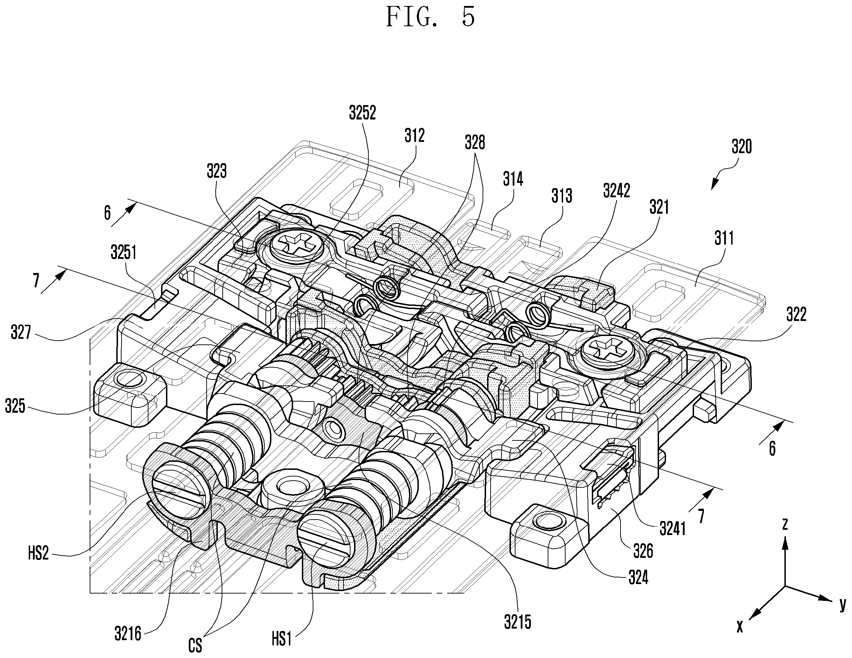

FIG. 5 is a coupling perspective view of a hinge device according to various embodiments of the present disclosure.

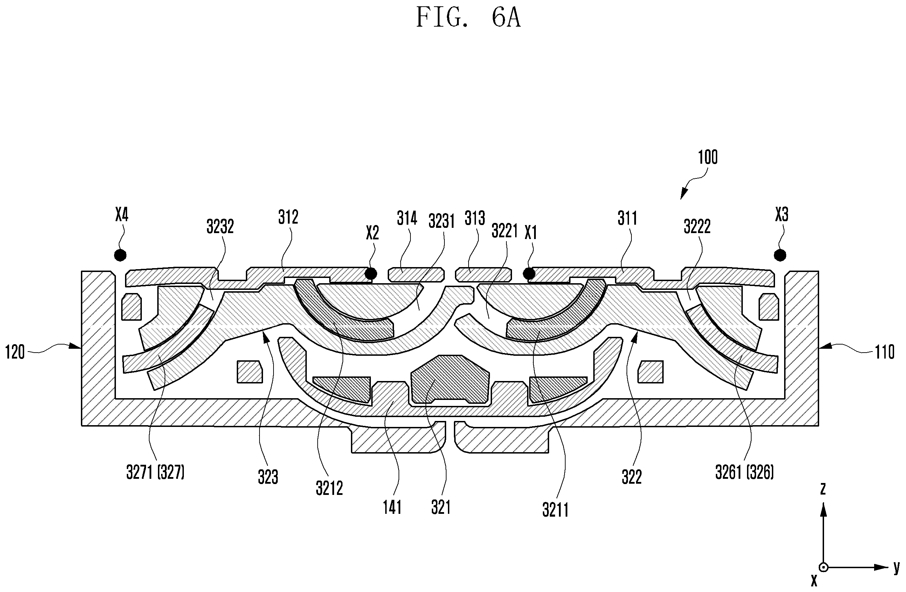

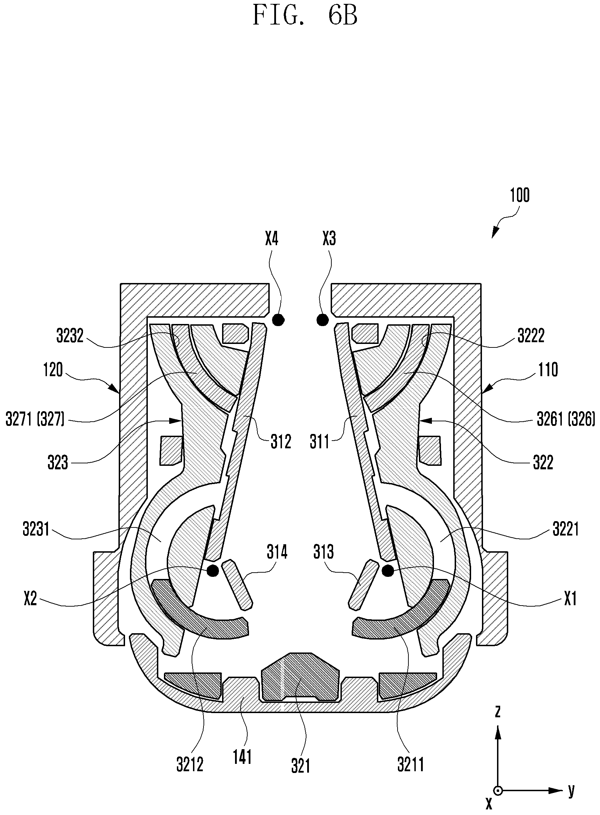

FIGS. 6a and 6b are cross-sectional views of a hinge device in an unfolded and folded state of the electronic device as taken along line 6-6 of FIG. 5 according to various embodiments of the present disclosure.

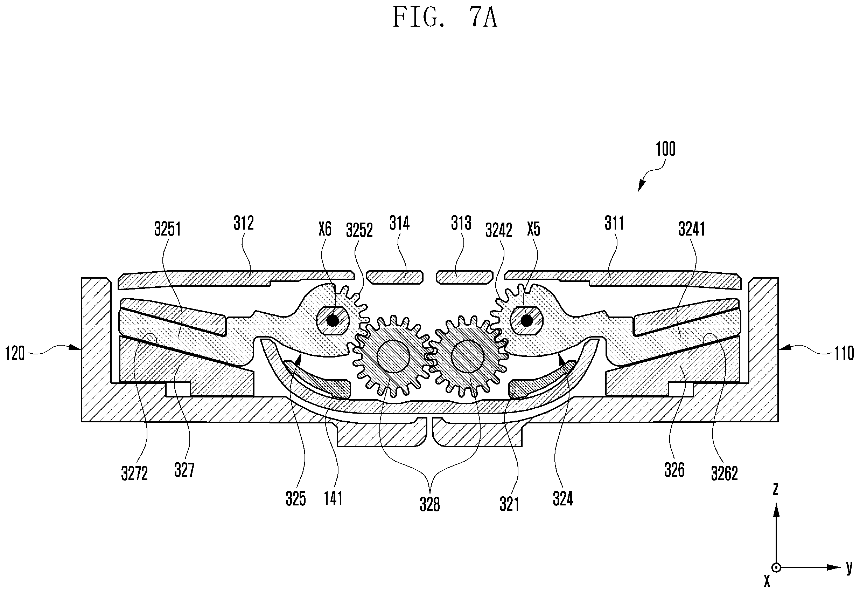

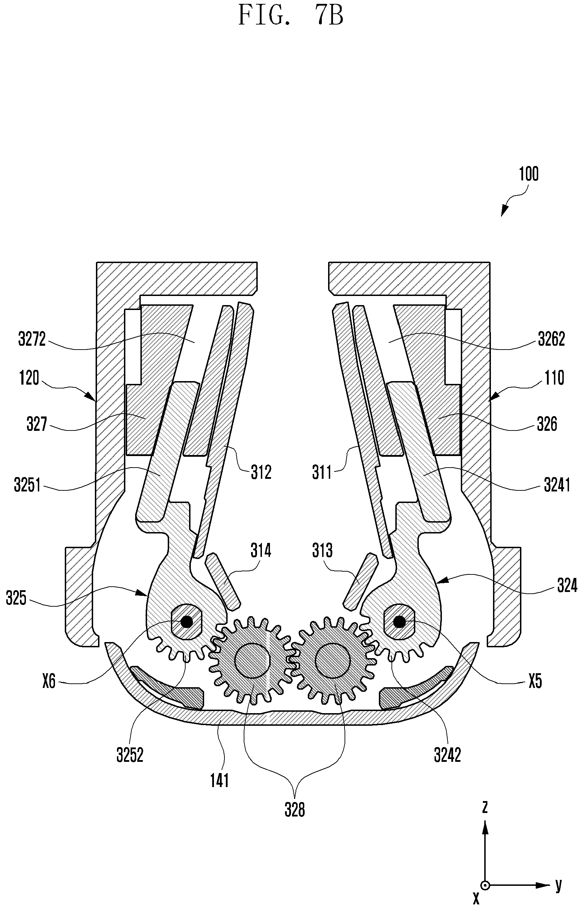

FIGS. 7a and 7b are cross-sectional views of the hinge device in an unfolded and folded state of the electronic device as taken along line 7-7 of FIG. 5 according to various embodiments of the present disclosure.

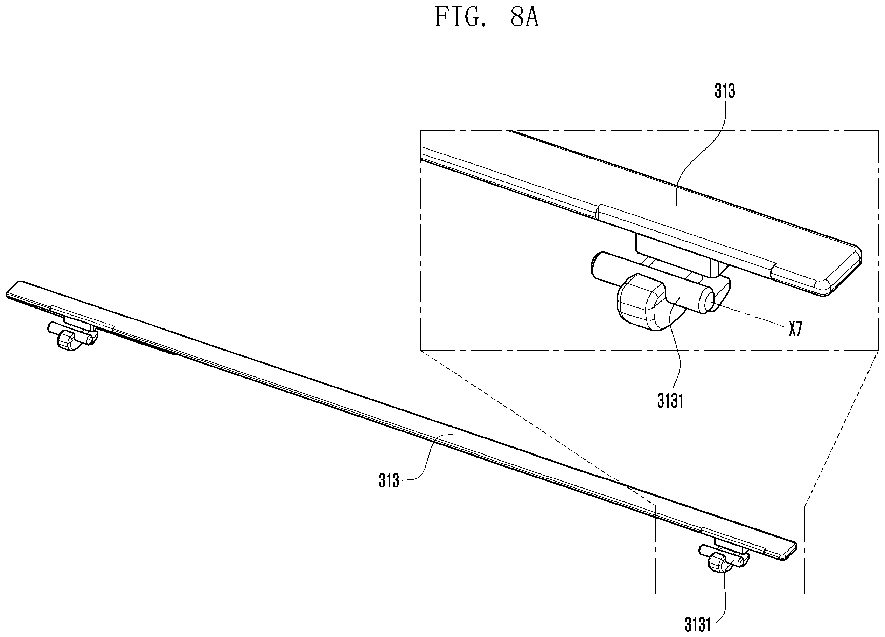

FIG. 8a is a perspective view of a first center bar according to various embodiments of the present disclosure.

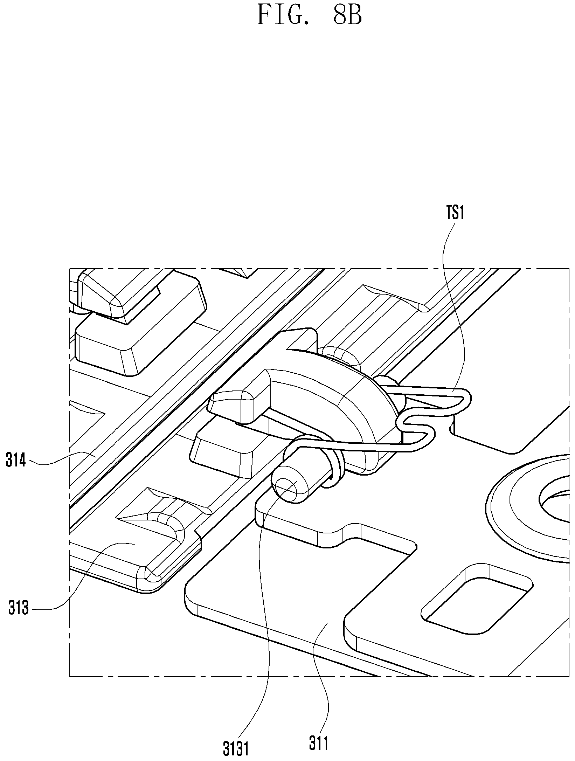

FIG. 8b is a partial perspective view illustrating the arrangement structure of the first center bar and the first wing plate according to various embodiments of the present disclosure.

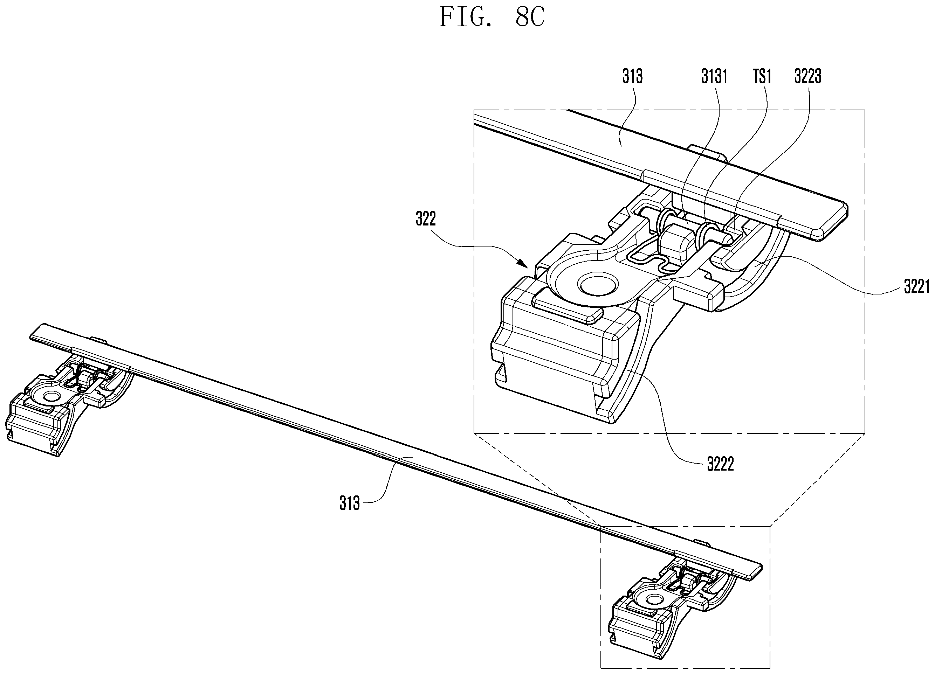

FIG. 8c is a diagram illustrating a coupling structure of a first center bar and a first rotator according to various embodiments of the present disclosure.

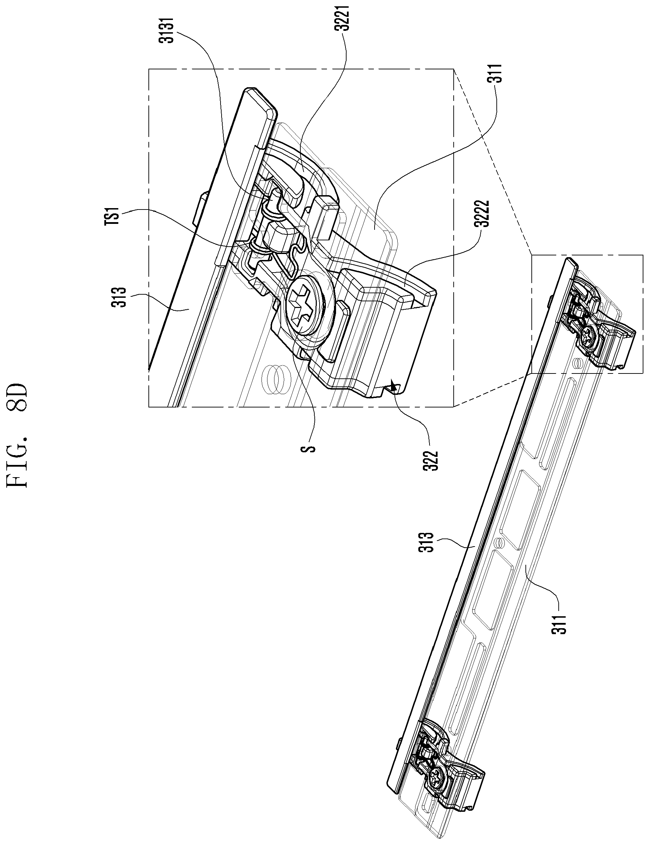

FIG. 8d is a diagram illustrating the arrangement structure of the first center bar and the first wing plate in a state in which the first center bar is mounted on the first rotator according to various embodiments of the present disclosure.

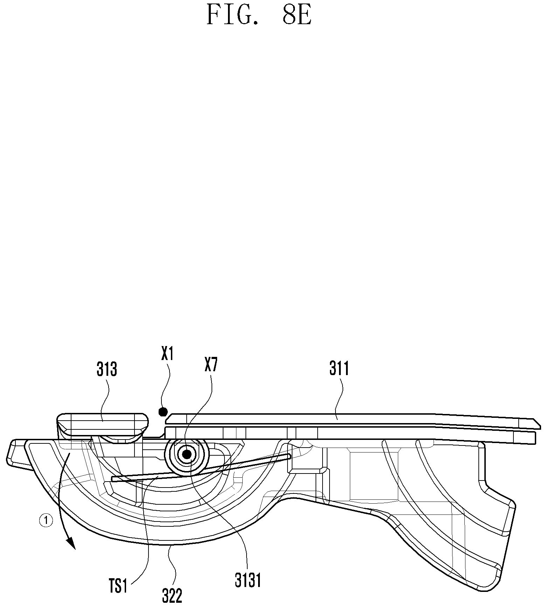

FIG. 8e is a side view illustrating the arrangement structure of the center bar and wing plate in the unfolded state according to various embodiments of the present disclosure.

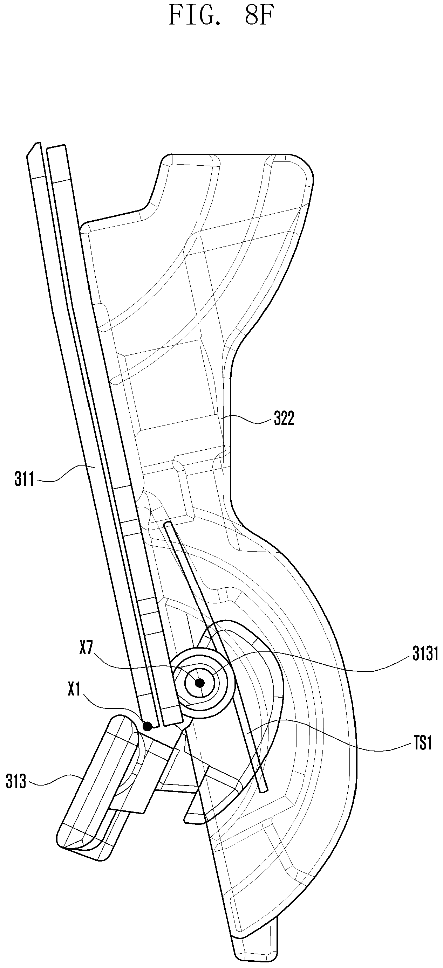

FIG. 8f is a side view illustrating the arrangement structure of the center bar and wing plate in a folded state according to various embodiments of the present disclosure.

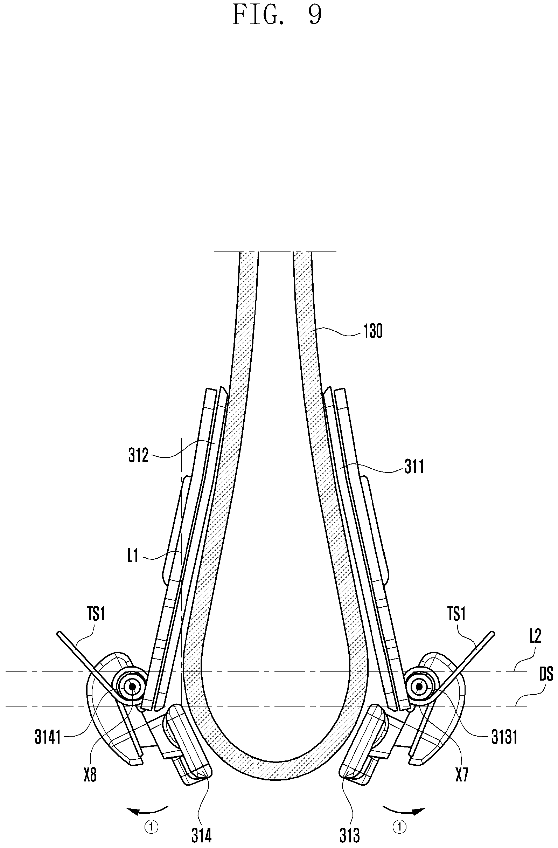

FIG. 9 is a diagram illustrating the position of the center bar in a folded state according to various embodiments of the present disclosure.

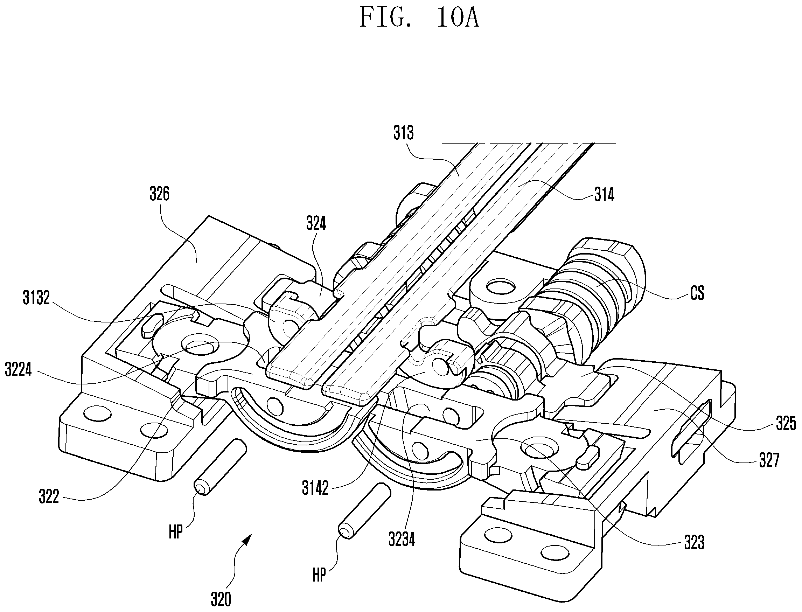

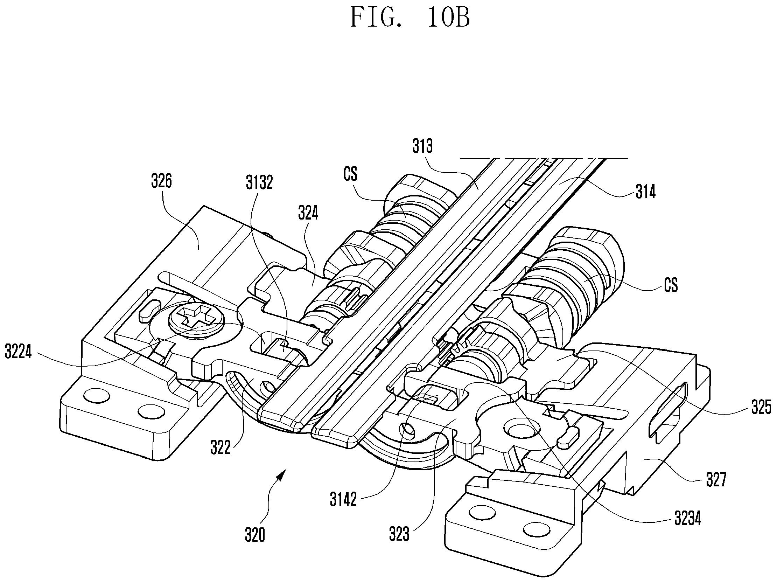

FIG. 10a and 10b are diagrams illustrating a combination structure of center bars and rotators according to various embodiments of the present disclosure.

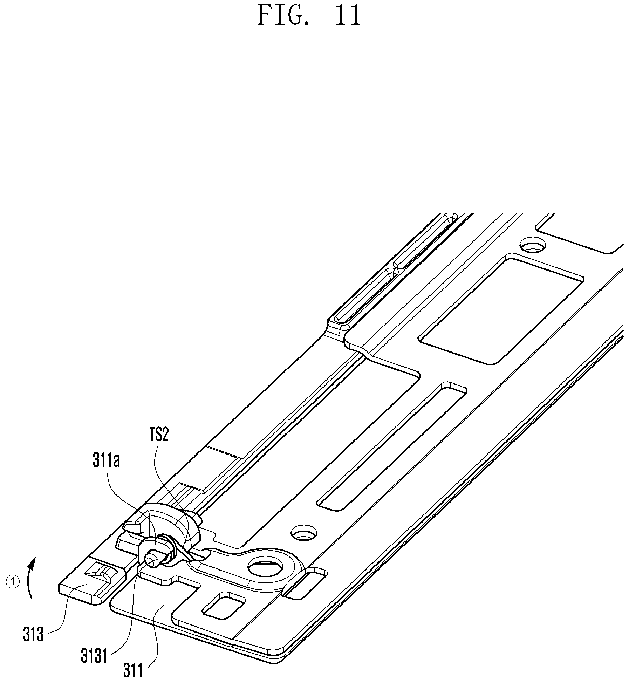

FIG. 11 is a perspective view illustrating a coupling structure of a first center bar and a first wing plate according to various embodiments of the present disclosure.

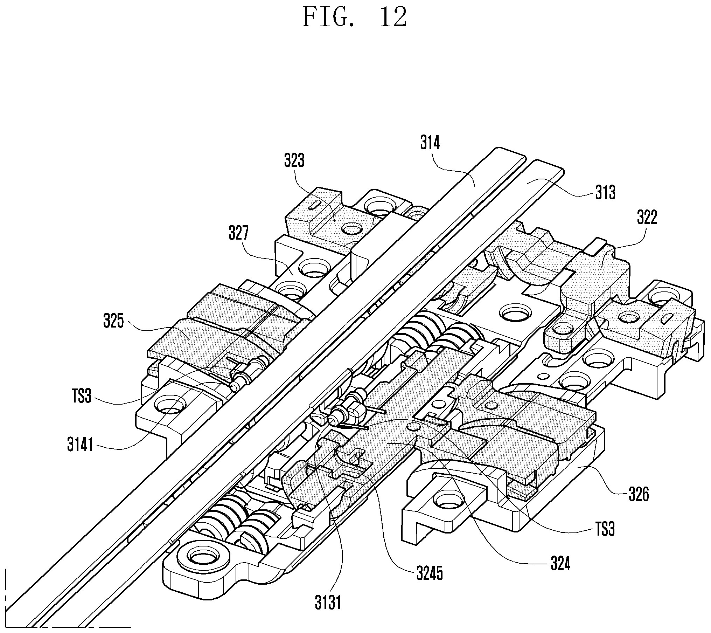

FIG. 12 is a diagram illustrating a coupling structure of center bars and hinge arms according to various embodiments of the present disclosure.

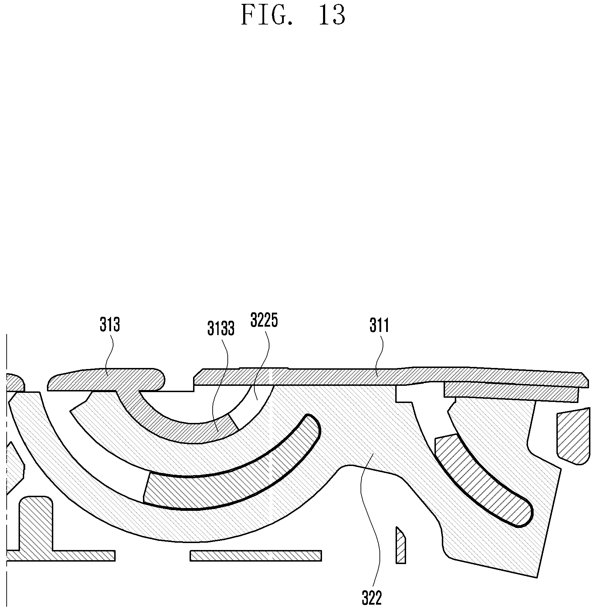

FIG. 13 is a perspective view illustrating a coupling structure of a first center bar and a first wing plate according to various embodiments of the present disclosure.

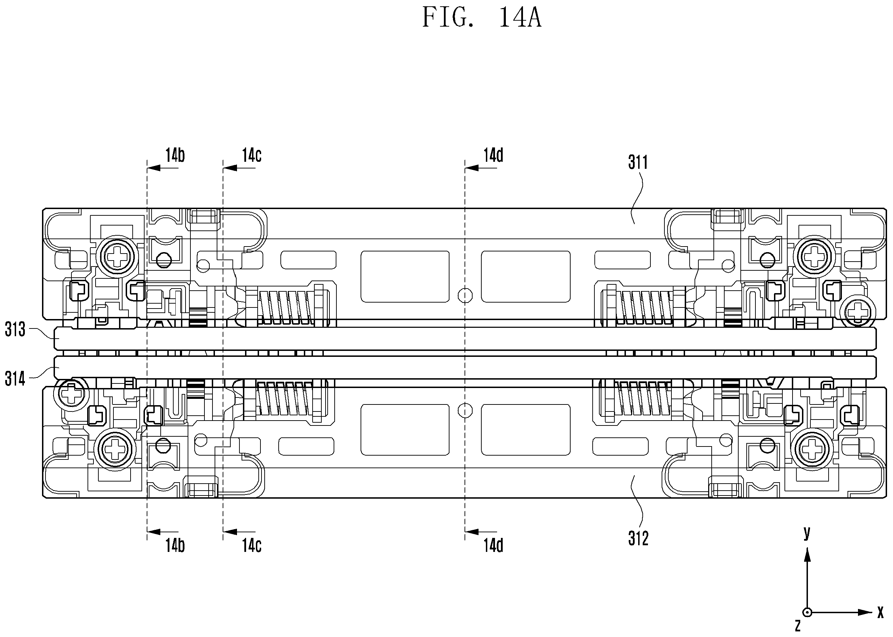

FIG. 14a is a plan view of a hinge assembly according to various embodiments of the present disclosure.

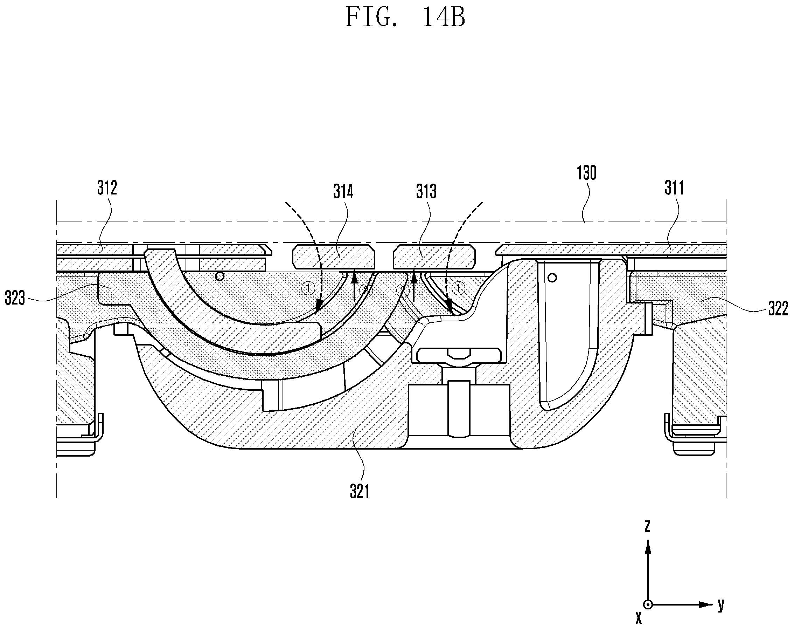

FIG. 14b is a cross-sectional view of the hinge assembly taken along line 14b-14b of FIG. 14a according to various embodiments of the present disclosure.

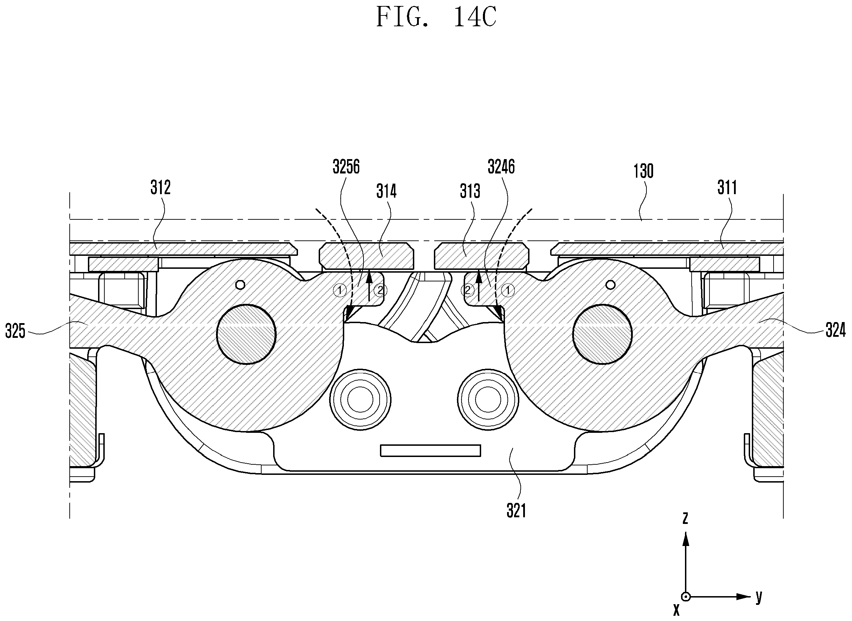

FIG. 14c is a cross-sectional view of the hinge assembly taken along line 14c-14c of FIG. 14a according to various embodiments of the present disclosure.

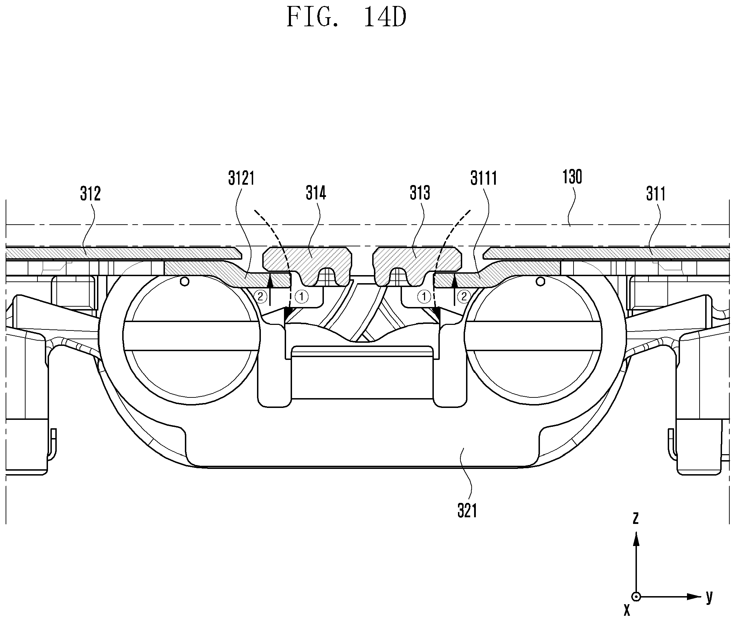

FIG. 14d is a cross-sectional view of the hinge assembly taken along line 14d-14d of FIG. 14a according to various embodiments of the present disclosure.

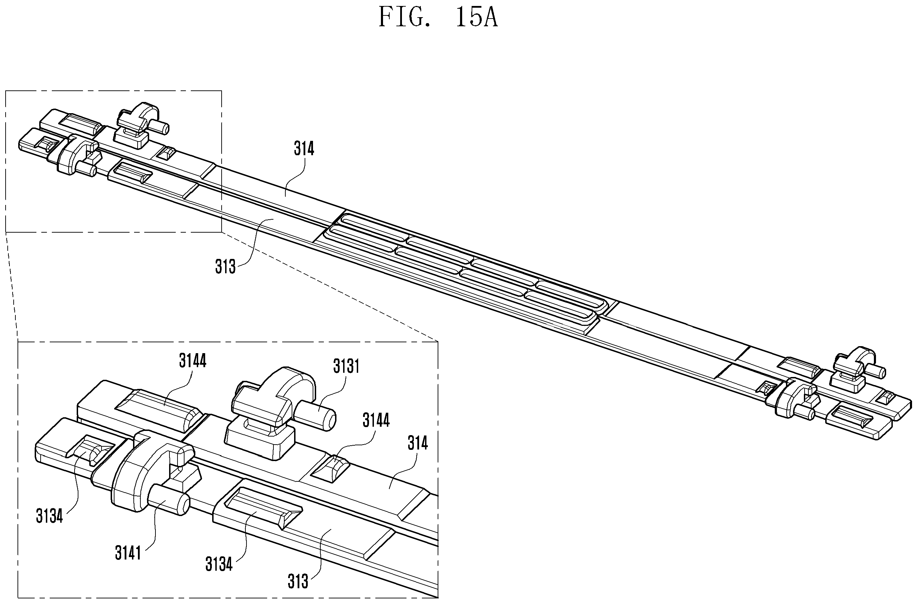

FIG. 15a is a perspective view of center bars according to various embodiments of the present disclosure.

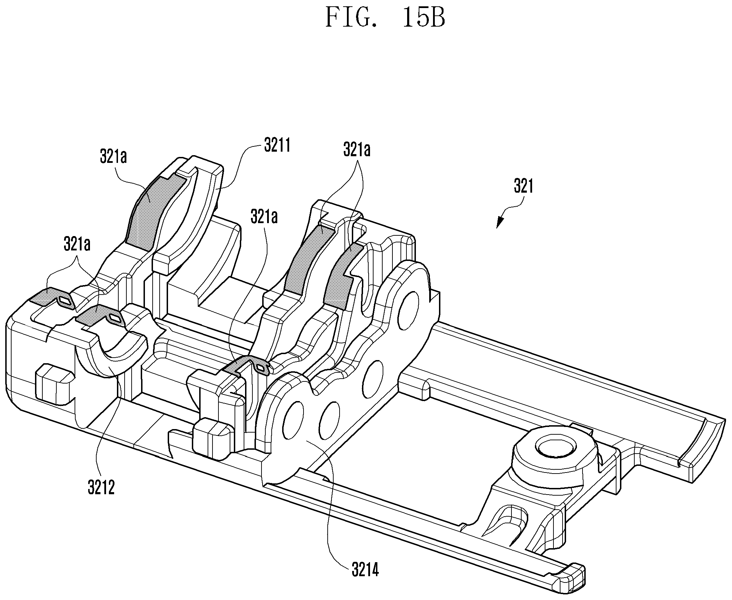

FIG. 15b is a perspective view of a rotator bracket according to various embodiments of the present disclosure.

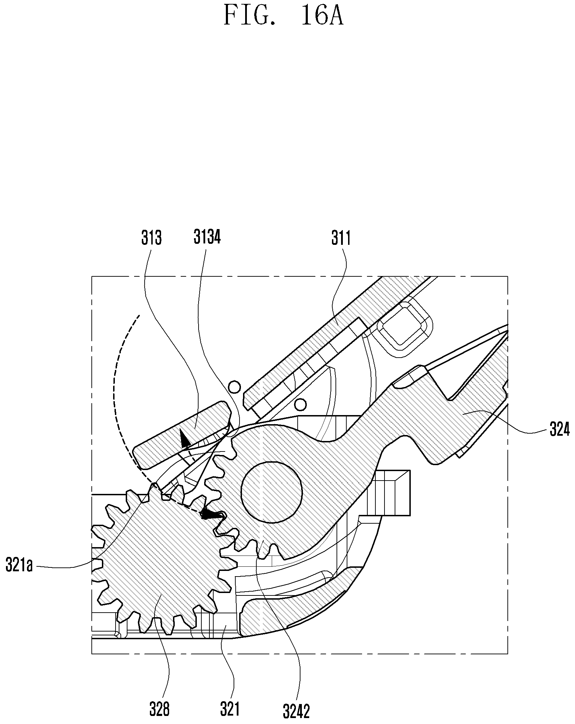

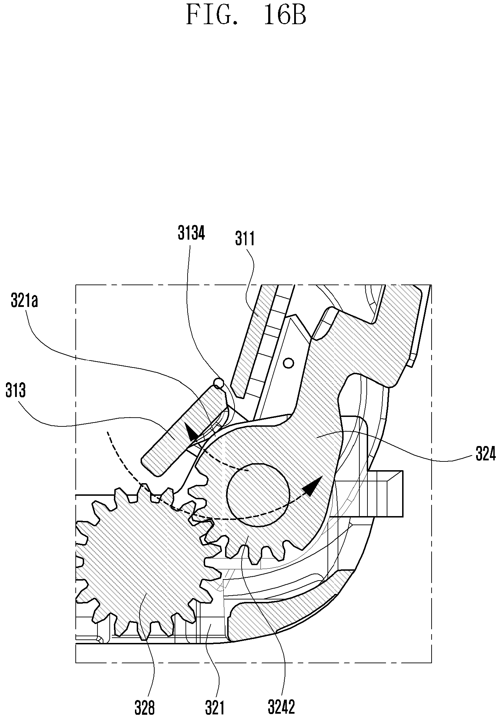

FIGS. 16a and 16b are diagrams illustrating a support structure for center bars by a rotator bracket according to various embodiments of the present disclosure.

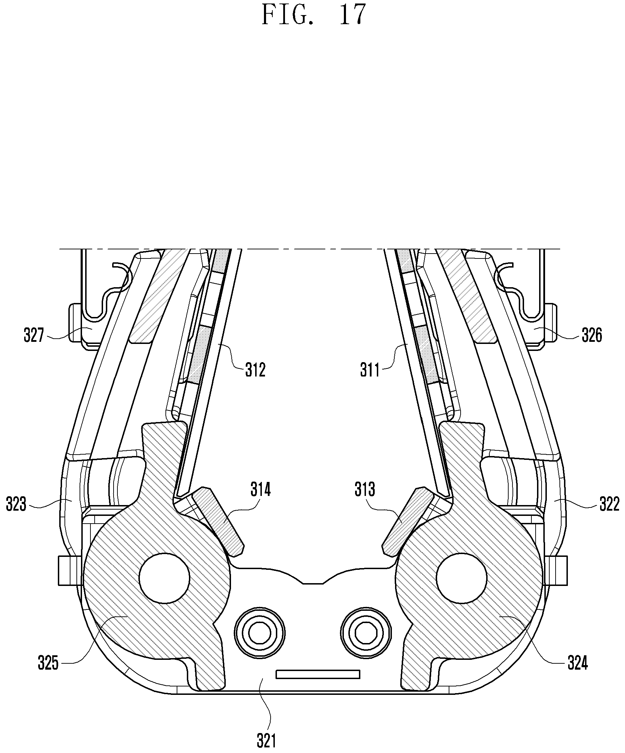

FIG. 17 is a diagram illustrating a support structure for center bars by hinge arms according to various embodiments of the present disclosure.

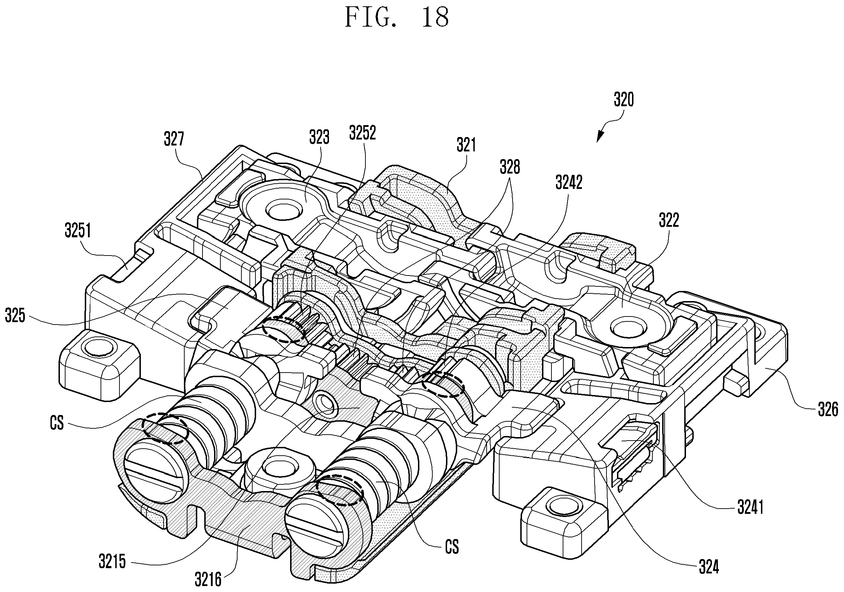

FIG. 18 is a perspective view of a hinge device illustrating support portions of center bars according to various embodiments of the present disclosure.

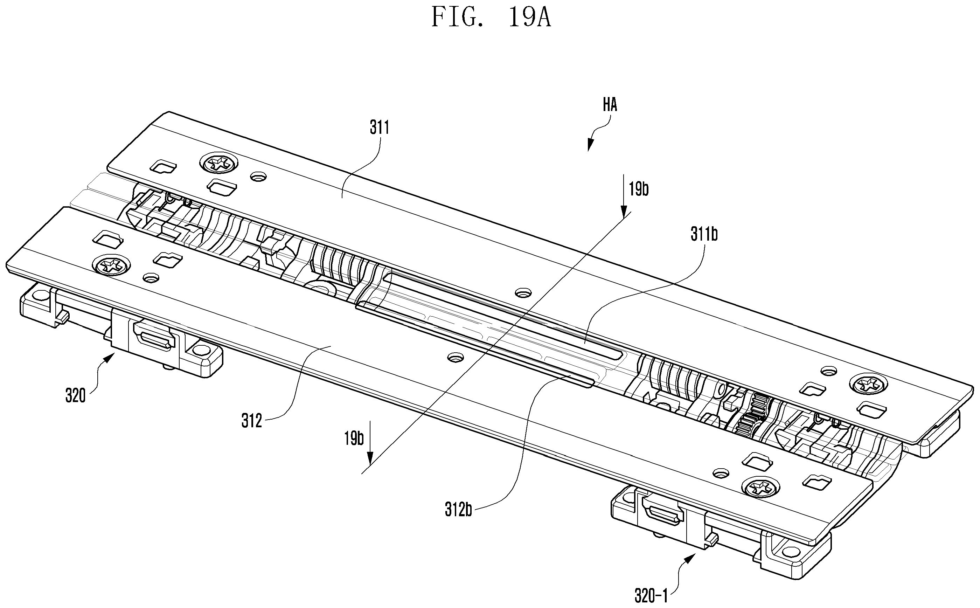

FIG. 19a is a perspective view of a hinge assembly according to various embodiments of the present disclosure.

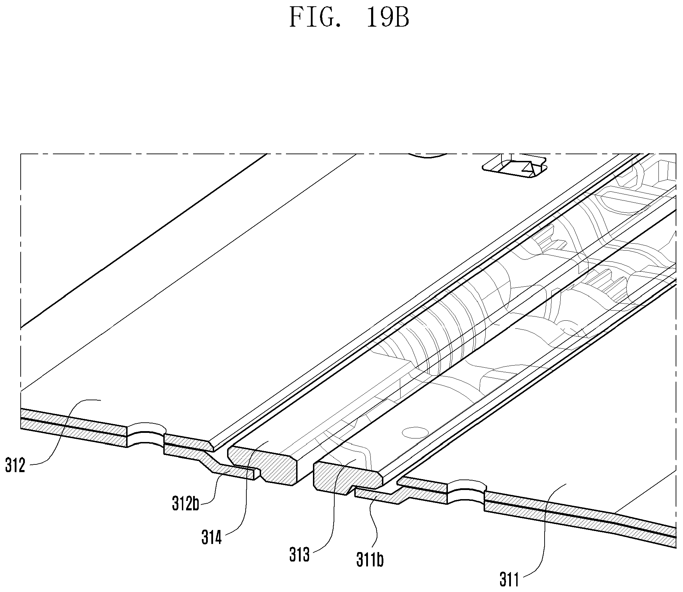

FIG. 19b is a cross-sectional perspective view of the hinge assembly taken along line 19b-19b of FIG. 19a according to various embodiments of the present disclosure.

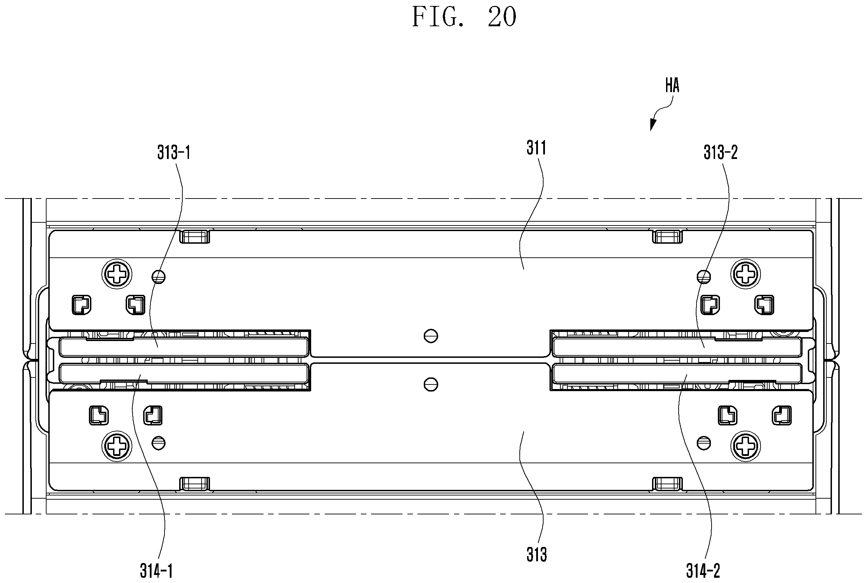

FIG. 20 is a plan view of a hinge assembly according to various embodiments of the present disclosure.

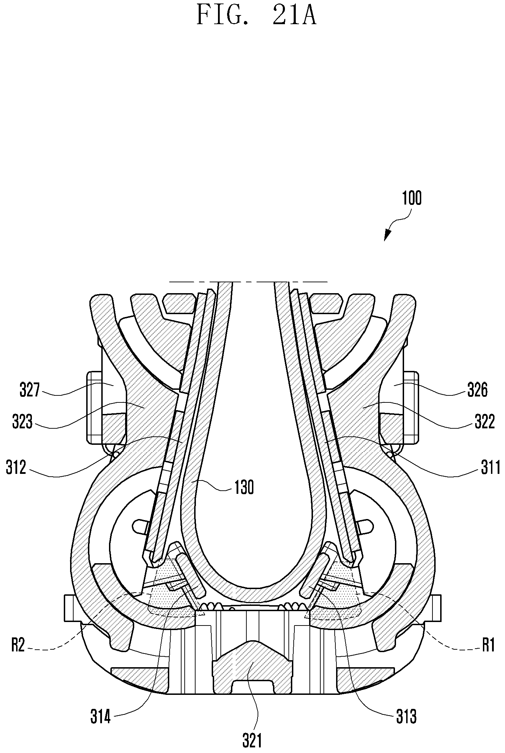

FIG. 21a is a partial cross-sectional view of an electronic device illustrating a rigidity reinforcement structure in a folded state according to various embodiments of the present disclosure.

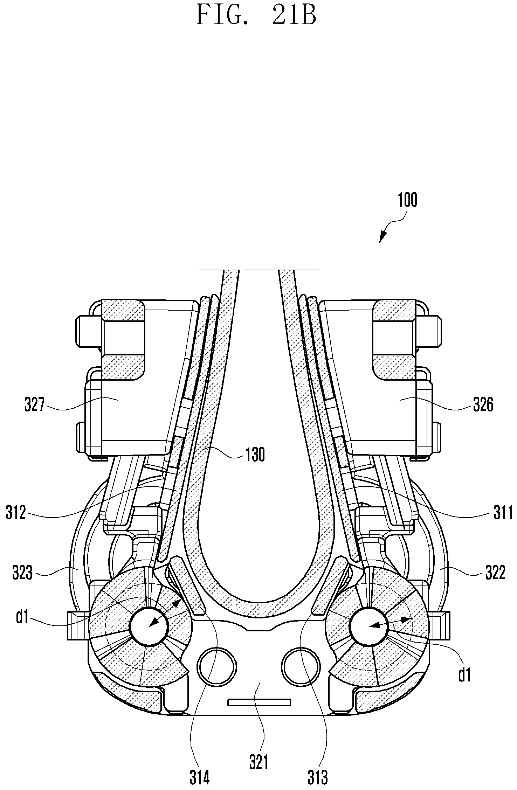

FIG. 21b is a partial cross-sectional view of an electronic device illustrating a hinge structure according to various embodiments of the present disclosure.

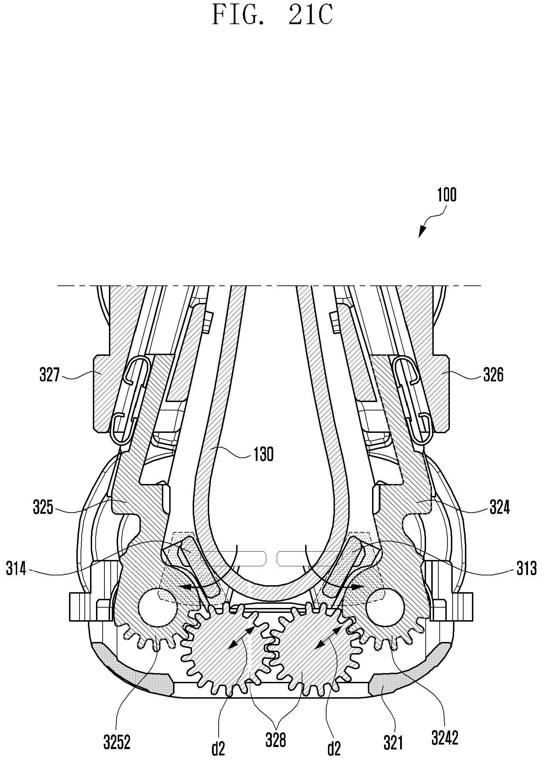

FIG. 21c is a partial cross-sectional view of an electronic device illustrating a gear structure according to various embodiments of the present disclosure.

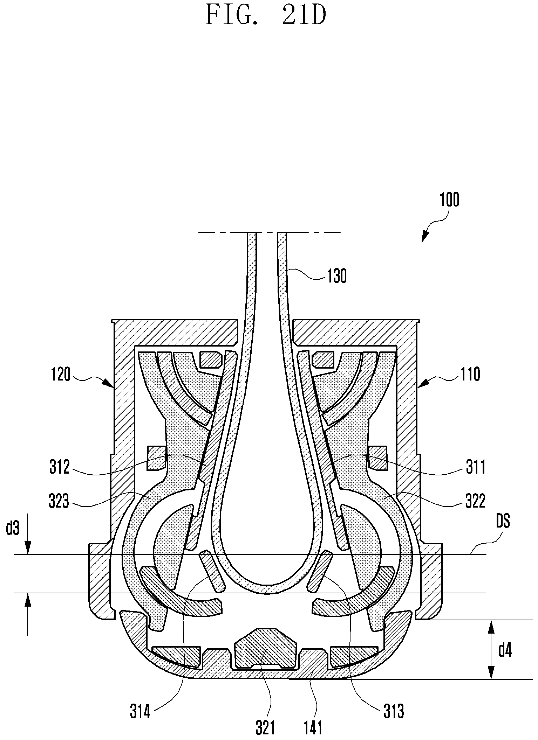

FIG. 21d is a partial cross-sectional view of an electronic device illustrating the relationship between the amount of protrusion of the hinge housing and the amount of deflection of the flexible display according to various embodiments of the present disclosure.

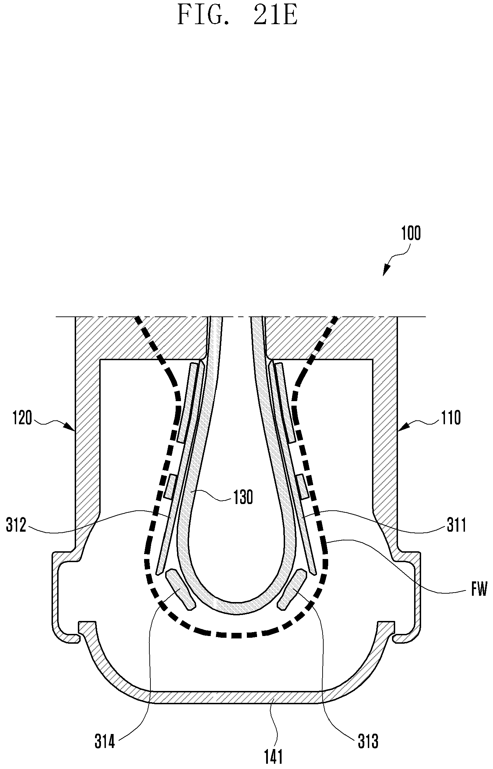

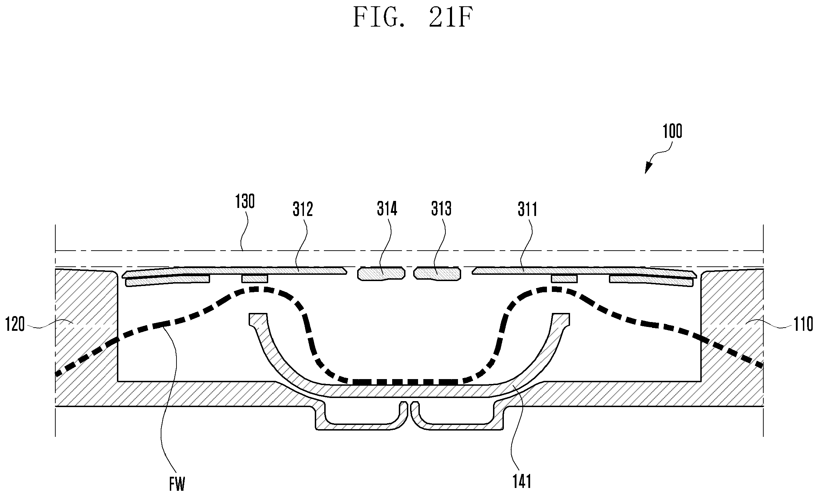

FIGS. 21e and 21f are partial cross-sectional views of an electronic device illustrating the arrangement structure of wiring members in a folded and unfolded state according to various embodiments of the present disclosure.

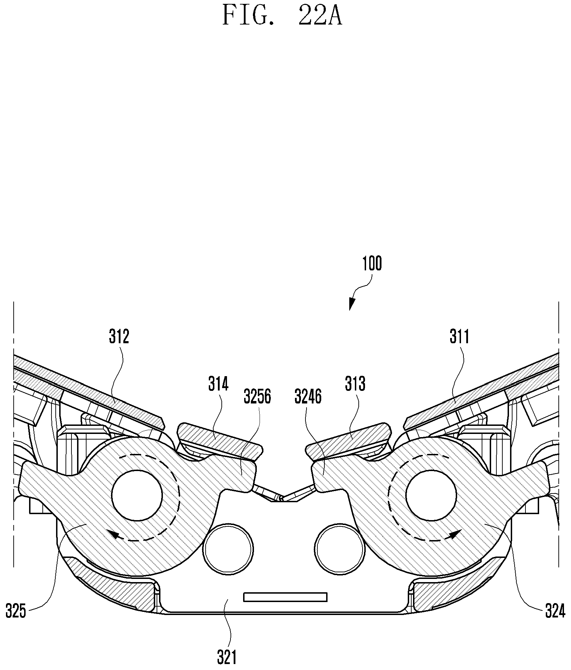

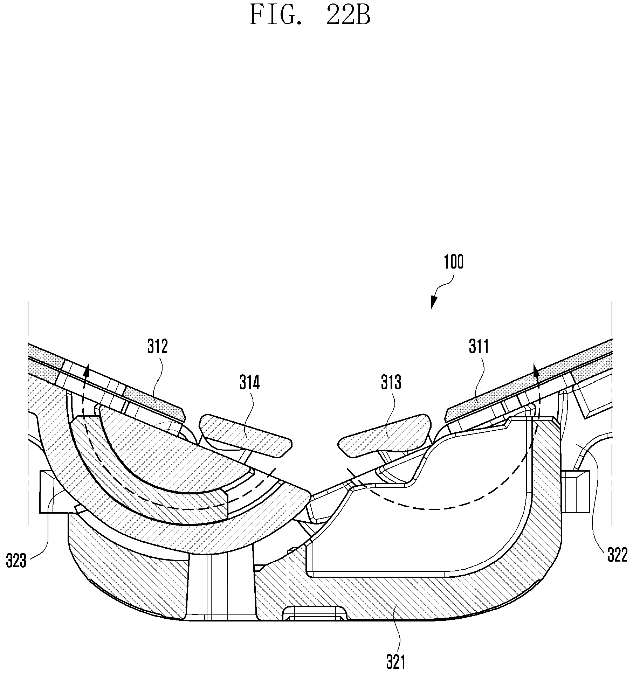

FIGS. 22a and 22b are diagrams illustrating a support structure for wing plates by hinge arms according to various embodiments of the present disclosure.

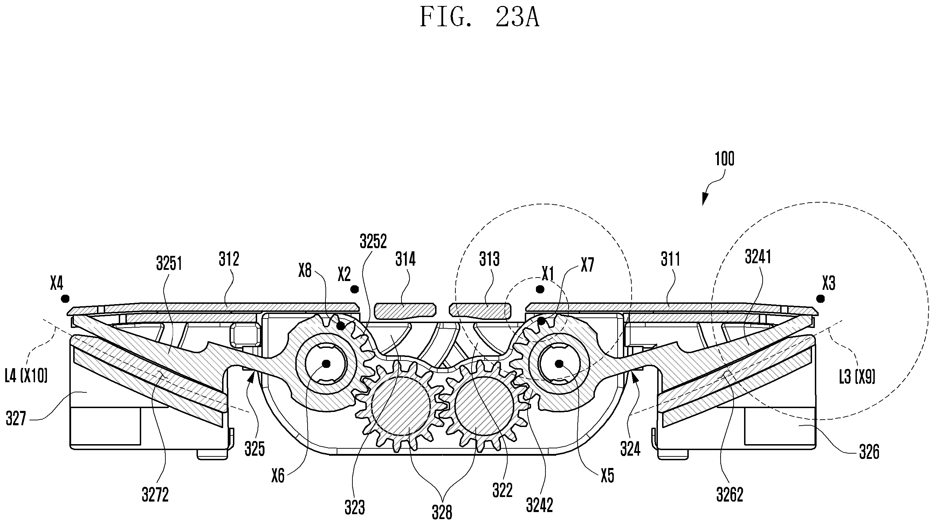

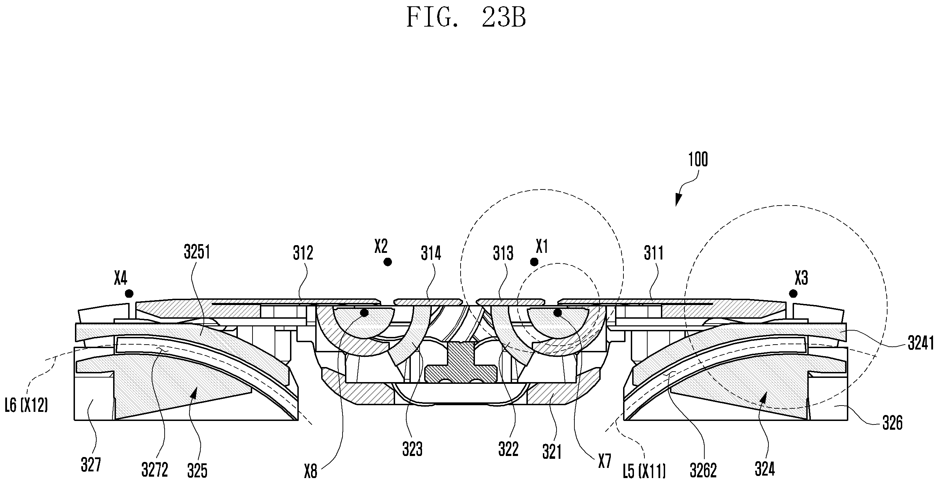

FIGS. 23a and 23b are diagrams illustrating the operating structure between the hinge arm and links according to various embodiments of the present disclosure.

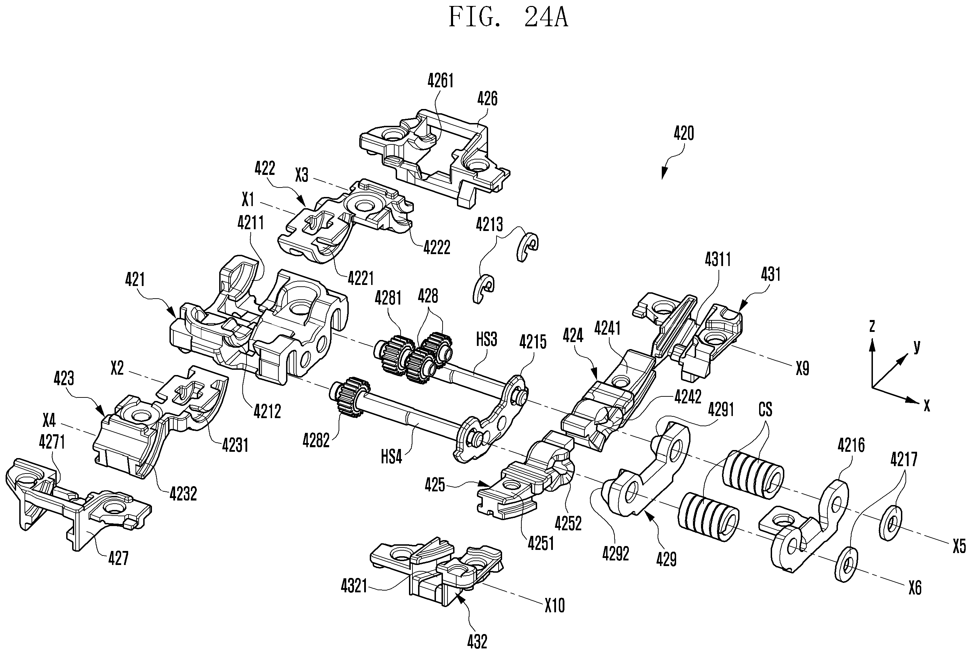

FIG.24a is an exploded perspective view of a hinge device according to various embodiments of the present disclosure.

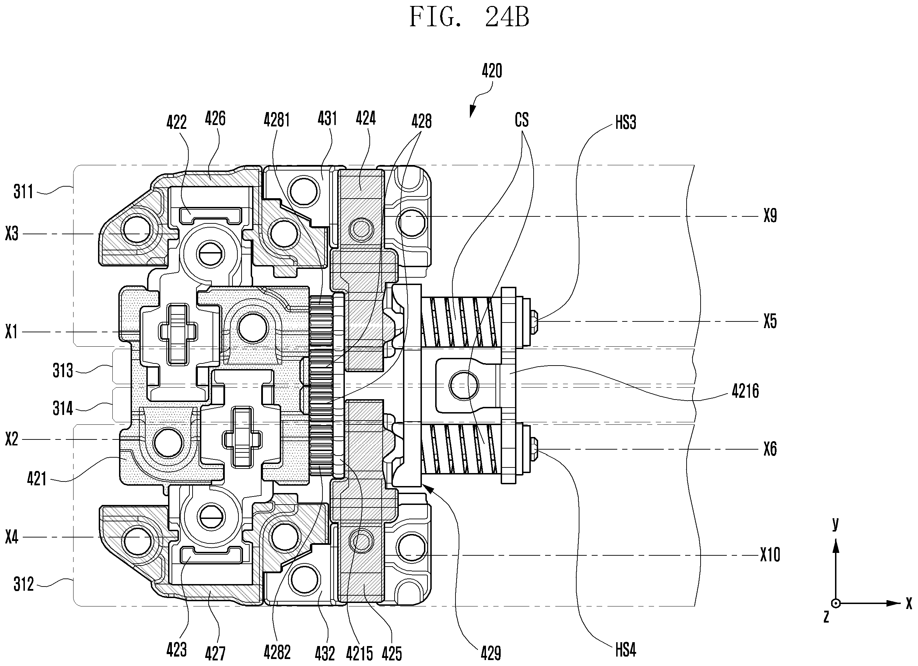

FIG. 24b is a coupling perspective view of the hinge device of FIG. 24aaccording to various embodiments of the present disclosure.

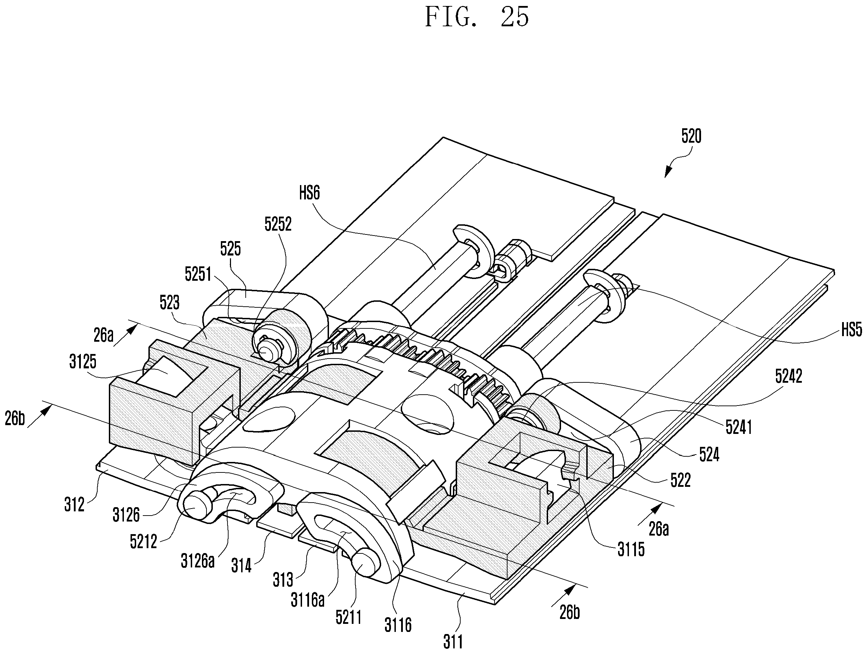

FIG. 25 is an exploded perspective view of a hinge device according to various embodiments of the present disclosure.

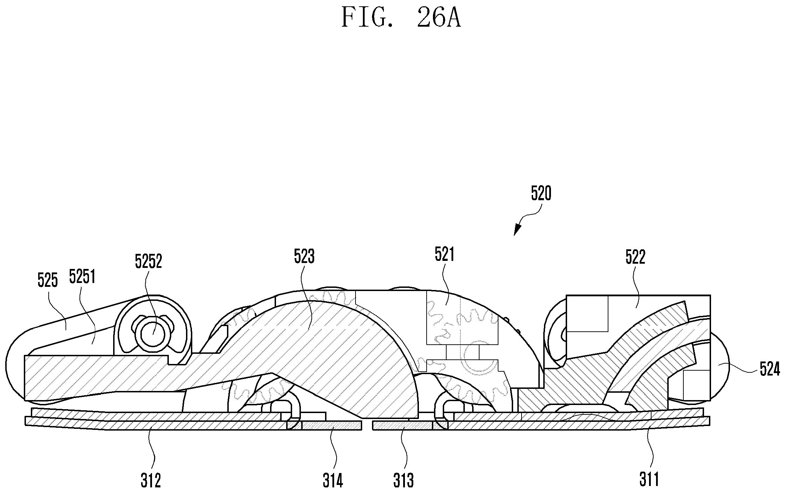

FIG. 26a is a cross-sectional view of a hinge device taken along line 26a-26a of FIG. 25 according to various embodiments of the present disclosure.

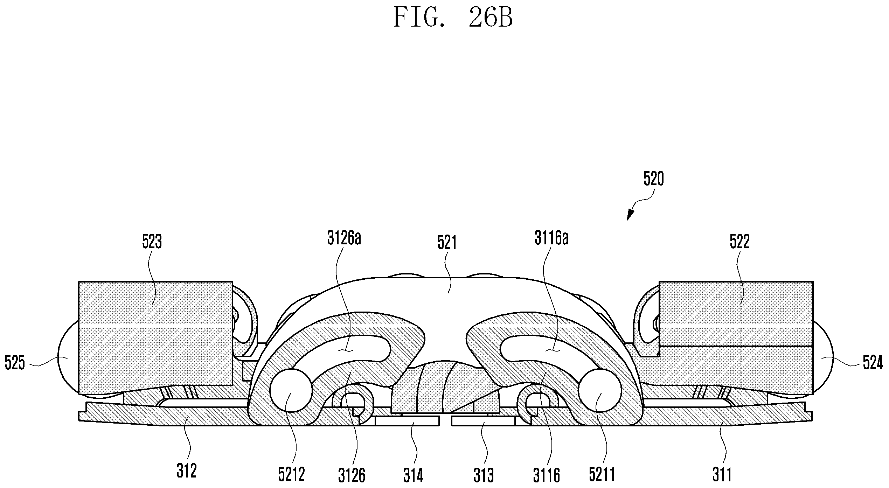

FIG. 26b is a cross-sectional view of the hinge device taken along line 26b-26b of FIG. 25 according to various embodiments of the present disclosure.

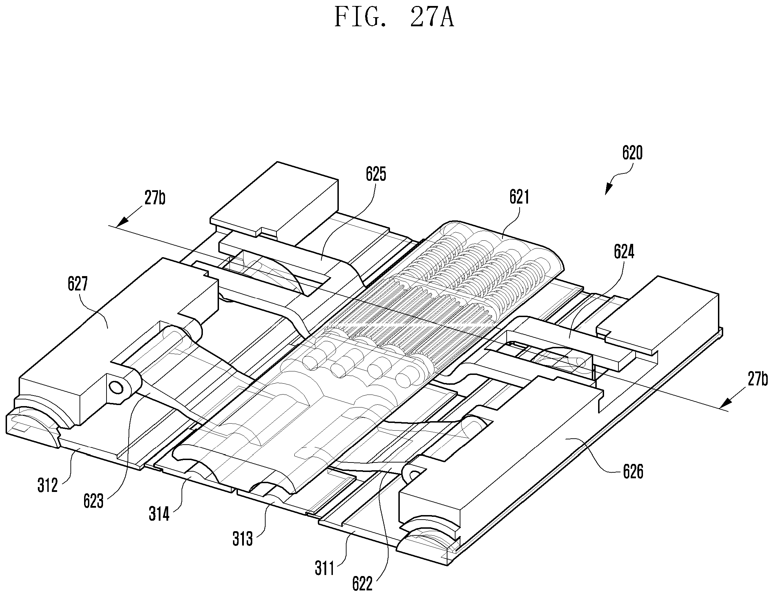

FIG. 27a is a perspective view of a hinge device according to various embodiments of the present disclosure.

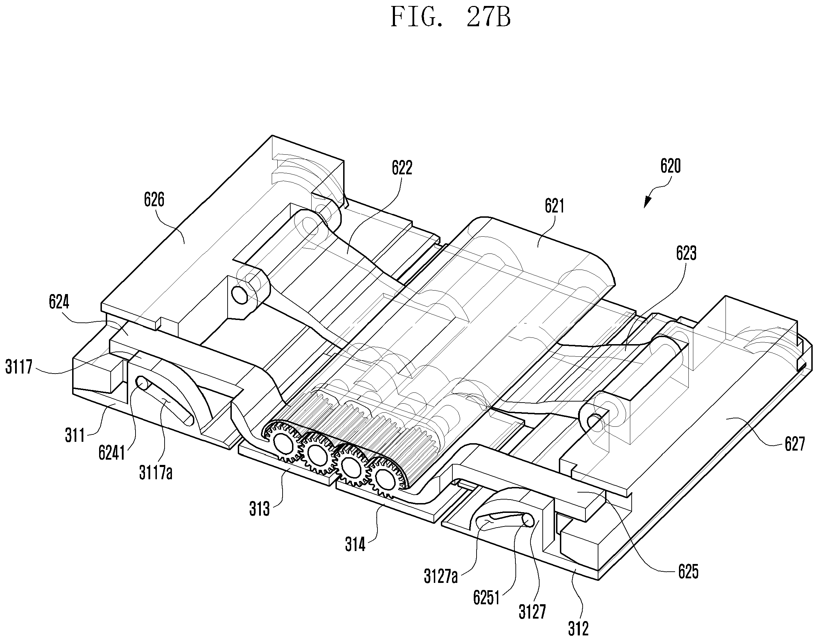

FIG. 27b is a cross-sectional perspective view of the hinge device taken along line 27b-27b of FIG. 27A according to various embodiments of the present disclosure.

### [Mode for the Invention]

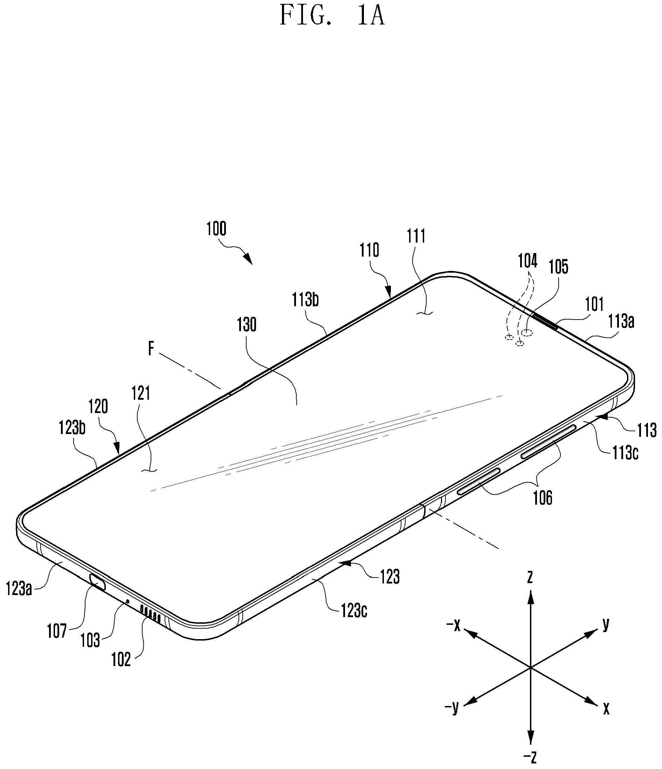

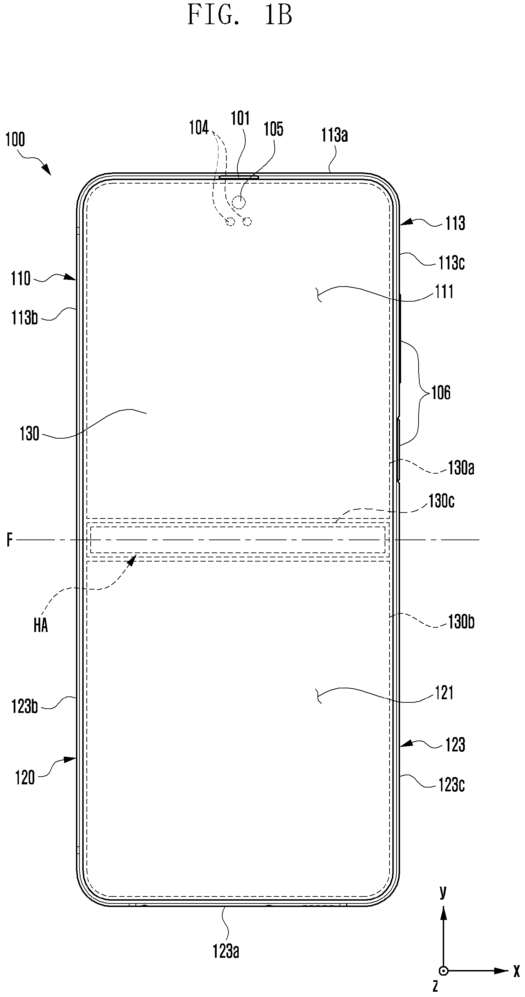

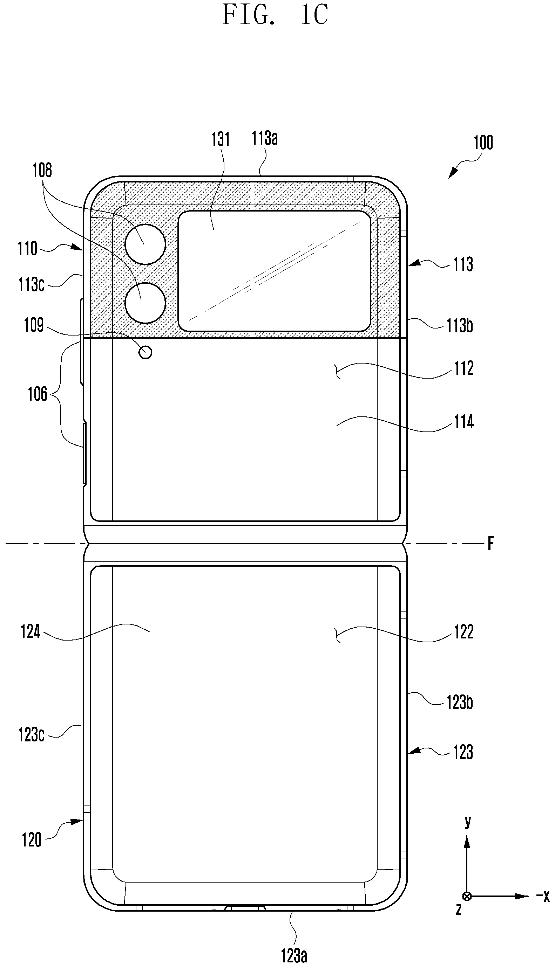

FIG. 1a is a perspective view of an electronic device illustrating a flat state or unfolded state of the electronic device according to various embodiments of the present disclosure. FIG. 1b is a plan view illustrating the front surface of an electronic device in an unfolded state according to various embodiments of the present disclosure. FIG. 1c is a plan view illustrating the rear surface of an electronic device in an unfolded state according to various embodiments of the present disclosure.

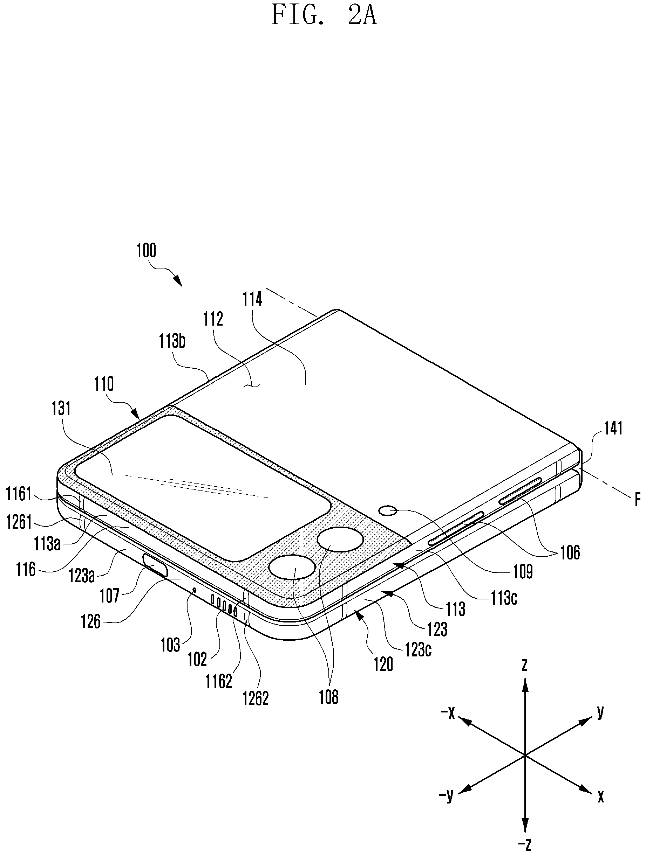

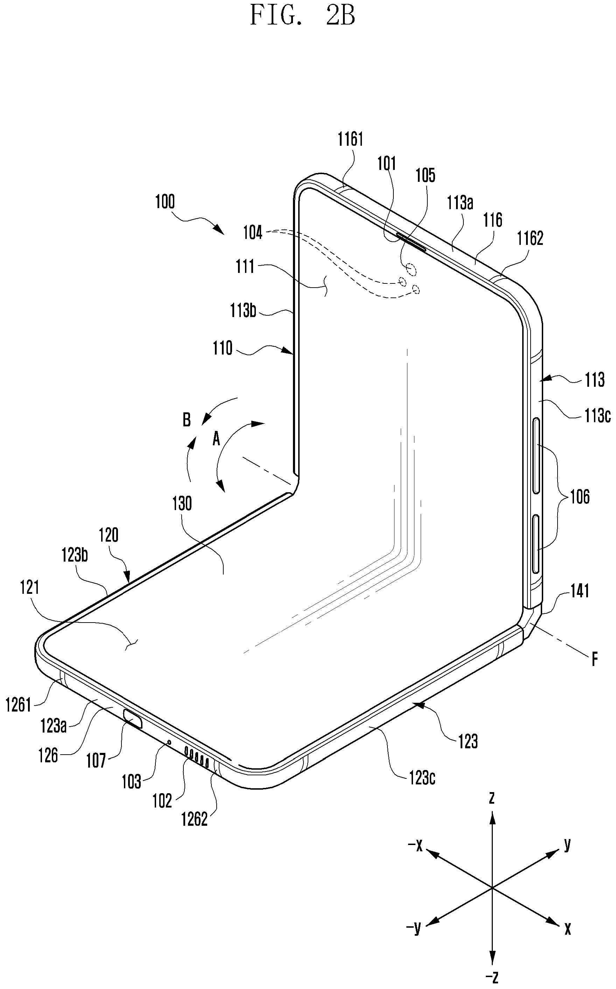

FIG. 2a is a perspective view of an electronic device illustrating a folded state of the electronic device according to various embodiments of the present disclosure. FIG. 2b is a perspective view of an electronic device illustrating an intermediate state of the electronic device according to various embodiments of the present disclosure.

With reference to FIGS. 1a to 2b, the electronic device 100 may include first and second housings 110 and 120 (e.g., a foldable housing structure) that are connected so that they can be folded with respect to each other based on a hinge device (e.g., the hinge device 140 of FIG. 1b). In one embodiment, thehinge device (e.g., the hinge device 140 of FIG. 1b) may be disposed in the direction of the X axis or in the direction of the Y axis. In one embodiment, the electronic device 100 may include a first display 130 (e.g., a flexible display, a foldable display, or a main display) disposed in an area (e.g., recess) formed by the first and second housings 110 and 120. In one embodiment, the first housing 110 and the second housing 120 may be disposed on opposite sides centered on the folding axis F and may have a shape that is substantially symmetrical with respect to the folding axis F. In one embodiment, the angle or distance between the first housing 110 and the second housing 120 may vary depending on the state of the electronic device 100. For example, depending on whether the electronic device is in a flat state or an unfolded state, a folded state, or an intermediate state, the first housing 110 and the second housing 120 may have different angles or distances formed from each other.

In one embodiment, the first housing 110 may include a first surface 111 facing the first direction (e.g., the front direction) (z axis direction) and a second surface 112 facing the second direction (i.e., the rear direction) (-z axis direction) opposite the first surface 111 in the unfolded state of the electronic device 100. In one embodiment, the second housing 120, in the unfolded state of electronic device 100, may include a third surface 121 facing the first direction (in the z-axis direction) and a fourth surface 122 facing the second direction (-z axis direction). In one embodiment, in the unfolded state of the electronic device 100, the first surface 111 of the first housing 110 and the third surface 121 of the second housing 120 may face substantially the same first direction (in the direction of the z axis).In one embodiment, in the folded state of the electronic device 100, the first surface 111 of the first housing 110 and the third surface 121 of the second housing 120 may face each other. In one embodiment, in the unfolded state of the electronic device 100, the second surface 112 of the first housing 110 and the fourth surface 122 of the second housing 120 may face substantially the same second direction (- z axis direction). In one embodiment, in the folded state of the electronic device 100, the second surface 112 of the first housing and the fourth surface 122 of the second housing 120 may face opposite each other. For example, in the folded state of electronic device 100, the second surface 112 may face the first direction (in the z axis), and the fourth surface 122 may face the second direction (-z axis direction).In this case, the first display 130 may not be visible from the outside (in folding mode). In one embodiment, the electronic device 100 may be folded so that the second surface 112 of the first housing 110 and the fourth surface 122 of the second housing 120 face each other. In this case, the first display 130 may be disposed to be viewed from the outside (out-folding).

According to various embodiments, the first housing 110 (e.g., the first housing structure) may include a first lateral member 113 that at least partially forms an exterior of the electronic device 100, and a first rear cover 114 that is coupled to the first lateral member 113 and forms at least portion of the second surface 112 of the electronic device 100. In one embodiment, the first lateral member 113 may include the first side surface 113a, the second side surface 113b extending from one end of the first side surface 113a, and the third side surface 113c extending from the other end of the first side surface 113a. In one embodiment, the first lateral member 113 may be formed into a quadrilateral (e.g., square or rectangular) shape through the first side surface 113a, the second side surface 113b, and the third side surface 113c.

According to various embodiments, the second housing 120 (e.g., the second housing structure) may include a second lateral member 123 that at least partially forms an exterior of the electronic device 100, and a second rear cover 124 that is at least partially coupled to the second lateral member 123, and a second lateral member 123 and forms at least portion of the fourth surface 122 of the electronic device 100. In one embodiment, the second lateral member 123 may include the fourth side surface 123a, the fifth side surface 123b extending from one end of the fourth side surface 123a, and the sixth side surface 123c extending from the other end of the fourth side surface 123a. In one embodiment, the second lateral member 123 may be formed into a quadrilateral shape through the fourth side surface 123a, the fifth side surface 123b, and the sixth side surface 123c.

According to various embodiments, the first and second housings 110, 120 are not limited to the illustrated shape and combination, and may be implemented by a combination and/or a coupling of other shapes or parts. In one embodiment, the first lateral member 113 may be integrally formed with the first rear cover 114, and the second lateral member 123 may be integrally formed with the second rear cover 124.

According to various embodiments, in the unfolded state of the electronic device 100, the second side surface 113b of the first lateral member 113 and the fifth side surface 123b of the second lateral member 123 may be connected without a gap. In one embodiment, in the unfolded state of the electronic device 100, the third side surface 113c of the first lateral member 113 and the sixth side surface 123c of the second lateral member 123 may be connected without a gap. In one embodiment, when electronic device 100 is unfolded, the sum of the lengths of the second side surface 113b and the fifth side surface 123b may be constituted to be longer than the length of the first side surface 113a and/or the fourth side surface 123a. In one embodiment, in the unfolded state of electronic device 100, the sum of the lengths of the third side surface 113c and the sixth side surface 123c may be constituted to be longer than the length of the first side surface 113a and/or the fourth side surface 123a.

With reference to FIG. 2a and FIG. 2b, the first lateral member 113 and/or the second lateral member 123 may contain more polymers formed from or injected into metal. In one embodiment, the first lateral member 113 and/or the second lateral member 123 may also include at least one conductive portion 116 and/or 126 electrically segmented through at least one segmentation portion 1161, 1162 and/or 1261, 1262 formed by the polymer. In such a case, at least one conductive portion 116 and/or 126 may be used as at least portion of an antenna operating in at least one band (e.g., legacy band) specified by an electrical connection with a radio communication circuit contained in electronic device 100.

According to various embodiments, the first rear cover 114 and/or the second rear cover 124 may be formed by a combination of at least one or at least two of the coated or colored glass, ceramics, polymers, or metals (e.g., aluminum, stainless steel (STS), or magnesium).

According to various embodiments, the first display 130 may be disposed to extend from the first surface 111 of the first housing 110 across the hinge device (e.g., the hinge device 140 of FIG. 1b) to at least a portion of the third surface 121 of the second housing 120. In one embodiment, the first display 130 may substantially include a first area 130a corresponding to the first surface 111, a second area 130b corresponding to the second surface 112, and a third area 130c (e.g., a flexible area or folding area) connecting the first area 130a and the second area 130b.In one embodiment, the third area 130c may be disposed in a position corresponding to the hinge device (e.g., the hinge device 140 of FIG. 1b) as part of the first area 130a and/or the second area 130b. In one embodiment, the electronic device 100 may include a hinge housing 141 (e.g., a hinge cover) supporting a hinge device (e.g., the hinge device 140 of FIG. 1b). In one embodiment, the hinge housing 141 may be exposed to the outside when the electronic device 100 is in the folded state, and may be disposed invisibly from the outside by being inserted into the inner space of the first housing 110 and the inner space of the second housing 120when the electronic device 100 is in the unfolded state.

According to various embodiments, electronic device 100 may include a second display 131 (e.g., a subdisplay) that is disposed separately from the first display 130. In one embodiment, the second display 131 may be disposed on the second surface 112 of the first housing 110 to be at least partially exposed. In one embodiment, when the electronic device 100 is in a folded state, the second display 131 may display at least portion of the state information of the electronic device 100, replacing at least portion of the display function of the first display 130. In one embodiment, the second display 131 may be disposed so that it can be viewed from the outside through at least portion of the area of the first rear cover 114. In one embodiment, the second display 131 may be disposed on the fourth surface 122 of the second housing 120. In such a case, the second display 131 may be disposed so that it can be viewed from the outside through at least portion of the area of the second rear cover 124.

According to various embodiments, the electronic device 100 may include at least one of an input device 103 (e.g., microphone), a sound output device 101 and 102, a sensor module 104, a camera device 105 and 108, a keystroke device 106 or a connector port 107. In the illustrated embodiment, the input device 103 (e.g., microphone), the sound output device 101 and 102, the sensor module 104, the camera device 105 and 108, the keystroke device 106 or the connector port 107 are illustrated as holes or circular elements formed in the first housing 110 or second housing 120, but this is illustrative for the purpose of explanation and is not limited thereto. According to various embodiments, input device 103 may include at least one microphone 103 disposed in second housing 120. In one embodiment, input device 103 may include a plurality of microphones 103 that are disposed to detect the direction of sound. In one embodiment, a plurality of microphones 103 may be disposed in appropriate locations in the first housing 110 and/or the second housing 120. In one embodiment, sound output devices 101 and 102 may include at least one speaker 101 and 102.In one embodiment, at least one speaker 101 and 102 may include a call receiver 101 disposed in the first housing 110 and a speaker 102 disposed in the second housing 120. In one embodiment, input device 103, sound output device 101 and 102 and connector port 107 are disposed in a space provided in the first housing 110 and/or second housing 120 of the electronic device 100 and may be exposed to the external environment through at least one hole formed in the first housing 110 and/or second housing 120. In one embodiment, at least one connector port 107 may be used to transmit and receive power and/or data with an external electronic device. In one embodiment, at least one connector port (e.g., an earjack hole) may also accommodate a connector (e.g., an earjack) for transmitting and receiving audio signals with an external electronic device. In one embodiment, holes formed in first housings 110 and/or second housings 120 may be used for input devices 103 and sound outputs 101 and 102. In one embodiment, sound output devices 101 and 102 may also include speakers (e.g., piezo speakers) that are not exposed through holes formed in the first housing 110 and/or second housing 120.

According to various embodiments, the sensor module 104 may generate electrical signals or data values corresponding to the internal operating state of electronic device 100 or external environmental conditions. In one embodiment, the sensor module 104 may detect the external environment through the first surface 111 of the first housing 110. In one embodiment, the electronic device 100 may include at least one additional sensor module that is disposed to detect the external environment through the second surface 112 of the first housing 110. In one embodiment, sensor module 104 (e.g., an illuminance sensor) may be disposed under first display 130 to detect the external environment through first display 130.In one embodiment, the sensor module 104 may include at least one of the following gesture sensors, gyro sensors, barometric pressure sensors, magnetic sensors, acceleration sensors, grip sensors, color sensors, infrared (IR) sensors, biometric sensors, temperature sensors, humidity sensors, ambient light sensors, proximity sensors, biometric sensors, ultrasonic sensors, or ambient light sensors 104.

According to various embodiments, camera devices 105 and 108 may include a first camera device 105 (e.g., a front camera device) disposed on the first surface 111 of the first housing 110 and a second camera device 108 disposed on the second surface 112 of the first housing 110. In one embodiment, electronic device 100 may further include flash 109 disposed near second camera device 108. In one embodiment, camera devices 105 and 108 may include at least one lens, an image sensor, and/or an image signal processor. In one embodiment, camera devices 105 and 108 may be disposed so that two or more lenses (e.g., a wide-angle lens, an ultra-wide-angle lens, or a telephoto lens) and two or more image sensors are located on one surface of the electronic device 100 (e.g., the first surface 111, the second surface 112, the third surface 121), or the fourth surface 122).In one embodiment, the camera devices 105 and 108 may include lenses and/or image sensors for time of flight (TOF).

According to various embodiments, the keystroke device 106 (e.g., a key button) may be disposed on the third side surface 113c of the first lateral member 113 of the first housing 110. In one embodiment, the keystroke device 106 may be disposed on at least one side surface of the other side surfaces 113a and 113b and/or side surfaces 123a, 123b, and 123c of the second housing 120. In one embodiment, the electronic device 100 may not include some or all of the keystroke devices 106 and the non-contained keystroke device 106 may be implemented in another form, such as a soft key, on the first display 130. In one embodiment, the keystroke device 106 may be implemented using a pressure sensor included in first display 130.

According to various embodiments, some of the camera devices 105 and 108 (e.g., the first camera device 105) or sensor module 104 may be disposed to be exposed through the first display 130. In one embodiment, the first camera device 105 or sensor module 104 may be optically exposed to the outside through an opening (e.g., a through hole) formed at least partially on the first display 130 in the inner space of the electronic device 100. In one embodiment, at least portion of the sensor module 104 may be disposed in the inner space of the electronic device 100 so that it is not visually exposed through the first display 130.With reference to FIG. 2b, the electronic device 100 may be operated through a hinge device (e.g., the hinge device 140 of FIG. 1b) to maintain at least one specified folding angle in the intermediate state. In such a case, electronic device 100 may control the first display 130 so that different contents are displayed in the display area corresponding to the first surface 111 and the display area corresponding to the third surface 121.In one embodiment, the electronic device 100 may operate in a substantially unfolded state (e.g., the unfolded state of FIG. 1a) and/or in a substantially folded state (e.g., the folded state of FIG. 2a) with respect to a certain folding angle (e.g., the angle between the first housing 110 and the second housing 120when the electronic device 100 is in an intermediate state) through a hinge device (e.g., the hinge device 140 of FIG. 1b). In one embodiment, the electronic device 100 may be operated through a hinge device (e.g., the hinge device 140 of FIG. 1b) to transition to an unfolded state (e.g., the unfolded state of FIG. 1a) when pressurized force is provided in the unfolding direction (A direction) at a certain folding angle. In one embodiment, the electronic device 100 may be operated through a hinge device (e.g., the hinge device 140 of FIG. 1b) in an unfolded state at a certain folding angle, to transition to a folded state (e.g., a folding state of FIG. 2a) if pressing force is provided in the direction to be folded (B direction). In one embodiment, the electronic device 100 may be operated through a hinge device (e.g., the hinge device 140 of FIG. 1b) to maintain an unfolded state (not shown) at various folding angles (free-stop function).

FIG. 3a is a configuration diagram of an electronic device including a hinge assembly according to various embodiments of the present disclosure. FIGS. 3a and 3c are exploded perspective views of a hinge assembly viewed from the front surface and rear surface according to various embodiments of the present disclosure.

With reference to FIGS. 3a to 3c, the electronic device 100 may include a first housing 110 (e.g., a first housing structure), a second housing 120 (e.g., a second housing structure) that is foldably connected to the first housing 110 by a hinge assembly HA and a flexible display (e.g., the first display 130 of FIG. 1a) disposed to support the first housing 110 and the second housing 120.

According to various embodiments, the hinge assembly HA may include at least one hinge device 320 and 320-1 coupled to a hinge housing 141, a pair of wing plates 311 and 312 coupled to at least one hinge device 320 and 320-1, and a pair of center bars 313 and 314 disposed between a pair of wing plates 311 and 312. In one embodiment, a pair of wing plates 311 and 312 may include a first wing plate 311 forming the same plane as the first housing 110 and a second wing plate 312 forming the same plane as the second housing 120. In one embodiment, a pair of center bars 313 and 314 may include a first center bar 313 rotatably disposed under the first wing plate 311 and a second center bar 314 rotatably disposed under the second wing plate 312.In one embodiment, when the electronic device 100 is in the unfolded state, the first wing plate 311, the second wing plate 312, the first center bar 313, and the second center bar 314 may smoothly support the flexible display (e.g., the first display 130 of FIG. 1a) by forming the same plane as the first housing 110 and the second housing 120. In one embodiment, the first center bar 313 may be operated to rotate at the same angle as the first wing plate 311 from the first state, in which the electronic device 100 is fully unfolded, to the third state which is an intermediate state between the first state and the second state, in which the electronic device 100 is fully folded, and rotate at a different angle from the first wing plate 311 from the third state to the second state. For example, the first center bar 313 may be rotated from the third state to the second state at a smaller rotation angle than the first wing plate 311, or its position may change slightly without being rotated. In some embodiments, the first center bar 313 may not operate from the third state to the second state. In one embodiment, the second center bar 314 may be operated to rotate at the same angle as the second wing plate 312 from the first state to the third state, and to rotate at a different angle from the second wing plate 312 from the third state to the second state. For example, the second center bar 314 may be rotated from the third state to the second state at a smaller rotation angle than the second wing plate 312, or its position may be slightly changed without being rotated. In some embodiments, the second center bar 314 may not operate from the third state to the second state.

In various embodiments, at least one hinge device 320and 320-1 may include a first hinge device 320 and a second hinge device 320-1 disposed at both ends of the wing plates 311 and 312 and center bars 313 and 314, respectively. In some embodiments, at least one hinge device 320 and 320-1 may be disposed with one or more than three at a predetermined interval. In one embodiment, at least one hinge device 320 and 320-1 may be at least partially fixed to the first housing 110 and the second housing 120. In one embodiment, at least one hinge device 320 and 320-1 may be at least partially fixed to the hinge housing 141. In one embodiment, the first wing plate 311 and the second wing plate 312 may be fixed through a screw S to at least one hinge device 320 and 320-1. In one embodiment, the first center bar 313 and the second center bar 314 may be rotatably fixed to at least one hinge device 320 and 320-1. In one embodiment, the first center bar 313 is rotatably fixed to the first wing plate 311, and the second center bar 314 may be rotatably fixed to the second wing plate 312.

The first center bar 313 and second center bar 314 according to the exemplary embodiments of the present disclosure may help to secure space for efficient placement of the surrounding structure and to slim down the electronic device 100 through the reduced rotation radius of the first and second wing plates 311 and 312 compared to the rotation radius of the first and second wing plates that support the flexible display 130 without the center bars 313 and 314 by operating in a close proximity to the first display (e.g., the first display 130 of FIG. 1a) at a different angle from the first wing plate 311 and the second wing plate 312 while the electronic device 100 is operated from the third state to the second state.

In describing the following drawings, the first hinge device 320 from at least one hinge device 320 and 320-1 has been described, but the second hinge device 320-1 may also have substantially the same configuration. In addition, the assembly structure and operating structure of the first wing plate 311 and the first center bar 313 coupled with at least one hinge device 320 and 320-1 have been mainly described, but the assembly structure and operating structure of the second wing plate 312and the second center bar 314 coupled with at least one hinge device 320 and 320-1may also have substantially the same configuration.

FIGS. 4a and 4b are exploded perspective views of a hinge device viewed from the front surface and rear surface according to various embodiments of the present disclosure. Figs. 4a, 4b, 5, 6a and 6b all share the concept of having six rotation axes X1 to X6 and therefore features of these embodiments may be combined. Whenever axes Xn are referred to, such axes preferably run in parallel to one another as shown in the figures.

With reference to FIG. 4a and 4b, the hinge device 320 includes a rotator bracket 321 that may be fixed to the hinge housing (e.g., the hinge housing 141 of FIG. 3a) through a fastening member such as a screw S; a first rotator 322 rotatably disposed on the rotator bracket 321 with respect to the first rotation axis X1; a second rotator 323 rotatably disposed on the rotator bracket 321 with respect to the second rotation axis X2; a first link 326 rotatably coupled to the first rotator 322 with respect to the third rotation axis X3; a second link 327 rotatably coupled to the second rotator 323 with respect to the fourth rotation axis X4; a first hinge arm 324, one end of which is rotatably disposed on the rotator bracket 321 with respect to the fifth rotation axis X5 and the other end of which is movably coupled to the first link 326; a second hinge arm 325, one end of which is rotatably disposed on the rotator bracket 321 with respect to the sixth rotation axis X6 and the other end of which is movably coupled to the second link 327. Accordingly, a folding/unfolding force exerted on the first link 326 may cause rotation of the first hinge arm 324 and the first rotator 322. The first rotator 322 causes a rotation of the first wing plate 311 which is translated to a rotation of the first center bar 313. In the same manner, a folding/unfolding force exerted on the second link 327 may cause rotation of the second hinge arm 325 and the second rotator 323. The second rotator 323 causes a rotation of the second wing plate 312 which is translated to a rotation of the second center bar 314.

According to various embodiments, the first rotator 322 may include the curved first guide slit 3221 at one end. In one embodiment, the second rotator 323 may include a curved second guide slit 3231 formed at one end. In one embodiment, the first rotator 322 may include a curved third guide slit 3222 formed at the other end. In one embodiment, the second rotator 323 may include a curved fourth guide slit 3232 formed at the other end. In one embodiment, the first rotator 322 may be rotatably coupled with respect to the first rotation axis X1 by the curved first guide rib 3211 formed on the rotator bracket 321 being coupled to the first guide slit 3221. In one embodiment, the second rotator 323 may be rotatably coupled with respect to the second rotation axis X2 by the curved second guide rib 3212 formed on the rotator bracket 321 being coupled to the second guide slit 3231.

According to various embodiments, the first link 326 may be rotatably coupled with respect to the third rotation axis X3 by the curved third guide rib 3261 formed at least in part being coupled to the third guide slit 3222. In one embodiment, the second link 327 may be rotatably coupled with respect to the fourth rotation axis X4 by the curved fourth guide rib 3271 formed at least in part being coupled to the fourth guide slit 3232. In one embodiment, the first link 326 may be fixed to the first housing (e.g., the first housing 110 of FIG. 3a). In one embodiment, the second link 327 may be fixed to the second housing (e.g., the second housing 120 of FIG. 3a).

According to various embodiments, the first hinge arm 324 may include a first guide body 3241 movably coupled to the first guide groove 3262 formed on the first link 326, a first gear structure 3242 formed on one side of the first guide body 3241, and a first cam structure 3243 formed in a direction opposite the first gear structure 3242. According to one embodiment, the second hinge arm 325 may include a second guide body 3251 movably coupled to the second guide groove 3272 formed on the second link 327, a second gear structure 3252 formed on one side of the second guide body 3251, and a second cam structure 3253 formed in a direction opposite the second gear structure 3252. In one embodiment, the first hinge arm 324 may be slidingly coupled with respect to the first link 326 via a linear guide structure of the first guide body 3241 and the first guide groove 3262. In one embodiment, the first hinge arm 324 may induce the first link 326 to rotate with respect to a specified rotation axis (e.g., the ninth rotation axis X9 of FIG. 23a) through a curved guide structure of the first guide body 3241 and the first guide groove 3262. In one embodiment, the second hinge arm 325 may be slidingly coupled with respect to the second link 327 via a linear guide structure of the first guide body 3241 and the second guide groove 3272.In some embodiments, the second hinge arm 325 may be induced to rotate with respect to the specified rotation axis (e.g., the tenth rotation axis X10 of FIG. 23a), through a curved guide structure of the second guide body 3251 and the second guide groove 3272.

According to various embodiments, the hinge device 320 may be supported by the support portion 3214 and the gear bracket 3215 formed on the rotator bracket 321 and may include a pair of idle gears 328 that are paired with the first gear structure 3242 and the second gear structure 3252 respectively. In one embodiment, one gear of a pair of idle gears 328 may be gear-coupled with the first gear structure 3242 and the remaining gear, and the remaining gear may be geared with the second gear structure 3252. Therefore, when the first link 326 is unfolded or folded together with the first housing 110, the second link 327 and the second housing 120 may also be induced to unfold or fold together at the same angle through a pair of idle gears 328 gear-coupled with the first and second gear structures 3242 and 3252.

According to various embodiments, the hinge device 320 may include a cam body 329 comprising a third cam structure 3291 cam-coupled to the first cam structure 3243 and a fourth structure 3292 cam-coupled to the second cam structure 3253 and a torque-generating structure that includes a pair of springs CS that press the cam body 329 in the direction (e.g., the -x axis direction) of the first hinge arm 324 and the second hinge arm 325 through the shaft bracket 3216. In one embodiment, the first hinge arm 324 may be rotated with respect to the fifth rotation axis X5. In one embodiment, the first gear structure 3242 and the first cam structure 3243of the first hinge arm 324, the gear bracket 3215, the third cam structure 3291 of the cam body 329, the spring CS and the first shaft HS1 penetrating the shaft bracket 3216 may be aligned. In one embodiment, the second hinge arm 325 may be rotated with respect to the sixth rotation axis X6. In one embodiment, the second gear structure 3252 and the first cam structure 3243 of the second hinge arm 325, the gear bracket 3215, the fourth cam structure 3292 of the cam body 329, the spring CS and the second shaft HS2 penetrating the shaft bracket 3216 may be aligned. In one embodiment, the first shaft HS1 and the second shaft HS2 may be constrained not to be escaped by the E-rig structure 3213. In one embodiment, the cam body 329 may be moved in a direction parallel to the fifth rotation axis X5 and sixth rotation axis X6, the first cam structure 3243 of the first hinge arm 324 is rotatably disposed with respect to the fifth rotation axis X5, and the second cam structure 3253 of the second hinge arm 325 may be rotatably disposed with respect to the sixth rotation axis X6.In one embodiment, when the first cam structure 3243 is rotated with respect to the fifth rotation axis X5 by the first hinge arm 324, the third cam structure 3291 coupled with the cam supported by the spring CS may be retracted backwards and torque may be generated. Similarly, when the second cam structure 3253 is rotated with respect to the sixth rotation axis X6 by the second hinge arm 325, the fourth cam structure 3292 coupled with the cam supported by the spring CS may be retracted backwards and torque may be generated. Therefore, torque may be generated as the cam body 329 is retracted to the rear direction by the retraction of the third cam structure 3291 and the fourth cam structure 3292.In one embodiment, the magnitude of the torque may be determined by the shape of the first cam structure 3243 and the third cam structure 3291 coupled therewith and the shape of the second cam structure 3253 and the fourth cam structure 3292 coupled therewith, and by the determined torque, the first housing 110 and second housing 120 may be configured to be pressurized in the direction of unfolding or folding at a specified angle of inflection or more, or to stop at a specified angle.

FIG. 5 is a coupling perspective view of a hinge device according to various embodiments of the present disclosure. FIGS. 6a and 6b are cross-sectional views of a hinge device in an unfolded and folded state of the electronic device as taken along line 6-6 of FIG. 5 according to various embodiments of the present disclosure. FIGS. 7a and 7b are cross-sectional views of the hinge device in an unfolded and folded state of the electronic device as taken along line 7-7 of FIG. 5 according to various embodiments of the present disclosure. Thus, features of Figs 7a and 7b are also combinable with the features of Figs. 4a to 6b.

With reference to FIGS. 5 to 7b, the hinge device 320 may be disposed to support the first and second wing plates 311 and 312 and the first and second center bars 313 and 314 disposed on top of it. In one embodiment, the first wing plate 311 may be fixed to the first rotator 322 via a fastening member (e.g., a screw). In one embodiment, the second wing plate 312 may be fixed to the second rotator 323 via a fastening member. In one embodiment, the first center bar 313 may be disposed between the first wing plate 311 and the second wing plate 312. In one embodiment, the second center bar 314 may be disposed between the second wing plate 312 and the first center bar 313. In one embodiment, the first center bar 313 may be rotatably disposed in part between the first wing plate 311 and the first rotator 322. The second center bar 314 may be rotatably disposed in part between the second wing plate 312 and the second rotator 323.

According to various embodiments, the first rotator 322 may be rotatably coupled with respect to the first rotation axis X1 by the curved first guide rib 3211 formed on the rotator bracket 321 being coupled to the first guide slit 3221. In one embodiment, the second rotator 323 may be rotatably coupled with respect to the second rotation axis X2 by the curved second guide rib 3212 formed on the rotator bracket 321 being coupled to the second guide slit 3231. In one embodiment, the first link 326 may be rotatably coupled with respect to the third rotation axis X3 by the curved third guide rib 3261 formed at least in part being coupled to the third guide slit 3222. In one embodiment, the second link 327 may be rotatably coupled with respect to the fourth rotation axis X4 by the curved fourth guide rib 3271 formed at least in part being coupled to the fourth guide slit 3232. In one embodiment, the first hinge arm 324 may be rotated with respect to the fifth rotation axis X5 by the rotation of the first link 326. The second hinge arm 325 may be rotated with respect to the sixth rotation axis X6 by the rotation of the first link 326. The first hinge arm 324 and second hinge arm 325 may be induced to rotate at the same angle through the first gear structure 3242 and the second gear structure 3252 and the gear-coupled idle gears 328.

According to various embodiments, the first wing plate 311 may be induced to rotate at an angle greater than the folding angle (e.g., 90 degrees) of the first housing 110 through a coupling structure of the rotator bracket 321 rotating with respect to the first rotation axis X1 and the first rotator 322, a coupling structure of the first rotator 322 and the first link 326 by the third rotation axis X3 that is different from the first rotation axis X1, and the coupling structure by the slide coupling of the first hinge arm 324 and the first link 326. In one embodiment, the second wing plate 312 may be induced to rotate at an angle greater than the folding angle (e.g., 90 degrees)of the second housing 120 through the coupling structure of the rotator bracket 321 rotating with respect to the second rotation axis X2 and the second rotator 323, the coupling structure of the second rotator 323 and the second link 327 by the fourth rotation axis X4 that is different from the second rotation axis X2, and the coupling structure by the slide coupling of the second hinge arm 325 and the second link 327.In one embodiment, the space provided by rotating the first wing plate 311 and the second wing plate 312 at an angle greater than the folding angle of the housings 110 and 120 may be used as a receiving space to accommodate the water-drop-shaped bending area of the flexible display.

According to the exemplary embodiments of the present disclosure, the first center bar 313 and second center bar 314 may help to secure space for efficient placement of the surrounding structure and to slim down the electronic device 100 through the reduced rotation radius of the first and second wing plates 311 and 312 compared to the rotation radius of the first and second wing plates that support the flexible display 130 without the center bars 313 and 314 by operating in a close proximity to the first display (e.g., the first display 130 of FIG. 1a) at a different angle from the first wing plate 311 and the second wing plate 312 while the electronic device 100 is operated from the third state to the second state.

FIG. 8a is a perspective view of a first center bar according to various embodiments of the present disclosure. FIG. 8b is a partial perspective view illustrating the arrangement structure of the first center bar and the first wing plate according to various embodiments of the present disclosure. FIG. 8c is a diagram illustrating a coupling structure of a first center bar and a first rotator according to various embodiments of the present disclosure. FIG. 8d is a diagram illustrating the arrangement structure of the first center bar and the first wing plate in a state in which the first center bar is mounted on the first rotator according to various embodiments of the present disclosure.

With reference to FIGS. 8a to 8d, the first center bar 313 of any of the preceding figures may include a downward extended center bar shaft 3131. In one embodiment, the first center bar 313 may be disposed to rotate with respect to the seventh rotation axis X7 through the center bar shaft 3131. In one embodiment, the center bar shaft 3131 may be disposed in a position overlapping with the first wing plate 311.

According to various embodiments, the first center bar 313 may be rotatably disposed on the first rotator 322. For example, the first center bar 313 may be rotatably disposed in the shaft receiving groove 3223 where the center bar shaft 3131 is formed on the first rotator 322 and may be constrained not to be escaped by the first wing plate 311 fixed to the first rotator 322. Therefore, the first center bar 313 may be rotatably coupled in the first rotator 322 and may be disposed to have the same plane as the first wing plate 311. In one embodiment, the first center bar 313 may be disposed to be pressurized in the direction of rotation specified through a torsion spring TS1.For example, while one end of the torsion spring TS1 is supported by the first rotator 322, the other end may be disposed to pressurize the first center bar 313 in a downward direction (e.g., in the opposite direction to the flexible display 130). This is to prevent or reduce the deterioration of surface quality such as the lifting phenomenon that may occur by arbitrarily pressurizing the rear surface of the flexible display 130 during operation of the first center bar 313. In some embodiments, the torsion spring TS1 may be omitted. Although not shown, the second center bar (e.g., the second center bar 314 of FIG. 9) may also have substantially the same configuration and, under the second wing plate 312, may be disposed rotatably with respect to the eighth rotation axis (e.g., the eighth rotation axis X8 of FIG. 9).

FIG. 8e is a side view illustrating the arrangement structure of the center bar and wing plate in the unfolded state according to various embodiments of the present disclosure. FIG. 8f is a side view illustrating the arrangement structure of the center bar and wing plate in a folded state according to various embodiments of the present disclosure.

With reference to FIGS. 8e and 8f, the first center bar 313 may be disposed rotatably with respect to the seventh rotation axis X7 in the first rotator 322 through the center bar shaft 3131. In one embodiment, the first center bar 313 may be prevented from escaping to the outside by the center bar shaft 3131 intervening between the first wing plate 311 and the first rotator 322. In one embodiment, the first center bar 313 may be disposed to be pressurized in the opposite direction (① direction) to the flexible display via a torsion spring TS1.

According to various embodiments, in the unfolded state, the first center bar 313 may be supported by the first rotator 322 to form the same plane as the first wing plate 311. In this case, the first center bar 313 may be in a state of downward pressure (① direction) through the torsion spring TS1. In one embodiment, while electronic device 100 is transitioning to a folding state, the first center bar 313 may be moved together with first wing plate 311 at the same rotation angle. In one embodiment, first center bar 313 may be supported by a surrounding structure when electronic device 100 reaches a third state, between a fully unfolded first state and a fully folded second state. In such a case, during the transition from the second state to the third state, the first wing plate 311 may be continuously rotated, and the first center bar 313 may rotate and/or move slightly in its position or remain in that state. Therefore, the first center bar 313 may stably support the flexible display 130 bent in a water drop shape, and by the different rotation angles of the first center bar 313 and the first wing plate 311, compared to the rotation radius of the conventional first wing plate supporting the flexible display 130 without the first center bar 313, the rotation radius of the first wing plate 311 may be partially reduced, and the reduced space may be used as an efficient placement space for the surrounding structure.

FIG. 9 is a diagram illustrating the position of the center bar (313 or 314 of any of the preceding figures) in a folded state according to various embodiments of the present disclosure.

With reference to FIG. 9, the electronic device (e.g., the electronic device 100 of FIG. 3a) may include the first wing plate 311 and the second wing plate 312 disposed to support the rear surface of the flexible display 130 in the folded state. In one embodiment, the electronic device 100 may include a first center bar 313 rotatably disposed with respect to the first wing plate 311 and a different seventh rotation axis under the first wing plate 311 and a second center bar 314 rotatably disposed with respect to the second wing plate 312 and a different eighth rotation axis X8 under the second wing plate 312. In one embodiment, the first center bar 313 may be disposed to be pressurized in the opposite direction (① direction) to the flexible display 130 through the torsion spring TS1, and the second center bar 314 may also be disposed to be pressurized in the opposite direction (① direction) to the flexible display 130 through the torsion spring TS1. In one embodiment, the first center bar 313 and the second center bar 314 may be driven in such a way that they are supported by the surrounding structure when the electronic device 100 is in a folded state, are disposed at different angles from the first wing plate 311 and the second wing plate 312, respectively, and are supported to be in contact with or in close proximity to the bending portion of the flexible display 130 formed in a water droplet shape.

According to various embodiments, the first center bar 313 and the second center bar 314 may, in the folded state, pass through the outer peripheral surface of the bending portion of the flexible display 130 and be disposed under the normal line L2 to the tangent line L1 perpendicular to the surface DS of the unfolded display DS. In one embodiment, this disposition structure of the first center bar 313 and the second center bar 314 may exclude interference during the folding operation of the flexible display 130 and support the lower part of the bending portion, thereby helping to prevent damage to the flexible display 130 by external impact.

FIGS. 10a and 10b are diagrams illustrating a combination structure of center bars (313 and 314 of any of the preceding figures) and rotators (322 and 323 of any of the preceding figures) according to various embodiments of the present disclosure.

With reference to FIGS. 10a and 10b, the hinge device 320 may include a first center bar 313 rotatably coupled to the first rotator 322 and a second center bar 314 rotatably coupled to the second rotator 323. In one embodiment, the first center bar 313 may include a first arm 3132 to be rotatably inserted into the first arm receiving portion 3224 formed on the first rotator 322. In one embodiment, the second center bar 314 may include a second arm 3142 to be rotatably inserted into the second arm receiving portion 3234 formed on the second rotator 323.In one embodiment, the first center bar 313 and the second center bar 314 may be rotatably disposed via a hinge pin HP disposed to be penetrated from the outside after the first arm 3132 and second arm 3142 are accommodated in the first arm receiving portion 3224 of the first rotator 322 and the second arm receiving portion 3234 of the second rotator 323, respectively. In one embodiment, the first arm 3132 and the second arm 3142 may be prevented from escaping to the outside through the first wing plate (e.g., the first wing plate 311 of FIG. 9) and the second wing plate (e.g., the second wing plate 312 of FIG. 9) disposed on top of the second rotator 323.

FIG. 11 is a perspective view illustrating a coupling structure of a first center bar (313 of any of the preceding figures) and a first wing plate (311 of any of the preceding figures) according to various embodiments of the present disclosure.

With reference to FIG. 11, the first center bar 313 may be rotatably disposed with respect to the first wing plate 311 under the first wing plate 311. In one embodiment, the center bar shaft 3131 of the first center bar 313 may be disposed to be rotatable through the shaft jam 311a formed under the first wing plate 311. In such a case, the torsion spring TS2 may be disposed so that the first end is supported by the rear surface of the wing plate 311 and the other end pressurizes the first center bar 313 in the opposite direction (① direction) of the flexible display (e.g., the flexible display 130 of FIG. 9). In some embodiments, the torsion spring TS2 may be omitted. Although not shown, the second center bar (e.g., the second center bar 314 of FIG. 9) may also be disposed substantially in the same manner on the second wing plate (e.g., the second wing plate 312 of FIG. 9).

FIG. 12 is a diagram illustrating a coupling structure of center bars (313 and 314 of any of the preceding figures) and hinge arms (324 and 325 of any of the preceding figures) according to various embodiments of the present disclosure.

With reference to FIG. 12, the first center bar 313 may be rotatably disposed in the shaft receiving groove 3245 formed on the first hinge arm 324, and the second center bar 314 may be rotatably disposed in the shaft receiving groove (not shown) formed in the same manner on the second hinge arm 325. In this case, the first center bar 313 may be at least partially penetrated by the first center bar shaft 3131 and may be supported by a torsion spring TS3 that presses the first center bar 313 in the opposite direction to the flexible display (e.g., the flexible display 130 of FIG. 9) while being supported by the shaft receiving groove 3245 at the other end. Substantially in the same manner, the second center bar 314 may be disposed to be supported by a torsion spring TS3 that is at least partially penetrated into the second center bar shaft 3141.

FIG. 13 is a perspective view illustrating a coupling structure of a first center bar (313 of any of the preceding figures) and a first wing plate (311 of any of the preceding figures) according to various embodiments of the present disclosure.

With reference to FIG. 13, the first center bar 313 may be rotatably disposed by a rail coupling structure on the first rotator 322. In one embodiment, the first center bar 313 may include a guide rail 3133 formed in a curve on the rear surface, and the first rotator 322 may be formed in a curve corresponding to the guide rail 3133 and may include a guide slit 3225 to accommodate the guide rail 3133. In one embodiment, the first center bar 313 may be disposed so that it moves with the first wing plate 311 up to a specified folding angle of the entire folding angle of the electronic device by guiding the guide rail 3133 along the guide slit 3225 of the first rotator 322.Although not shown, a second center bar (e.g., a second center bar 314 of FIG. 3a) may also be disposed through a substantially identical rail coupling structure to a second rotator (e.g., second rotator 323 of FIG. 3a).

FIG. 14a is a plan view of a hinge assembly according to various embodiments of the present disclosure.

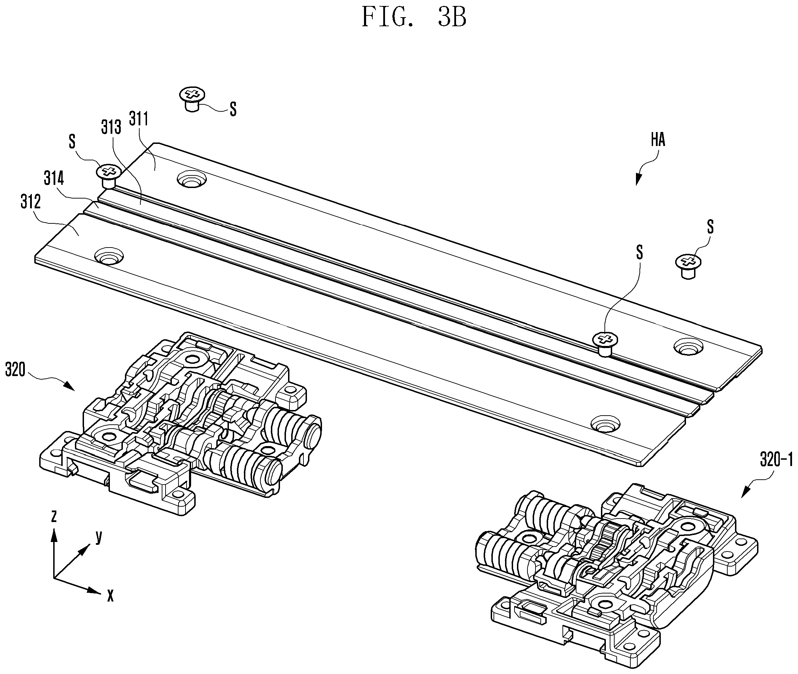

With reference to FIG. 14a, the hinge assembly HA may include at least one hinge device (e.g., at least one hinge device 320 and 320-1 of for example FIG. 3b) coupled to a hinge housing (e.g., the hinge housing 141 of for example FIG. 3a), a pair of wing plates 311 and 312 coupled to a hinge housing 320 and 320-1, and a pair of center bars 313 and 314 disposed between a pair of wing plates 311 and 312.In one embodiment, when the electronic device 100 is in the unfolded state, the first wing plate 311, the second wing plate 312, the first center bar 313, and the second center bar 314 may form the same plane as the first housing (e.g., the first housing 110 of FIG. 3a) and the second housing (e.g., the second housing 120 of FIG. 3a), so that the flexible display (e.g., the first display 130 of FIG. 1a) can be smoothly supported.

According to various embodiments, when the electronic device 100 is in the unfolded state, the first center bar 313 and the second center bar 314 may include the following support structures disposed to form the same plane as the first wing plate 311 and the second wing plate 312.

FIG. 14b is a cross-sectional view of the hinge assembly taken along line 14b-14b of FIG. 14a according to various embodiments of the present disclosure.

With reference to FIG. 14b, when the electronic device 100 is unfolded, the first center bar 313 and the second center bar 314 may form the same plane as the first wing plate 311 and the second wing plate 312, so that the flexible display 130 can be smoothly supported. In this case, even if the first center bar 313 is pressurized in the opposite direction (① direction) to the flexible display 130, it is supported in the direction facing the flexible display (② direction) in a way that it is contacted through a portion of the first rotator 322, so that it can be prevented from sagging downward. In one embodiment, even if the second center bar 314 is also pressurized in the opposite direction (①direction) to the flexible display 130, it is supported in the direction (② direction) toward the flexible display in a way that it is contacted through a portion of the second rotator 323, so that it can be prevented from sagging downward.

FIG. 14c is a cross-sectional view of the hinge assembly taken along line 14c-14c of FIG. 14a according to various embodiments of the present disclosure.

With reference to FIG. 14c, when the electronic device 100 is unfolded, the first center bar 313 and the second center bar 314 may form the same plane as the first wing plate 311 and the second wing plate 312, so that the flexible display 130 can be supported smoothly. In this case, even if the first center bar 313 is pressurized in the opposite direction (①direction) to the flexible display 130, it is supported in the direction facing the flexible display (② direction) in a way that it is contacted through the first support 3246 formed on the first hinge arm 324, so that it can be prevented from sagging downward. In one embodiment, even if the second center bar 314 is also pressurized in the opposite direction (① direction) to the flexible display 130, it is supported in the direction (② direction) toward the flexible display in a way that it is contacted through the second support 3256 formed on the second hinge arm 325, so that it can be prevented from sagging downward.

FIG. 14d is a cross-sectional view of the hinge assembly taken along line 14d-14d of FIG. 14a according to various embodiments of the present disclosure.

With reference to FIG. 14d, when the electronic device 100 is unfolded, the first center bar 313 and the second center bar 314 may form the same plane as the first wing plate 311 and the second wing plate 312, so that the flexible display 130 can be supported smoothly. In such a case, even if the first center bar 313 is pressurized in the opposite direction (① direction) to the flexible display 130, it is supported in the direction (② direction) toward the flexible display in such a way that it is contacted through the first support piece 3111 disposed at least portion of the first wing plate 311, so that it can be prevented from sagging downward. In one embodiment, even if the second center bar 314 is also pressurized in the opposite direction (① direction) to the flexible display 130, it is supported in the direction (② direction) toward the flexible display in such a way that it is contacted by the second support piece 3121 disposed at least portion of the second wing plate 312, so that it can be prevented from sagging downward. In one embodiment, the first support piece 3111 may be formed integrally with or separately from the first wing plate 311 and then structurally coupled. In one embodiment, the second support piece 3121 may also be formed integrally with or separately from the second wing plate 312 and then structurally coupled.

The support structure of the center bars 313 and 314 according to the exemplary embodiment of the present disclosure may include at least one of the support structures of the above-described FIGS. 14b to 14d.

According to various embodiments, the first center bar 313 and second center bar 314 may be operated to rotate at the same angle as the first wing plate 311 and second wing plate 312 up to the third state, in which the electronic device 100 are intermediate between the fully unfolded first state and the fully folded second state, and may rotate at different angles from the first wing plate 311 and the second wing plate 312 from the third state to the second state or the rotational operation may be stopped. For example, the first center bar 313 and the second center bar 314 may be rotated from the third state to the second state at a smaller rotation angle than the first wing plate 311, or the position may change slightly without rotating. In one embodiment, the hinge device 320 may include a support structure to support these center bars 313 and 314 to perform a different rotational motion from wing plates 311 and 312, from the third state to the second state.

FIG. 15a is a perspective view of center bars (313 and 314 of any of the preceding figures) according to various embodiments of the present disclosure. FIG. 15b is a perspective view of a rotator bracket according to various embodiments of the present disclosure.

With reference to FIGS. 15a and 15b, the first center bar 313 and second center bar 314 may contain at least one protrusion 3134 and 3144 formed to protrude above the rear surface. In one embodiment, the rotator bracket 321 may include at least one protrusion 3134 and 3144 formed on the first center bar 313 and second center bar 314 and at least one contact portion 321a protruding at a corresponding location. In some embodiments, at least one protrusion 3134 and 3144 formed on the first center bar 313 and the second center bar 314 may be omitted.

FIGS. 16a and 16b are diagrams illustrating a support structure for center bars (313 and 314 of any of the preceding figures) by the rotator bracket (321 of any of the preceding figures) according to various embodiments of the present disclosure.

With reference to FIGS. 16a and 16b, when the electronic device 100 is switched from a fully unfolded first state to a folding method, the first center bar 313 may be rotated at the same angle with the first wing plate 311. In one embodiment, when electronic device 100 reaches the third state, between the fully unfolded first state and the fully folded second state, the protrusion 3134 protruding from the rear surface of the first center bar 313 may be contacted to the contact portion 321a of the rotator bracket 321. In such a case, if the electronic device 100 is continuously folded from the third state to the second state, the first wing plate 311 may be continuously rotated, and the first center bar 313 may stop rotating, move slightly, or rotate at a different rotation angle from the first wing plate 311. Therefore, the first center bar 313 may be modified to maintain an angle that can be contacted or close to the lower side of the waterdrop shaped bending portion of the flexible display 130, unlike the first wing plate 311 which generally supports the upper portion, through a support structure through the contact portion 321a of the rotator bracket 321. Although not shown, a second center bar (e.g., second center bar 314 of FIG. 15a) may operate substantially in the same manner.

FIG. 17 is a diagram illustrating a support structure for center bars (313 and 314 of any of the preceding figures) by hinge arms (324 and 325 of any of the preceding figures) according to various embodiments of the present disclosure.

Refer to FIG. 17, when the electronic device 100 is switched from a fully unfolded first state to a folding method, the first center bar 313 and the second center bar 314 may be rotated at the same angle with each of the first wing plate 311 and the second wing plate 312. In one embodiment, when the electronic device 100 reaches the third state, between the first state and the fully folded second state, the first center bar 313 may be in contact with at least portion of the first hinge arm 324, and the second center bar 314 may be in contact with at least portion of the second hinge arm 325. In such a case, if the electronic device 100 is continuously folded from the third state to the second state, the first wing plate 311 may be continuously rotated, and the first center bar 313 may be stopped in rotation by the first hinge arm 324, moved slightly, or rotated at a different rotation angle from the first wing plate 311. Similarly, the second wing plate 312 may also be continuously rotated, and the second center bar 314 may be stopped in rotation by the second hinge arm 325, moved slightly, or rotated at a different rotation angle from the second wing plate 312. Therefore, the first center bar 313 may be modified to maintain an angle that can be contacted or close to the lower side of the waterdrop shaped bending portion of the flexible display 130, unlike the first wing plate 311 which generally supports the upper portion, by a support structure through at least portion of the first hinge arm 324. Similarly, the second center bar 314 may be modified to maintain an angle that may be contacted or close to the lower side of the waterdrop shaped bending portion of the flexible display 130, unlike the second wing plate 312 which generally supports the upper portion by a support structure through at least portion of the second hinge arm 325.

FIG. 18 is a perspective view of a hinge device illustrating support portions of center bars (313 and 314 of any of the preceding figures) according to various embodiments of the present disclosure.

With reference to FIG. 18, the first center bar 313 and the second center bar 314 may be supported by at least one structure of hinge device 320 when the electronic device 100 reaches the third state. For example, the first center bar 313 and the second center bar 314, when the third state is reached, may be supported by at least a portion (e.g., portions of illustrated dotted line) of the gear bracket 3215 disposed to support the gear structures (e.g., the first gear structure 3242, the second gear structure 3252, and the idle gears 328) and/or the shaft bracket 3216 disposed to support the springs CS as components of the hinge device 320.

FIG. 19a is a perspective view of a hinge assembly according to various embodiments of the present disclosure. FIG. 19b is a cross-sectional perspective view of the hinge assembly taken along a line 19b-19b of FIG. 19a according to various embodiments of the present disclosure.

According to various embodiments, the center bars 313 and 314having a relatively small width may be shaken or deformed by external impact because there is no separate support structure in the portion (e.g., the central portion) other than the portion where the hinge devices 320 and 320-1 are disposed. An exemplary embodiment of the present disclosure may provide a deformation-resistant structure to support the center bars 313 and 314 in a portion not supported by a hinge device320 and 320-1.

With reference to FIGS. 19a and 19b, the hinge assembly HA may include at least one hinge device 320 and 320-1 coupled to a hinge housing (e.g., the hinge housing 141 of FIG. 3a), a pair of wing plates 311 and 312 coupled to at least one hinge device 320 and 320-1, and a pair of center bars 313 and 314disposed between a pair of wing plates 311 and 312. In one embodiment, when the electronic device 100 is in the unfolded state, the first wing plate 311, the second wing plate 312, the first center bar 313 and the second center bar 314 may form the same plane as the first housing (e.g., the first housing 110 of FIG. 3a) and the second housing (e.g., the second housing 120 of FIG. 3a), so that the flexible display (e.g., the first display 130 of FIG. 1a) can be smoothly supported.

According to various embodiments, the hinge assembly HA, when the electronic device 100 is unfolded, may include a first support bar 311b disposed under the first wing plate 311 to support the rear surface of the first center bar 313 in a portion where at least one hinge device 320 and 320-1 is not disposed. In one embodiment, the hinge assembly HA, when the electronic device 100 is unfolded, may include a second support bar 312b disposed under the second wing plate 312 to support the rear surface of the second center bar 314 in a portion where at least one hinge device 320 and 320-1 is not disposed. In one embodiment, the first support bar 311b may be formed integrally with the first wing plate 311, or it may be formed separately and structurally coupled. In one embodiment, the second support bar 312b may be formed integrally with the second wing plate 312, or it may be formed separately and structurally coupled.

FIG. 20 is a plan view of the hinge assembly according to various embodiments of the present disclosure.

With reference to FIG. 20, the hinge assembly HA may include at least one hinge device (e.g., at least one hinge device 320 and 320-1 of FIG. 3b) coupled to a hinge housing (e.g., the hinge housing 141 of FIG. 3a), a pair of wing plates 311 and 312 coupled to at least one hinge device 320 and 320-1, and center bars 313-1, 313-2, 314-1 and 314-2 disposed between a pair of wing plates 311 and 312. In one embodiment, when the electronic device 100 is unfolded, a pair of wing plates 311 and 312, center bars 313-1, 313-2, 314-1, and 314-2 may form the same plane as the first housing (e.g., the first housing 110 of FIG. 3a) and the second housing (e.g., the second housing 120 of FIG. 3a) so that the flexible display (e.g., the first display 130 of FIGS. 1a) can be smoothly supported.

According to various embodiments, the center bars may include the first center bar 313-1 overlapped with at least the first hinge device (e.g., the first hinge device 320 of FIG. 3b) and rotatably disposed under the first wing plate 311, and the second center bar 313-2 overlapped with at least the second hinge device (e.g., the second hinge device 320-1 of FIG. 3b) at a distance from the first center bar 313-1 and rotatably disposed under the first wing plate 311. In one embodiment, the center bars may include the third center bar 314-1 overlapped with at least the first hinge device (e.g., the first hinge device 320 of FIG. 3b) and rotatably disposed under the second wing plate 311, and the fourth center bar 314-2 overlapped with at least the second hinge device (e.g., the second hinge device 320-1 of FIG. 3b) at a distance from the third center bar 314-1 and rotatably disposed under the second wing plate 312. In one embodiment, the portion in which the center bars 313-1, 313-2, 314-1, and 314-2 are not disposed and that does not overlap with at least one hinge device 320 and 320-1 may be disposed in close proximity to each other by an extension of the first wing plate 311 and the second wing plate 312. Therefore, the vulnerable areas where at least one hinge device 320 and 320-1 is not disposed, rigidity may be reinforced through an extended portion of the first and second wing plates 311 and 312 having a relatively wide width.

In accordance with the exemplary embodiments of the present disclosure, when the electronic device is changed from a third state between a fully unfolded first state and a fully folded second state, to a second state, the following advantages may be derived from the operating structure of the center bars 313 and 314 that are changed at different angles from the wing plates 311 and 312.

FIG. 21a is a partial cross-sectional view of the electronic device illustrating a rigidity reinforcement structure in a folded state according to various embodiments of the present disclosure.

With reference to FIG. 21a, the electronic device 100 may include a first wing plate 311 and a second wing plate 312 disposed to support the rear surface of the flexible display 130. In one embodiment, the electronic device 100 may, in a folding state, include a first center bar 313 disposed to be in contact with or in close proximity to the bending portion of the flexible display 130 at a different angle from the first wing plate 311, and a second center bar 314 disposed to be in contact with or in close proximity to the bending portion of the flexible display 130 at a different angle from the first wing plate 311. In one embodiment, through the modified operating structure of the first and second center bars 313 and 314, the electronic device 100 may include areas R1 and R2 provided by at least partially reduced rotation trajectories of the first wing plate 311 and the second wing plate 312. These areas R1 and R2 may help to provide a rigid reinforcement structure for strength-enhanced rotators 322, 323.

FIG. 21b is a partial cross-sectional view of the electronic device illustrating a hinge structure according to various embodiments of the present disclosure.

With reference to FIG. 21b, through the modified operating structure of the first and second center bars 313 and 314, the electronic device 100 may help to provide a reliable torque generating structure by increasing the radius d1 of the cam structure without increasing the volume of the electronic device 100 through at least partially reduced rotation trajectories of the first wing plate 311 and second wing plate 312.

FIG. 21c is a partial cross-sectional view of the electronic device illustrating a gear structure according to various embodiments of the present disclosure.

With reference to FIG. 21c, through the modified operating structure of the first and second center bars 313 and 314, the electronic device 100 may help to provide a reliable drive structure by increasing the radius d2 of the idle gears 328 without increasing the volume of the electronic device 100 through at least partially reduced rotation trajectories of the first wing plate 311 and second wing plate 312.

FIG. 21d is a partial cross-sectional view of an electronic device illustrating the relationship between the amount of protrusion of the hinge housing and the amount of deflection of the flexible display according to various embodiments of the present disclosure.

With reference to FIG. 21d, through the modified operating structure of the first and second center bars 313 and 314, the electronic device 100 may be designed to provide additional flexure d3 for the flexible display 130 without increasing the volume of the flexible display 130 through at least partially reduced rotation trajectories of the first wing plate 311 and the second wing plate 312, and to reduce the protrusion d4 of the hinge housing 141 even while securing a gap at the bottom of the flexible display 130.

FIGS. 21e and 21f are partial cross-sectional views of an electronic device illustrating the arrangement structure of wiring members in a folded and unfolded state according to various embodiments of the present disclosure.

With reference to FIGS. 21e and 21f, through the modified operating structure of the first and second center bars 313 and 314, the electronic device 100 may reduce efficiently the length of the wiring member FW (e.g., flexible printed circuit board (FPCB)) electrically connecting the first housing (e.g., the first housing 110 of FIG. 3a) and the second housing (e.g., the second housing 120 of FIG. 3a) through at least partially reduced rotation trajectories of the first wing plate 311 and the second wing plate 312. In addition, when the wiring member FW is disposed in a limited space, the curvature of the wiring member FW may be relatively large, so it may be advantageous to secure the durability of the wiring member FW according to the frequent folding operation of the electronic device 100 and to secure the placement space.

FIGS. 22a and 22b are diagrams illustrating a support structure for wing plates by hinge arms according to various embodiments of the present disclosure.

With reference to FIGS. 22a and 22b, the electronic device 100 may include first wing plates 311 and second wing plates 312 disposed to support the rear surface of the flexible display 130. In one embodiment, the electronic device 100 may, in the folded state, include a first center bar 313 disposed to be in contact with or in close proximity to the bending portion of the flexible display 130 at a different angle from the first wing plate 311, and a second center bar 314 disposed to be in contact with or in close proximity to the bending portion of the flexible display 130 at a different angle from the first wing plate 311. In one embodiment, the first and second center bars 313 and 314 may be constituted to operate at the same rotation angle as the first and second wing plates 311 and 312up to the third state between the fully unfolded first state and the fully folded second state, and may rotate at different angles from the first wing plate 311 and the second wing plate 312 from the third state to the second state.

According to various embodiments, the first and second center bars 313 and 314 may, in the unfolded state, be disposed to be supported by the first support 3246 of the first hinge arm 324 and the second support 3256 of the second hinge arm 325. In one embodiment, the first hinge arm 324 and second hinge arm 325 may be constituted to rotate slower than the first rotator 322 and the second rotator 323, which may cause a relative delay in the rotation speed of the first and second center bars 313 and 314. In such a case, the first and second hinge arms 324 and 325may be constituted to rotate later than the first and second rotators 322 and 323 by changing the coupling structure with the first and second guide grooves (e.g., the first and second guide grooves of 3262 and 3272of FIG. 3) of the first and second links (e.g., the first and second links 326 and 327 of FIG. 3).

FIGS. 23a and 23b are diagrams illustrating the operating structure between the hinge arm and links according to various embodiments of the present disclosure.

With reference to FIG. 23a, the electronic device 100 may include a first wing plate 311 disposed to support the first rotator 322 rotating with respect to the first rotation axis X1 on the rotator bracket 321 and a second wing plate 312 disposed to support the second rotator 323 rotating with respect to the second rotation axis X2 on the rotator bracket 321. In one embodiment, the electronic device 100 may include a first link 326 a portion of which is rotated with respect to the third rotation axis X3 on the first rotator 322 and another portion of which is fixed to the first housing (e.g., the first housing 110 of FIG. 3a), and a second link 327 a portion of which is rotated with respect to the fourth rotation axis X4 on the second rotator 323 and another portion of which is fixed to the second housing (e.g., the second housing 120 of FIG. 3a). In one embodiment, the electronic device 100 may include a first hinge arm 324 one end of which is rotatably disposed in the rotator bracket 321 with respect to the fifth rotation axis X5 and the other end of which is movably coupled with respect to the first link 326, and a second hinge arm 325 one end of which is rotatably disposed on the rotator bracket 321 with respect to the sixth rotation axis X6 and the other end of which is movably coupled with respect to the second link 327. In one embodiment, the first guide body 3241 of the first hinge arm 324 may be movably inserted into the first guide groove 3262 formed on the first link 326. In one embodiment, the second guide body 3251 of the second hinge arm 325 may be movably inserted into the second guide groove 3272 formed on the second link 327.In one embodiment, electronic device 100 may include a first center bar 313 rotatably disposed with respect to the seventh rotation axis X7 under the first wing plate 311 and a second center bar 314 rotatably disposed with respect to the eighth rotation axis X8 under the second wing plate 312. In one embodiment, the first center bar 313 and the second center bar 314 may, when the electronic device 100 is in an unfolded state, form the same plane as the first wing plate 311 and the second wing plate 312 by being supported by at least portion of the first rotator 322 and the second rotator 323. In one embodiment, the first center bar 313 and the second center bar 314 are rotated with the same rotation angle as the first and second wing plates 311 and 312 from the first state to the third state, and from the third state to the second state they can be rotated or slightly moved at a different angle from the first and second wing plates 311 and 312.

According to various embodiments, the rotation angle of the first and second hinges 324 and 325 may be adjusted by changing the slide coupling structure with the first and second links 326 and 327. For example, when the coupling shape of the first guide groove 3262 and the first guide body 3241 is formed along the first line L3 curving upward so that it rotates with respect to the ninth rotation axis X9, the first hinge arm 324 may induce rotation at an angle less than 90 degrees with respect to the first rotator 322 rotating 90 degrees. Similarly, when the coupling shape of the second guide groove 3272 and the second guide body 3251 is formed along the second line L4 curving upward so that it rotates with respect to the tenth rotation axis X10, the second hinge arm 325 may induce rotation at an angle less than 90 degrees with respect to the second rotator 323 rotating 90 degrees. For example, the angular velocity control structure through the combination of these first and second hinges 324 and 325 and these first and second links 326 and 327 may be substituted with the coupling structure between the first and second hinges 324 and 325 and the first and second links 326 and 327 of the foregoing FIGS. 4a to 5.

In describing the electronic device of FIG. 23b, identical components are given the same code, and the details may be omitted.

With reference to FIG. 23b, the rotation angle of the first and second hinges arm 324 and 325 may be adjusted by changing the slide coupling structure with the first and second links 326 and 327. For example, when the coupling shape of the first guide groove 3262 and the first guide body 3241 is formed along a third line L5 curving downward so that it rotates with respect to the eleventh rotation axis X11, the first hinge arm 324 may induce a rotation at an angle greater than 90 degrees with respect to the first rotator 322 rotating 90 degrees. Similarly, when the coupling shape of the second guide groove 3272 and the second guide body 3251 is formed along a fourth line L6 curving downward so that it rotates with respect to the twelfth rotation axis X12, the second hinge arm 325 may induce a rotation at an angle greater than 90 degrees with respect to the second rotator 323 rotating 90 degrees. For example, the angular velocity control structure through the combination of these first and second hinge arms 324 and 325 and the first and second links 326 and 327 may be substituted with the coupling structure between the first and second hinges 324 and 325 and the first and second links 326 and 327 of the foregoing FIGS. 4a to 5.

FIG.24a is an exploded perspective view of a hinge device according to various embodiments of the present disclosure. FIG. 24b is a coupling perspective view of the hinge device of FIG. 24a according to various embodiments of the present disclosure.

The hinge device 420 of FIGS. 24a and 24b may be substituted with at least one hinge device 320 and 320-1 of FIG. 3a and 3b.

With reference to FIGS. 24a and 24b, the hinge device 420 may include a rotator bracket 421 fixed through a screw-like fastening member to a hinge housing (e.g., the hinge housing 141 of FIG. 3a), a first rotator 422 rotatably disposed on the rotator bracket 421 with respect to the first rotation axis X1, a second rotator 423 rotatably disposed on the rotator bracket 421 with respect to the second rotation axis X2, a first fixed bracket 426 rotatably coupled to the first rotator 422 with respect to the third rotation axis X3, a second fixed bracket 427 rotatably coupled to the second rotator 423 with respect to the fourth rotation axis X4, a first hinge arm 424 one end of which is rotatably disposed on the rotator bracket 421 with respect to the fifth rotation axis X5, a second hinge arm 425 one end of which is rotatably disposed on the rotator bracket 421 with respect to the sixth rotation axis X6. In one embodiment, the first fixed bracket 426 may be fixed to the first housing (e.g., the first housing 110 of FIG. 3a). In one embodiment, the second fixed bracket 427 may be fixed to the second housing (e.g., the second housing 120 of FIG. 3a). In one embodiment, the first center bar 313 disposed between the first wing plate 311 and the second wing plate 312 may be rotatably disposed with respect to the seventh rotation axis (e.g., the seventh rotation axis X7 of FIG. 23a) located under the first wing plate 311, and the second center bar 314 disposed between the first center bar 313 and the second wing plate 312 may be rotatably disposed with respect to the eighth rotation axis (e.g., the eighth rotation axis X8 of FIG. 23a) located under the second wing plate 312.In one embodiment, the coupling structure and support structure for the first center bar 313 and the second center bar 314 may be substantially identical to the coupling structure and support structure of the first and second center bars 313 and 314 shown in FIGS. 8a to 23b above. In one embodiment, the hinge device 420 may include a first link 431 that is fixed to the first housing (e.g., the first housing 110 of FIG. 3a) and guides the other end of the first hinge arm 424 movably, and a second link 432 that is fixed to the second housing (e.g., the second housing 120 of FIG. 3a) and guides the other end of the second hinge arm 425 movably.

According to various embodiments, the first rotator 422 may include the curved first guide slit 4221 formed at one end. In one embodiment, the second rotator 423 may include a curved second guide slit 2231 formed at one end. In one embodiment, the first rotator 222 may include a curved third guide slit 4222 formed at the other end. In one embodiment, the second rotator 423 may include a curved fourth guide slit 4232 formed at the other end. In one embodiment, the first rotator 422 may be rotatably coupled with respect to the first rotation axis X1 by the curved first guide rib 4211 formed on the rotator bracket 421 being coupled to the first guide slit 4221. In one embodiment, the second rotator 423 may be rotatably coupled with respect to the second rotation axis X2 by the curved second guide rib 4212 formed on the rotator bracket 421 being coupled to the second guide slit 4231.

According to various embodiments, the first fixed bracket 426 may be rotatably coupled with respect to the third rotation axis X3 by the curved third guide rib 4261 formed at least in part being coupled to the third guide slit 4222. In one embodiment, the second fixed bracket 427 may be rotatably coupled with respect to the fourth rotation axis X4 by the curved fourth guide rib 4271 formed at least in part being coupled to the fourth guide slit 4232.

According to various embodiments, the first hinge arm 424 may include a first guide body 4241 movably coupled to the first guide groove 4311 formed at the first link 431 and a first cam structure 4242 on one side of the first guide body 4241. According to one embodiment, the second hinge arm 425 may include a second guide body 4251 movably coupled to a second guide groove 4321 formed at the second link 432 and a second cam structure 4252 formed on one side of the second guide body 4251. In one embodiment, the first hinge arm 424 may induce the first link 431 to move rotatably with respect to the ninth rotation axis X9 through the curved guide structure of the first guide body 4241 and the first guide groove 4311.In some embodiments, the first hinge arm 424 may be slidingly coupled in the first link 431 through a linear guide structure of the first guide body 4241 and the first guide groove 4311. In one embodiment, the second hinge arm 425 may induce the second link 432 to move rotatably with respect to the tenth rotation axis X10 through the curved guide structure of the second guide body 4251 and the second guide groove 4321. In some embodiments, the second hinge arm 425 may be slidingly coupled in the second link 432 through a linear guide structure of the second guide body 4251 and the second guide groove 4321. In one embodiment, the first link 431 may be disposed to overlap at least partially with the first fixed bracket 426. In one embodiment, the second link 432 may be disposed to overlap at least partially with the second fixed bracket 427.

According to various embodiments, the hinge device 420 may include a first shaft HS3 rotatably disposed on the rotator bracket 421 with respect to the fifth rotation axis X5 through the gear bracket 4215 and including the first gear 4281, and a second shaft HS4 rotatably disposed on the rotator bracket 421 with respect to the sixth rotation axis X6 through the gear bracket 4215 and including the second gear 4282. In one embodiment, the hinge device 420 may include a pair of idle gears 428 that are paired with first gear 4281 and second gear 4282 respectively. Therefore, when the first fixed bracket 426 and the first link 431 are unfolded or folded together with the first housing (e.g., the first housing 110 of FIG. 3a), the first and second gears 4281 and 4282 and the gear-coupled pair of idle gears 428 may be induced to unfold or fold together at the same angle with the second housing (e.g., the second housing 120 of FIG. 3a).

According to various embodiments, the hinge device 420 may include the cam body 429 comprising a cam-coupled third cam structure 4291 with a first cam structure 4242 and a cam-coupled fourth cam structure 4292 with a second cam structure 4252, and a torque generating structure comprising a pair of springs CS that pressurizes the cam body 429 in the first hinge arm 424 and second hinge arm 425 directions (e.g., the -x axis direction)through the shaft bracket 4216 and a pair of washer members 4217 fixed to the ends of the first and second shafts HS3 and HS4. In one embodiment, the first hinge arm 424 may be rotated with respect to the fifth rotation axis X5. In one embodiment, the first cam structure 4242 of the first hinge arm 424, the gear bracket 4215, the third cam structure 4291 of the cam body 429, the spring CS and the shaft bracket 4216 may be aligned through the first shaft HS3 penetrating them. In one embodiment, the second hinge arm 425 may be rotated with respect to the sixth rotation axis X6. In one embodiment, the second cam structure 4252 of the second hinge arm 425, the gear bracket 4215, the fourth cam structure 4292 of the cam body 429, the spring CS and the shaft bracket 4216 may be aligned through the second shaft HS4 penetrating them. In one embodiment, the first shaft HS1 and the second shaft HS2 may be constrained not to be escaped by the E-rig structure 4213. In one embodiment, cam body 429 may be moved in a direction parallel to the fifth rotation axis X5 and sixth rotation axis X6, and the first cam structure 4242 of the first hinge arm 424 is rotatably disposed with respect to the fifth rotation axis X5, and the second cam structure 4252 of the second hinge arm 425 may be rotatably disposed with respect to the sixth rotation axis X6.In one embodiment, when the first cam structure 4242 is rotated with respect to the fifth rotation axis X5 by the first hinge arm 424, torque may be generated as the cam-coupled third cam structure 4291 is retracted backwards with the support of the spring CS. Similarly, when the second cam structure 4252 is rotated with respect to the sixth rotation axis X6 by the second hinge arm 425, the fourth cam structure 4292 coupled with the support of the spring CS may be retracted backwards and torque may be generated. Therefore, torque may be generated as the cam body 429 is retracted backwards by the retraction of the third cam structure 4291 and the fourth cam structure 4292.In one embodiment, the size of the torque may be determined by the shape of the first cam structure 4242 and the third cam structure 4291 coupled therewith and the shape of the second cam structure 4252 and the fourth cam structure 4292 coupled therewith, and by the determined torque the first housing (e.g., the first housing 110 of FIG. 3a) and the second housing (e.g., the second housing 120 of FIG. 3a) may be configured to be pressurized in the direction of unfolding or folding above a specified inflection angle, or may be configured to stop at a specified angle.

FIG. 25 is an exploded perspective view of a hinge device according to various embodiments of the present disclosure. FIG. 26a is a cross-sectional view of a hinge device taken along line 26a-26a of FIG. 25 according to various embodiments of the present disclosure. FIG. 26b is a cross-sectional view of the hinge device taken along line 26b-26b of FIG. 25 according to various embodiments of the present disclosure.

The hinge device 520 of FIGS. 25 to 26b may be substituted with at least one hinge device320 and 320-1 of FIG. 3a and 3b.

With reference to FIG. 25 to 26b, the hinge device 520 may include a rotator bracket 521, a first rotator 522 rotatably coupled to one side of the rotator bracket 521, a second rotator 523 rotatably coupled to the other side of the rotator bracket 521, a first wing plate 311 supported by and rotatably coupled to the first rotator 522, and a second wing plate 312 supported by and rotatably coupled to the second rotator 523. In one embodiment, the hinge device 520 may include a first center bar 313 rotatably coupled to the first wing plate 311 between the first wing plate 311 and the second wing plate 312, and a second center bar 314 rotatably coupled to the second wing plate 312 between the first center bar 313 and the second wing plate 312. In one embodiment, the hinge device 520 may include a first hinge arm 524 rotatably coupled with respect to the first shaft HS5 coupled to the rotator bracket 521 and a second hinge arm 525 rotatably coupled with respect to the second shaft HS6 coupled to the rotator bracket 521. In one embodiment, the first rotator 522 may be coupled to the first housing (e.g., the first housing 110 of 3a) of the electronic device (e.g., the electronic device 100 of FIG. 3a). In one embodiment, the second rotator 523 may be coupled to the second housing (e.g., the second housing 120 of FIG. 3a) of the electronic device (e.g., the electronic device 100 of FIG. 3a).

According to various embodiments, the first wing plate 311 may be coupled so that the first guide structure 3115 protruding on the rear surface is rotatably guided to the first rotator 522. In one embodiment, the second wing plate 312 may be coupled so that the second guide structure 3125 protruding on the rear surface is rotatably guided to the second rotator 523. In one embodiment, the first wing plate 311 may include a first guide rail 3116 comprising a first guide slit 3116a through which the first guide pin 5211 formed on the rotator bracket 521 may be guided. In one embodiment, the second wing plate 312 may include a second guide rail 3126 comprising a second guide slit 3126a in which the second guide pin 5212 formed on the rotator bracket 521 may be guided. This guide structure may assist in the stable rotational motion of the wing plates 311 and 312. In one embodiment, the first guide slit 3116a and the second guide slit 3126a may be formed as a curve. In one embodiment, the first guide structure 3115 and the first guide rail 3116 may be integrated with the first wing plate 311. In one embodiment, the second guide structure 3125 and the second guide rail 3126 may be integrated with the second wing plate 312.

According to various embodiments, the first hinge arm 524 may include a first slit 5241 through which the first hinge pin 5242 coupled to the first rotator 522 may be guided. In one embodiment, the second hinge arm 525 may include a second slit 5251 through which the second hinge pin 5252 coupled to the second rotator 523 may be guided. In one embodiment, the first slit 5241 and the second slit 5251 may be formed as a curve.

According to various embodiments, when the first and second links are folded together with the first housing 110 and the second housing 120, the first wing plate 311 and the second wing plate 312 may be rotated together. In this case, the links may be rotated with respect to the rotator bracket 521 via rotators 522 and 523 and, through the bidirectional rotational coupling structure of the rotators 522 and 523, may be additionally rotated than the housings 110 and 120 when folded, thereby helping to provide space to support and accommodate the bended area of the flexible display 130. In this case, the hinge arms 524 and 525 may be moved pivotally and rotated through guide slits 5241 and 5251, in response to additional rotation of the rotators 522 and 523.

The hinge device 520 according to the exemplary embodiment of the present disclosure may perform substantially the identical operation as the hinge device 320 of FIG. 4a, even if the links (e.g., the links 326 and 327 of FIG. 4a) are excluded, by coupling rotatably the wing plates 311 and 312 to the rotators 522 and 523 and fixing the rotators 522 and 523 directly to the housings 110 and 120, and may help to slim down the electronic device by reducing the number of components.

Although not shown or not described, the gear coupling structure and torque generating structure included in the hinge device 520 may be similar or substantially identical to the gear coupling structure and torque generating structure configured on the hinge device 320 of FIG. 4a.

FIG. 27a is a perspective view of a hinge device according to various embodiments of the present disclosure. FIG. 27b is a cross-sectional perspective view of the hinge device taken along line 27b-27b of FIG. 27a according to various embodiments of the present disclosure.

The hinge devices 620 of FIG. 27a and 27b may be substituted with at least one hinge device 320 and 320-1 of FIG. 3a and 3b.

With reference to FIG. 27a and 27b, the hinge device 620 may include a rotator bracket 621, a first rotator 622 rotatably coupled to one side of the rotator bracket 621, a second rotator 623 rotatably coupled to the other side of the rotator bracket 621, a first link 626 rotatably coupled to the first rotator 622 and fixed to the first housing (e.g., the first housing 110 of FIG. 3a), a second link 627 rotatably coupled to the send rotator 623 and fixed to the second housing, a first hinge arm 624 rotatably coupled to the rotator bracket 621, and a second hinge arm 625 rotatably coupled to the rotator bracket 621. In one embodiment, the hinge device 620 may include a first wing plate 311 fixed to the first link 626, and a second wing plate 312 fixed to the second link 627.In one embodiment, the hinge device 620 may include a first center bar 313 rotatably coupled to the first wing plate 311 between the first wing plate 311 and the second wing plate 312, and a second center bar 314 rotatably coupled to the second wing plate 312 between the first center bar 313 and the second wing plate 312. In one embodiment, one end of the first rotator 622 may be rotatably coupled to the rotator bracket 621, and the other end of the first rotator 622 may be rotatably coupled to the first link 626. In one embodiment, one end of the second rotator 623 may be rotatably coupled to the rotator bracket 621, and the other end of the second rotator 623 may be rotatably coupled to the second link 627. In one embodiment, the first hinge arm 624 may be coupled in such a way that the first hinge pin 6241 coupled to the first hinge arm 624 is guided to the first guide slit 3117a of the first guide structure 3117 formed protruding on the rear surface of the first wing plate 311.In one embodiment, the second hinge arm 625 may be coupled in such a way that the second hinge pin 6251 coupled to the second hinge arm 625 is guided to the second guide slit 3127a of the second guide structure 3127 formed protruding on the rear surface of the second wing plate 312. In one embodiment, the first guide slit 3117a and the second guide slit 3127a may be curved.

According to various embodiments, when the first rotator 622 and the second rotator 623 are folded together with the first housing 110 and the second housing 120, the first wing plate 311 and the second wing plate 312 may be rotated together. In this case, the wing plates 311 and 312 may be rotated additionally through guide structures 3117 and 3127 than the housings 110 and 120, thereby helping to provide space to support and accommodate the bended area of the flexible display 130. In this case, the hinge arms 624 and 625 may be moved and rotated pivotally through guide slits 3117a and 3127a, in response to additional rotation of the rotators 622 and 623.

The hinge device 620 according to the exemplary embodiment of the present disclosure may help to ensure a stable operation by including the links 626 and 627 in which the hinge arms 624 and 625 are pivotally coupled movably and rotatably at the same time of rotatably coupling with the rotators 622 and 623.

Although not shown or not described, the gear engagement structure and torque generating structure included in the hinge device 620 may be similar or substantially identical to the gear coupling structure and torque generation structure configured on the hinge device 320 of FIG. 4a.

According to various embodiments, an electronic device (e.g., the electronic device 100 of FIG. 3a) includes a first housing (e.g., the first housing 110 of FIG. 3a); a second housing (e.g., the second housing 120 of FIG. 3a); and at least one hinge device (e.g., the hinge device 320 of FIG. 4a) that connects the first housing and the second housing to be foldable from a first state to a second state, at least one hinge device that includes a rotator bracket (e.g., the rotator bracket 321 of FIG. 4a), a first rotator (e.g., the first rotator 322 of FIG. 4a) rotatably coupled to the rotator bracket with respect to a first rotation axis(e.g., the first rotation axis X1 of FIG. 4a), a second rotator (e.g., the second rotator 323 of FIG. 4a) rotatably coupled to the rotator bracket with respect to a second rotation axis (e.g., the second rotation axis X2 of FIG. 4a), a first link (e.g., the first link 326 of FIG. 4a) rotatably coupled to the first rotator with respect to a third rotation axis (e.g., the third rotation axis X3 of FIG. 4a), a second link (e.g., the second link 327 of FIG. 4a) rotatably coupled to the second rotator with respect to a fourth rotation axis (e.g., the fourth rotation axis X4 of FIG. 4a), a first hinge arm (e.g., the first hinge arm 324 of FIG. 4a) rotatably disposed on the rotator bracket with respect to a fifth rotation axis (e.g., the fifth rotation axis X5), and a second hinge arm (e.g., the second hinge arm 325 of FIG. 4a) rotatably disposed on the rotator bracket with respect to a sixth rotation axis (e.g., the sixth rotation axis X6); a first wing plate(e.g., the first wing plate 311 of FIG. 3a) fixed to the first rotator; a second wing plate (e.g., the second wing plate 312 of FIG. 3a) fixed to the second rotator; a first center bar (e.g., the first center bar 313 of FIG. 3a) rotatably disposed with respect to the first wing plate; a second center bar (e.g., the second center bar 314 of FIG. 3a) rotatably disposed with respect to the second wing plate; and a flexible display (e.g., the flexible display 130 of FIG. 1a) disposed to be supported by the first and second housings, the first and second wing plates, and the first and second center bars in the first state, wherein the first center bar and the second center bar are operated to correspond to the first wing plate and the second wing plate, respectively, up to a third state which is between the first state and the second state, and are operated respectively to have a different rotation angle from the first wing plate and the second wing plate from the third state to the second state.

According to various embodiments, the first center bar may be rotatably coupled to the first rotator with respect to the seventh rotation axis (e.g., the seventh rotation axis X7 of FIG. 9) located under the first wing plate, and the second center bar may be rotatably coupled to the second rotator with respect to the eighth rotation axis (e.g., the eighth rotation axis X8 of FIG. 9) located under the second wing plate.

According to various embodiments, the first center bar and the second center bar may be disposed to be pressurized in a direction opposite to the flexible display through a torsion spring (e.g., the torsion spring TS1 of FIG. 9).

According to various embodiments, the first center bar may be rotatably coupled to the rear surface of the first wing plate with respect to the seventh rotation axis, and the second center bar may be rotatably coupled to the rear surface of the second wing plate with respect to the eighth rotation axis.

According to various embodiments, the first center bar may be rotatably coupled to at least portion of the first hinge arm, with respect to the seventh rotation axis located under the first wing plate, and the second center bar may be rotatably coupled to at least portion of the second hinge arm, with respect to the eighth rotation axis located under the second wing plate.

According to various embodiments, the first center bar may, in the first state, be disposed to be supported by the first rotator, and the second center bar may, in the first state, be disposed to be supported by the second rotator.

According to various embodiments, the first center bar may, in the first state, be disposed to be supported through at least portion of the first hinged arm (e.g., the first support 3246 of the 14c), and the second center bar may, in the first state, be disposed to be supported by at least portion of the second hinge arm (e.g., the second support 3256 of the 14c).

According to various embodiments, the first center bar may, in the first state, be disposed to be supported by at least portion of the first support piece (e.g., the first support piece 3111 of FIG. 14d) extended from at least portion of the first wing plate, and the second center bar may, in the first state, be disposed to be supported by at least portion of the second support piece (e.g., the second support piece 3121 of FIG. 14d) extended from at least portion of the second wing plate.

According to various embodiments, the first center bar and the second center bar may be disposed to be supported by at least portion of the rotator bracket, between the third state and the second state.

According to various embodiments, the first center bar and the second center bar may be disposed to be supported, between the third state and the second state, by at least portion of the first hinge arm and at least portion of the second hinge arm.

According to various embodiments, the first center bar and the second center bar may pass through the outer peripheral surface of the bending portion of the flexible display (e.g., the flexible display 130 of FIG. 9) in the second state and may be disposed under the normal line (e.g., the normal lineL2 of FIG. 9) to the tangent line (e.g., the tangent line L1 of FIG. 9) perpendicular to the display surface (e.g., the display surface DS of FIG. 9)of the first state.

According to various embodiments, a first gear structure (e.g., the first gear structure 3242 of FIG. 4a)formed on the first hinge arm and rotated with respect to the fifth rotation axis and a second gear structure (e.g., the second gear structure 3252 of FIG. 4a)formed on the second hinge arm and rotated with respect to the sixth rotation axis may be included and the first gear structure and the second gear structure may be disposed to be geared with a pair of idle gears (e.g., the idle gear 328 of FIG. 4a) disposed on the rotator bracket.

According to various embodiments, a first cam structure(e.g., the first cam structure 3243 of FIG. 4a) formed on the first hinge arm and rotated with respect to the fifth rotation axis, a second cam structure (e.g., the second cam structure 3253 of FIG. 4a) formed on the second hinge arm and rotated with respect to the sixth rotation axis, as a cam body (e.g., the cam body 329 of FIG. 4a) disposed to retreat backwards in accordance with the rotation of the first cam structure and the second cam structure, a cam body comprising the third cam structure (e.g., the third cam structure of FIG. 4a) cam-coupled to the first cam structure and the fourth cam structure (e.g., the fourth cam structure of FIG. 4a) cam-coupled to the second cam structure, and at least one spring (e.g., the spring CS of FIG. 4a) pressurizing the cam body in the first and second cam structure direction, may be included, and, when the first hinge arm and the second hinge arm are rotated, through the pressure that the spring pressurizes the cam body, a torque may be generated between the first cam structure and third cam structure, and between the second cam structure and the fourth cam structure.

According to various embodiments, the first hinge arm may include a first guide body (e.g., the first guide body 3241 of FIG. 4a) movably inserted into the first guide groove (e.g., the first guide groove 3262 of FIG. 4a) formed on the first link, and the second hinge arm may include a second guide body (e.g., the second guide body 3251 of FIG. 4a) movably inserted into the second guide groove (e.g., the second slide groove 3272 of FIG. 4a) formed on the second link.

According to various embodiments, the rotational angular velocity of the first hinge arm with respect to the first rotator may be determined by the coupling shape of the first guide body and the first guide groove, and the rotational angular velocity of the second hinge arm with respect to the second rotator may be determined by the coupling shape of the second guide body and the second guide groove.

According to various embodiments, the first center bar may be disposed to be supported by at least portion of the first hinge arm, in the first state, the second center bar may be disposed to be supported by at least portion of the second hinge arm, in the first state, and the first center bar and the second center bar may be rotated at a rotational angular velocity equal to or different from the wing plate in accordance with the determined angular velocity of rotation.

According to various embodiments, an electronic device (e.g., the electronic device 100 of FIG. 3a) includes a first housing (e.g., the first housing 110 of FIG. 3a); a second housing (e.g., the second housing 120 of FIG. 3a); and at least one hinge device (e.g., the hinge device 320 of FIG. 4a) that connects the first housing and the second housing to be foldable from a first state to a second state, at least one hinge device that includes a rotator bracket (e.g., the rotator bracket 321 of FIG. 4a), a first rotator (e.g., the first rotator 322 of FIG. 4a) rotatably coupled to the rotator bracket with respect to a first rotation axis (e.g., the first rotation axis X1 of FIG. 4a), a second rotator (e.g., the second rotator 323 of FIG. 4a) rotatably coupled to the rotator bracket with respect to a second rotation axis (e.g., the second rotation axis X2 of FIG. 4a), a first wing plate (e.g., the first wing plate 311 of FIG. 3a) rotatably coupled to the first rotator with respect to a third rotation axis (e.g., the third rotation axis X3 of FIG. 4a), a second wing plate (e.g., the second wing plate 312 of FIG. 3a) rotatably coupled to the second rotator with respect to a fourth rotation axis (e.g., the fourth rotation axis X4 of FIG. 4a), a first hinge arm (e.g., the first hinge arm 324 of FIG. 4a) rotatably disposed on the rotator bracket with respect to a fifth rotation axis (e.g., the fifth rotation axis X5), and a second hinge arm (e.g., the second hinge arm 325 of FIG. 4a) rotatably disposed on the rotator bracket with respect to a sixth rotation axis (e.g., the sixth rotation axis X6); a first wing plate (e.g., the first wing plate 311 of FIG. 3a) fixed to the first rotator; a second wing plate (e.g., the second wing plate 312 of FIG. 3a) fixed to the second rotator; a first center bar (e.g., the first center bar 313 of FIG. 3a) rotatably disposed with respect to the first wing plate; a second center bar (e.g., the second center bar 314 of FIG. 3a) rotatably disposed with respect to the second wing plate; and a flexible display (e.g., the flexible display 130 of FIG. 1a) disposed to be supported by the first and second housings, the first and second wing plates, and the first and second center bars in the first state, wherein the first center bar and the second center bar are operated respectively to have a different rotation angle from the first wing plate and the second wing plate from the third state, which is between the first state and the second state, to the second state.

According to various embodiments, the first center bar is rotatably coupled to the first rotator with respect to the seventh rotation shaft located under the first wing plate, and the second center bar may be rotatably coupled to the second rotator with respect to the eighth rotating shaft located under the second wing plate.

According to various embodiments, the first center bar and the second center bar may be disposed under pressure through a torsion spring in a direction facing the opposite direction to the flexible display.

According to various embodiments, the first center bar and the second center bar may pass through the outer peripheral surface of the bending portion of the flexible display 130 (e.g., the flexible display 130 of FIG. 9) in the second state and may be disposed under the normal line (e.g., the normal line L2 of FIG. 9) to the tangent line (e.g., the tangent line L1 of FIG. 9) perpendicular to the display surface (e.g., the display surface DS of FIG. 9) of the first state.

In addition, the embodiments of the present document disclosed in the present specification and drawings are merely presented as specific examples to easily explain the technical contents according to the embodiments disclosed in the present document and to facilitate the understanding of the embodiments disclosed in the present document, but are not intended to limit the scope of the embodiments disclosed in the present document.

## Claims

1. An electronic device (100) comprising:
a first housing (110);
a second housing (120);
at least one hinge device, as at least one hinge device (320), that connects the first housing (110) and the second housing (120) to be foldable from a first state to a second state, that comprises:
a rotator bracket (321),
a first rotator (322) rotatably coupled to the rotator bracket (321) with respect to a first rotation axis (X1),
a second rotator (323) rotatably coupled to the rotator bracket (321) with respect to a second rotation axis (X2),
a first link (326) rotatably coupled to the first rotator (322) with respect to a third rotation axis (X3),
a second link (327) rotatably coupled to the second rotator (323) with respect to a fourth rotation axis (X4),
a first hinge arm (324) rotatably disposed on the rotator bracket (321) with respect to a fifth rotation axis (X5), and
a second hinge arm (325) rotatably disposed on the rotator bracket (321) with respect to a sixth rotation axis (X6);
a first wing plate (311) fixed to the first rotator (322);
a second wing plate (312) fixed to the second rotator (323);
a first center bar (313) rotatably disposed with respect to the first wing plate (311);
a second center bar (314) rotatably disposed with respect to the second wing plate (312); and
a flexible display (130) disposed to be supported by the first and second housings (110, 120), the first and second wing plates (311, 312), and the first and second center bars (313, 314) in the first state, wherein
the first center bar (313) and the second center bar (314) are configured to be operated to correspond to the first wing plate (311) and the second wing plate (312), respectively, up to a third state which is between the first state and the second state, and are configured to be operated to have a different rotation angle from the first wing plate (311) and the second wing plate (312) from the third state to the second state.

2. The electronic device (100) of the claim 1, wherein
the first center bar (313) is rotatably coupled to the first rotator (322) with respect to a seventh rotation axis (X7) located under the first wing plate (311), and
the second center bar is rotatably coupled to the second rotator (323) with respect to an eighth rotation axis (X8) located under the second wing plate (312).

3. The electronic device (100) of claim 1 or claim 2, wherein
the first center bar (313) and the second center bar are disposed to be pressurized in a direction facing the opposite direction to the flexible display through a torsion spring (TS1).

4. The electronic device (100) of any one of claims 1 to 3, wherein
the first center bar (313) is rotatably coupled to the rear surface of the first wing plate (311) with respect to the seventh rotation axis (X7), and
the second center bar is rotatably coupled to the rear surface of the second wing plate (312) with respect to the eighth rotation axis (X8).

5. The electronic device (100) of any one of claims 1 to 4, wherein
the first center bar (313) is rotatably coupled to at least a portion of the first hinge arm (324), with respect to the seventh rotation axis (X7) located under the first wing plate (311), and
the second center bar is rotatably coupled to at least a portion of the second hinge arm (325), with respect to the eighth rotation axis (X8) located under the second wing plate (312).

6. The electronic device (100) of any one of claims 1 to 5, wherein
the first center bar (313) is disposed to be supported by the first rotator (322) in the first state, and
the second center bar is disposed to be supported by the second rotator (323) in the first state.

7. The electronic device (100) of any one of claims 1 to 6, wherein
the first center bar (313) is disposed to be supported by at least a portion (3246) of the first hinge arm (324) in the first state, and
the second center bar is to be supported by at least a portion (3256) of the second hinge arm (325) in the first state.

8. The electronic device of any one of claims 1 to 7, wherein
the first center bar (313) is disposed to be supported by at least a portion of the first support piece (3111) extending from at least a portion of the first wing plate (311) in the first state, and
the second center bar is disposed to be supported by at least a portion of the second support piece (3121) extending from at least a portion of the second wing plate (312) in the first state.

9. The electronic device (100) of any one of claims 1 to 8, wherein
the first center bar (313) and the second center bar are disposed to be supported by at least a portion of the rotator bracket (321), between the third state and the second state.

10. The electronic device (100) of any one of claims 1 to 9, wherein
the first center bar (313) and the second center bar (324) are disposed to be supported by at least a portion of the first hinge arm (324) and at least a portion of the second hinge arm (325), between the third state and the second state.

11. The electronic device (100) of any one of claims 1 to 10, wherein
the first center bar (313) and the second center bar pass through the outer peripheral surface of the bending portion of the flexible display (130) in the second state and are disposed under the normal line (L2) to a tangent line (L1) perpendicular to the surface (DS) of the display in the first state.

12. The electronic device of any one of claims 1 to 11, comprising:
the first gear structure (3242) formed on the first hinge arm and rotated with respect to the fifth rotation axis; and
the second gear structure (3252) formed on the second hinge arm and rotated with respect to the sixth rotation axis, wherein
the first gear structure and the second gear structure are disposed to be gear-coupled to a pair of idle gears (328) disposed on the rotator bracket (321).

13. The electronic device (100) of any one of claims 1 to 12, comprising:
a first cam structure (3243) formed on the first hinge arm and rotated with respect to the fifth rotation axis;
a second cam structure (3253) formed on the second hinge arm and rotated with respect to the sixth rotation axis;
a cam body, as a cam body (329) disposed to be retracted backwards in accordance with the rotation of the first cam structure and the second cam structure that comprises
a third cam structure (3291) that is cam-coupled to the first cam structure, and
a fourth cam structure (3292) that is cam-coupled to the second cam structure; and
at least one spring (CS) pressurizing the cam body in the direction of the first and second cam structures, wherein,
when the first hinge arm and the second hinge arm are rotated, a torque is generated between the first cam structure and the third cam structure and between the second cam structure and the fourth cam structure, through the pressurization force by which the spring pressurizes the cam body.

14. The electronic device (100) of any one of claims 1 to 13, wherein
the first hinge arm comprises a first guide body (3241) movably inserted into the first guide groove (3262) formed at the first link (326), and
the second hinge arm comprises a second guide body (3251) movably inserted into the second guide groove (3272) formed at the second link (327).

15. The electronic device (100) of claim 14, wherein
the rotational angular velocity of the first hinge arm is determined by the coupling shape of the first guide body and the first guide groove with respect to the first rotator (322), and
the rotational angular velocity of the second hinge arm is determined by the coupled shape of the second guide body and the second guide groove with respect to the second rotator (323).

## Patentansprüche

1. Elektronische Vorrichtung (100), umfassend:
ein erstes Gehäuse (110);
ein zweites Gehäuse (120);
mindestens eine Scharniervorrichtung als mindestens eine Scharniervorrichtung (320), die das erste Gehäuse (110) und das zweite Gehäuse (120) verbindet, um von einem ersten Zustand in einen zweiten Zustand faltbar zu sein, und die umfasst:
eine Rotatorhalterung (321),
einen ersten Rotator (322), der drehbar mit der Rotatorhalterung (321) in Bezug auf eine erste Drehachse (X1) gekoppelt ist,
einen zweiten Rotator (323), der drehbar mit der Rotatorhalterung (321) in Bezug auf eine zweite Drehachse (X2) gekoppelt ist,
ein erstes Gelenk (326), das drehbar mit dem ersten Rotator (322) in Bezug auf eine dritte Drehachse (X3) gekoppelt ist,
ein zweites Gelenk (327), das drehbar mit dem zweiten Rotator (323) in Bezug auf eine vierte Drehachse (X4) gekoppelt ist,
einen ersten Scharnierarm (324), der drehbar auf der Rotatorhalterung (321) in Bezug auf eine fünfte Drehachse (X5) angeordnet ist, und
einen zweiten Scharnierarm (325), der drehbar auf der Rotatorhalterung (321) in Bezug auf eine sechste Drehachse (X6) angeordnet ist;
eine erste Flügelplatte (311), die am ersten Rotator (322) befestigt ist;
eine zweite Flügelplatte (312), die am zweiten Rotator (323) befestigt ist;
eine erste Mittelstange (313), die drehbar in Bezug auf die erste Flügelplatte (311) angeordnet ist;
eine zweite Mittelstange (314), die drehbar in Bezug auf die zweite Flügelplatte (312) angeordnet ist; und
eine flexible Anzeige (130), die so angeordnet ist, dass sie durch das erste und zweite Gehäuse (110, 120), die erste und zweite Flügelplatte (311, 312) und die erste und zweite Mittelstange (313, 314) im ersten Zustand gestützt wird, wobei
die erste Mittelstange (313) und die zweite Mittelstange (314) konfiguriert sind, um so betrieben zu werden, dass sie jeweils der ersten Flügelplatte (311) und der zweiten Flügelplatte (312) bis zu einem dritten Zustand entsprechen, der zwischen dem ersten Zustand und dem zweiten Zustand liegt, und konfiguriert sind, um so betrieben zu werden, dass sie einen unterschiedlichen Drehwinkel von der ersten Flügelplatte (311) und der zweiten Flügelplatte (312) von dem dritten Zustand zu dem zweiten Zustand aufweisen.

2. Elektronische Vorrichtung (100) nach Anspruch 1, wobei
die erste Mittelstange (313) drehbar mit dem ersten Rotator (322) in Bezug auf eine siebte Drehachse (X7), die sich unter der ersten Flügelplatte (311) befindet, gekoppelt ist, und
die zweite Mittelstange drehbar mit dem zweiten Rotator (323) in Bezug auf eine achte Drehachse (X8), die sich unter der zweiten Flügelplatte (312) befindet, gekoppelt ist.

3. Elektronische Vorrichtung (100) nach Anspruch 1 oder Anspruch 2, wobei
die erste Mittelstange (313) und die zweite Mittelstange so angeordnet sind, dass sie durch eine Torsionsfeder (TS1) in einer Richtung, die in eine der flexiblen Anzeige entgegengesetzten Richtung weist, mit Druck beaufschlagt werden.

4. Elektronische Vorrichtung (100) nach einem der Ansprüche 1 bis 3, wobei
die erste Mittelstange (313) mit der Rückfläche der ersten Flügelplatte (311) in Bezug auf die siebte Drehachse (X7) drehbar gekoppelt ist, und
die zweite Mittelstange drehbar mit der Rückfläche der zweiten Platte (312) in Bezug auf die achte Drehachse (X8) gekoppelt ist.

5. Elektronische Vorrichtung (100) nach einem der Ansprüche 1 bis 4, wobei:
die erste Mittelstange (313) drehbar mit mindestens einem Abschnitt des ersten Scharnierarms (324) in Bezug auf die siebte Drehachse (X7), die sich unter der ersten Flügelplatte (311) befindet, gekoppelt ist, und
die zweite Mittelstange drehbar mit mindestens einem Abschnitt des zweiten Scharnierarms (325) in Bezug auf die achte Drehachse (X8), die sich unter der zweiten Flügelplatte (312) befindet, gekoppelt ist.

6. Elektronische Vorrichtung (100) nach einem der Ansprüche 1 bis 5, wobei
die erste Mittelstange (313) so angeordnet ist, dass sie im ersten Zustand durch den ersten Rotator (322) gestützt wird, und
die zweite Mittelstange so angeordnet ist, dass sie im ersten Zustand durch den zweiten Rotator (323) gestützt wird.

7. Elektronische Vorrichtung (100) nach einem der Ansprüche 1 bis 6, wobei
die erste Mittelstange (313) so angeordnet ist, dass sie im ersten Zustand von mindestens einem Abschnitt (3246) des ersten Scharnierarms (324) gestützt wird, und
die zweite Mittelstange von mindestens einem Abschnitt (3256) des zweiten Scharnierarms (325) im ersten Zustand gestützt werden soll.

8. Elektronische Vorrichtung (100) nach einem der Ansprüche 1 bis 7, wobei
die erste Mittelstange (313) so angeordnet ist, dass sie von mindestens einem Abschnitt des ersten Stützstücks (3111) gestützt wird, das sich von mindestens einem Abschnitt der ersten Flügelplatte (311) im ersten Zustand erstreckt, und
die zweite Mittelstange so angeordnet ist, dass sie von mindestens einem Abschnitt des zweiten Stützstücks (3121) gestützt wird, das sich von mindestens einem Abschnitt der zweiten Flügelplatte (312) im ersten Zustand erstreckt.

9. Elektronische Vorrichtung (100) nach einem der Ansprüche 1 bis 8, wobei
die erste Mittelstange (313) und die zweite Mittelstange so angeordnet sind, dass sie zwischen dem dritten Zustand und dem zweiten Zustand von mindestens einem Abschnitt der Rotatorhalterung (321) gestützt werden.

10. Elektronische Vorrichtung (100) nach einem der Ansprüche 1 bis 9, wobei
die erste Mittelstange (313) und die zweite Mittelstange (324) so angeordnet sind, dass sie von mindestens einem Abschnitt des ersten Scharnierarms (324) und mindestens einem Abschnitt des zweiten Scharnierarms (325) zwischen dem dritten Zustand und dem zweiten Zustand gestützt werden.

11. Elektronische Vorrichtung (100) nach einem der Ansprüche 1 bis 10, wobei
die erste Mittelstange (313) und die zweite Mittelstange durch die äußere Umfangfläche des Biegeabschnitts der flexiblen Anzeige (130) im zweiten Zustand hindurchgehen und unter der Normallinie (L2) zu einer Tangentiallinie (L1) senkrecht zur Oberfläche (DS) der Anzeige im ersten Zustand angeordnet sind.

12. Elektronische Vorrichtung nach einem der Ansprüche 1 bis 11, umfassend:
die erste Getriebestruktur (3242), die am ersten Scharnierarm ausgebildet ist und in Bezug auf die fünfte Drehachse gedreht wird; und
die zweite Getriebestruktur (3252), die am zweiten Scharnierarm ausgebildet ist und in Bezug auf die sechste Drehachse gedreht wird, wobei
die erste Getriebestruktur und die zweite Getriebestruktur so angeordnet sind, dass sie mit einem Paar von Leerlaufzahnrädern (328) getriebe-gekoppelt sind, die auf der Rotatorhalterung (321) angeordnet sind.

13. Elektronische Vorrichtung (100) nach einem der Ansprüche 1 bis 12, umfassend:
eine erste Nockenstruktur (3243), die auf dem ersten Scharnierarm ausgebildet ist und in Bezug auf die fünfte Drehachse gedreht wird;
eine zweite Nockenstruktur (3253), die auf dem zweiten Scharnierarm ausgebildet ist und in Bezug auf die sechste Drehachse gedreht wird;
einen Nockenkörper als Nockenkörper (329), der so angeordnet ist, dass er in Übereinstimmung mit der Drehung der ersten Nockenstruktur und der zweiten Nockenstruktur nach hinten zurückgezogen wird, und der Folgendes umfasst:
eine dritte Nockenstruktur (3291), die mit der ersten Nockenstruktur nockengekoppelt ist, und
eine vierte Nockenstruktur (3292), die mit der zweiten Nockenstruktur nockengekoppelt ist; und
mindestens eine Feder (CS), die den Nockenkörper in Richtung der ersten und zweiten Nockenstruktur mit Druck beaufschlagt, wobei,
wenn der erste Scharnierarm und der zweite Scharnierarm gedreht werden, ein Drehmoment zwischen der ersten Nockenstruktur und der dritten Nockenstruktur und zwischen der zweiten Nockenstruktur und der vierten Nockenstruktur durch die Druckbeaufschlagungskraft erzeugt wird, mit der die Feder den Nockenkörper mit Druck beaufschlagt.

14. Elektronische Vorrichtung (100) nach einem der Ansprüche 1 bis 13, wobei
der erste Scharnierarm einen ersten Führungskörper (3241) umfasst, der beweglich in die am ersten Gelenk (326) ausgebildete erste Führungsnut (3262) eingesetzt ist, und
der zweite Scharnierarm einen zweiten Führungskörper (3251) umfasst, der beweglich in die am zweiten Gelenk (327) ausgebildete zweite Führungsnut (3272) eingesetzt ist.

15. Elektronische Vorrichtung (100) nach Anspruch 14, wobei
die Drehwinkelgeschwindigkeit des ersten Scharnierarms durch die Kopplungsform des ersten Führungskörpers und der ersten Führungsnut in Bezug auf den ersten Rotator (322) bestimmt wird, und
die Drehwinkelgeschwindigkeit des zweiten Scharnierarms durch die gekoppelte Form des zweiten Führungskörpers und der zweiten Führungsnut in Bezug auf den zweiten Rotator (323) bestimmt wird.

## Revendications

1. Dispositif électronique (100), comprenant :
un premier boîtier (110) ;
un deuxième boîtier (120) ;
au moins un dispositif de charnière, en tant qu'au moins un dispositif de charnière (320), qui relie le premier boîtier (110) et le deuxième boîtier (120) pour être pliable d'un premier état à un deuxième état, qui comprend :
un support de rotateur (321),
un premier rotateur (322) couplé de manière rotative au support de rotateur (321) par rapport à un premier axe de rotation (X1),
un deuxième rotateur (323) couplé de manière rotative au support de rotateur (321) par rapport à un deuxième axe de rotation (X2),
une première liaison (326) couplée de manière rotative au premier rotateur (322) par rapport à un troisième axe de rotation (X3),
une deuxième liaison (327) couplée de manière rotative au deuxième rotateur (323) par rapport à un quatrième axe de rotation (X4),
un premier bras de charnière (324) disposé de manière rotative sur le support de rotateur (321) par rapport à un cinquième axe de rotation (X5), et
un deuxième bras de charnière (325) disposé de manière rotative sur le support de rotateur (321) par rapport à un sixième axe de rotation (X6) ;
une première plaque d'aile (311) fixée au premier rotateur (322) ;
une deuxième plaque d'aile (312) fixée au deuxième rotateur (323) ;
une première barre centrale (313) disposée de manière rotative par rapport à la première plaque d'aile (311) ;
une deuxième barre centrale (314) disposée de manière rotative par rapport à la deuxième plaque d'aile (312) ; et
un affichage flexible (130) disposé de manière à être supporté par les premier et deuxième boîtiers (110, 120), les première et deuxième plaques d'aile (311, 312), et les première et deuxième barres centrales (313, 314) dans le premier état, dans lequel
la première barre centrale (313) et la deuxième barre centrale (314) sont configurées pour être opérées afin de correspondre à la première plaque d'aile (311) et à la deuxième plaque d'aile (312), respectivement, jusqu'à un troisième état qui se situe entre le premier état et le deuxième état, et sont configurés pour être opérés pour avoir un angle de rotation différent de la première plaque d'aile (311) et de la deuxième plaque d'aile (312) depuis le troisième état jusqu'au deuxième état.

2. Dispositif électronique (100) de la revendication 1, dans lequel
la première barre centrale (313) est couplée de manière rotative au premier rotateur (322) par rapport à un septième axe de rotation (X7) situé sous la première plaque d'aile (311), et
la deuxième barre centrale est couplée de manière rotative au deuxième rotateur (323) par rapport à un huitième axe de rotation (X8) situé sous la deuxième plaque d'aile (312).

3. Dispositif électronique (100, 1) de la revendication 1 ou la revendication 2, dans lequel
la première barre centrale (313) et la deuxième barre centrale sont disposées de manière à être pressurisées dans une direction faisant face à la direction opposée à l'affichage flexible par l'intermédiaire d'un ressort de torsion (TS1).

4. Dispositif électronique (100) de l'une quelconque des revendications 1 à 3, dans lequel
la première barre centrale (313) est couplée de manière rotative à la surface arrière de la première plaque d'aile (311) par rapport au septième axe de rotation (X7), et
la deuxième barre centrale est couplée de manière rotative à la surface arrière de la deuxième plaque arrière (312) par rapport au huitième axe de rotation (X8).

5. Dispositif électronique (100) de l'une quelconque des revendications 1 à 4, dans lequel
la première barre centrale (313) est couplée de manière rotative à au moins une partie du premier bras de charnière (324), par rapport au septième axe de rotation (X7) situé sous la première plaque d'aile (311) et
la deuxième barre centrale est couplée de manière rotative à au moins une partie du deuxième bras de charnière (325), par rapport au huitième axe de rotation (X8) situé sous la deuxième plaque d'aile (312).

6. Dispositif électronique (100) de l'une quelconque des revendications 1 à 5, dans lequel
la première barre centrale (313) est disposée de manière à être supportée par le premier rotateur (322) dans le premier état, et
la deuxième barre centrale est disposée de manière à être supportée par le deuxième rotateur (323) dans le premier état.

7. Dispositif électronique (100) de l'une quelconque des revendications 1 à 6, dans lequel
la première barre centrale (313) est disposée de manière à être supportée par au moins une partie (3246) du premier bras de charnière (324) dans le premier état, et
la deuxième barre centrale doit être supportée par au moins une partie (3256) du deuxième bras de charnière (325) dans le premier état.

8. Dispositif électronique de l'une quelconque des revendications 1 à 7, dans lequel
la première barre centrale (313) est disposée de manière à être supportée par au moins une partie de la première pièce de support (3111) s'étendant à partir d'au moins une partie de la première plaque d'aile (311) dans le premier état, et
la deuxième barre centrale est disposée de manière à être supportée par au moins une partie de la deuxième pièce de support (3121) s'étendant à partir d'au moins une partie de la deuxième plaque d'aile (312) dans le premier état.

9. Dispositif électronique (100) de l'une quelconque des revendications 1 à 8, dans lequel
la première barre centrale (313) et la deuxième barre centrale sont disposées de manière à être supportées par au moins une partie du support de rotation (321), entre le troisième état et le deuxième état.

10. Dispositif électronique (100) de l'une quelconque des revendications 1 à 9, dans lequel
la première barre centrale (313) et la deuxième barre centrale (324) sont disposées de manière à être supportées par au moins une partie du premier bras de charnière (324) et au moins une partie du deuxième bras de charnière (325), entre le troisième état et le deuxième état.

11. Dispositif électronique (100) de l'une quelconque des revendications 1 à 10, dans lequel
la première barre centrale (313) et la deuxième barre centrale traversent la surface périphérique extérieure de la partie de flexion de l'affichage flexible (130) dans le deuxième état et sont disposées sous la ligne normale (L2) à une ligne tangente (L1) perpendiculaire à la surface (DS) de l'affichage dans le premier état.

12. Dispositif électronique de l'une des revendications 1 à 11, comprenant :
la première structure d'engrenage (3242) formée sur le premier bras de charnière et tournée par rapport au cinquième axe de rotation ; et
la deuxième structure d'engrenage (3252) formée sur le deuxième bras de charnière et tournée par rapport au sixième axe de rotation, dans lequel
la première structure d'engrenage et la deuxième structure d'engrenage sont disposées de manière à être accouplées en engrenage à un couple de roues dentées folles (328) disposés sur le support de rotateur (321).

13. Dispositif électronique (100) de l'une quelconque des revendications 1 à 12, comprenant :
une première structure de came (3243) formée sur le premier bras de charnière et tournée par rapport au cinquième axe de rotation ;
une deuxième structure de came (3253) formée sur le deuxième bras de charnière et tournée par rapport au sixième axe de rotation ;
un corps de came, en tant que corps de came (329) disposé pour être rétracté vers l'arrière en fonction de la rotation de la première structure de came et de la deuxième structure de came, comprenant
une troisième structure de came (3291) couplée en came à la première structure de came, et
une quatrième structure de came (3292) couplée en came à la deuxième structure de came ; et
au moins un ressort (CS) mettant en pression le corps de came en direction des première et deuxième structures de came, dans lequel
lorsque le premier bras de charnière et le deuxième bras de charnière sont tournés, un couple est généré entre la première structure de came et la troisième structure de came et entre la deuxième structure de came et la quatrième structure de came, par l'intermédiaire de la force de pressurisation par laquelle le ressort met le corps de came sous pression.

14. Dispositif électronique (100) de l'une quelconque des revendications 1 à 13, dans lequel
le premier bras de charnière comprend un premier corps de guidage (3241) inséré de manière mobile dans la première rainure de guidage (3262) formée au niveau de la première liaison (326), et
le deuxième bras de charnière comprend un deuxième corps de guidage (3251) inséré de manière mobile dans la deuxième rainure de guidage (3272) formée au niveau de la deuxième liaison (327).

15. Dispositif électronique (100) de la revendication 14, dans lequel
la vitesse angulaire de rotation de la première charnière est déterminée par la forme de couplage du premier corps de guidage et de la première rainure de guidage par rapport au premier rotateur (322), et
la vitesse angulaire de rotation de la deuxième charnière est déterminée par la forme couplée du deuxième corps de guidage et de la deuxième rainure de guidage par rapport au deuxième rotateur (323).
